# EUROPEAN PATENT APPLICATION

(11) **EP 4 761 536 A1**
(43) Date of publication of application: **17.06.2026**
(21) Application number: 24219612.9
(22) Date of filing: 12.12.2024
(51) Int. Cl.: H10K 50/155, H10K 50/15, H10K 50/17

(54) **AN ORGANIC ELECTRONIC DEVICE COMPRISING A SUBSTRATE, AN ANODE LAYER, A CATHODE LAYER, AT LEAST ONE FIRST EMISSION LAYER, AND TWO HOLE INJECTION LAYERS**

(71) Applicant: Novaled GmbH, 01099 Dresden (DE)
(72) Inventor: UVAROV, Vladimir, 01099 Dresden (DE); PINTER, Piermaria, 01099 Dresden (DE); LUSCHTINETZ, Regina, 01099 Dresden (DE); ROSENOW, Thomas, 01099 Dresden (DE)
(74) Representative: Michalski Hüttermann & Partner mbB

(57) **Abstract**

The present invention relates to an organic electronic device, comprising a substrate, an anode layer, a cathode layer, at least one first emission layer, and two hole injection layers.

## Description

### Technical Field

The present invention relates to an organic electronic device, comprising a substrate, an anode layer, a cathode layer, at least one first emission layer, and two hole injection layers.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

There remains a need to improve the performance of organic electronic devices by providing organic semiconductor layers with improved performance, in particular to improved operating voltage, cd/A efficiency, external quantum efficiency and/or improved sheet resistance of the hole injection layer, especially providing such layers which essentially contain compounds which are suitable for evaporation in vacuum

### DISCLOSURE

An aspect of the present invention provides an organic electronic device comprising an anode layer, a cathode layer, at least one emission layer, a first hole injection layer (HIL1) and a second hole injection layer (HIL2), and a hole transport layer (HTL),
wherein
- The first hole injection layer (HIL1) is in direct contact with the anode layer and the second hole injection layer (HIL2);
- The hole transport layer (HTL) is arranged between the second hole injection layer (HIL2) and the at least one emission layer;
- The emission layer is arranged between the hole transport layer and the cathode layer;
wherein the first hole injection layer (HIL1) comprises a compound of formula (I) 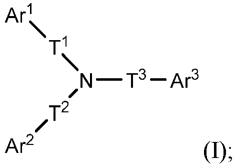 whereby
T¹, T², T³ are independently selected from a single bond, phenylene, biphenylene, terphenylene or naphthenylene, preferably a single bond or phenylene;
Ar¹, Ar², Ar³ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³ are selected the same or different from the group comprising H, D, F, CN, Si(R')₃, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R' may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
the second hole injection layer (HIL2) comprises a compound of formula (I) and a compound of formula (II)

M^{n⊕}(L^{⊝})ₙ(AL)ₘ (II),

wherein
M is a metal ion,
n is the valency of M and selected from 1 to 4;
L is a mono-anionic ligand comprising between 7 and 40 carbon atoms,
wherein L comprises at least one six membered aromatic or heteroaromatic ring, which may be part of a ring system;
wherein L comprises at least two fluorine atoms, preferably at least 3 fluorine atoms;
   AL is an ancillary ligand which coordinates to the metal ion M;
   m is an integer selected from 0 to 2;
whereby both the first hole injection layer (HIL1) and the hole transport layer (HTL) are free of a compound of formula (II).

The negative charge in the compounds of formula (II) may be delocalised partially or fully over the β-dicarbonyl group and optionally also over the aryl group(s).

It should be noted that throughout the application and the claims any R^{k} etc. always refer to the same moieties, unless otherwise noted. k is an integer from 1 to 3.

It should be noted that throughout the application and the claims any Aⁿ, Bⁿ, Rⁿ, Arⁿ, Tⁿ, Xⁿ, L, M, Q etc. always refer to the same moieties, unless otherwise noted.

In the present specification, when a definition is not otherwise provided, "partially fluorinated" refers to a C₁ to C₈ alkyl group in which only part of the hydrogen atoms are replaced by fluorine atoms.

In the present specification, when a definition is not otherwise provided, "perfluorinated" refers to a C₁ to C₈ alkyl group in which all hydrogen atoms are replaced by fluorine atoms.

In the present specification, when a definition is not otherwise provided, "substituted" refers to one substituted with a deuterium, C₁ to C₁₂ alkyl and C₁ to C₁₂ alkoxy.

In the present specification, when a definition is not otherwise provided, a substituted aryl group with at least 6 C-ring atoms can be substituted with 1, 2, 3, 4 or 5 substituents. For example a substituted C₆ aryl group may have 1, 2, 3, 4 or 5 phenyl substituents.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, a substituted heteroaryl group with at least 2 C-ring atoms can be substituted with one or more substituents. For example a substituted C₂ heteroaryl group may have 1 or 2 substituents.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

The term "charge-neutral" means that the corresponding group is overall electrically neutral.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

Consequently the term "ring system" is to be understood to cover a chemical moiety comprising two or more fused aryl rings.

The term "5-, 6- or 7-member ring" is understood to mean a ring comprising 5, 6 or 7 atoms. The atoms may be selected from C and one or more heteroatoms.

In the present specification, the single bond refers to a direct bond.

In the present specification, when a definition is not otherwise provided, "substituted" refers to one substituted with a H, deuterium, C₁ to C₁₂ alkyl, unsubstituted C₆ to C₁₈ aryl, and unsubstituted C₃ to C₁₈ heteroaryl.

In the present specification, when a substituent is not named, the substituent can be a H.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

As used herein, "percent by weight", "weight percent", "wt.-%", "% by weight", and variations thereof refer to a composition, component, substance or agent as the weight of that composition, component, substance or agent of the respective layer divided by the total weight of the composition thereof and multiplied by 100. It is understood that the total weight percent amount of all components, substances or agents of the respective are selected such that it does not exceed 100 wt.-%.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The term "at least two anode sub-layers" is understood to mean two or more anode sub-layers, for example two or three anode sub-layers.

The terms "cathode", "cathode layer" and "cathode electrode" are used synonymously.

The term "hole injection layer" is understood to mean a layer which improves charge injection from the anode layer into further layers in the organic electronic device or from further layers of the organic electronic device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of the compound of formula (I) or the hole injection layer comprising a compound of formula (I), to the visible emission spectrum from an electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the context of the present invention, the term "sublimation" may refer to a transfer from solid state to gas phase or from liquid state to gas phase.

The term "LUMO level" is understood to mean the lowest unoccupied molecular orbital and is determined in eV (electron volt). The LUMO level may also be named "LUMO" or "LUMO energy level".

The term "LUMO level further away from vacuum level" is understood to mean that the absolute value of the LUMO level is higher than the absolute value of the LUMO level of the reference compound.

The term "HOMO level" is understood to mean the highest occupied molecular orbital and is determined in eV (electron volt). The HOMO level may also be named "HOMO" or "HOMO energy level". The term "HOMO level further away from vacuum level" is understood to mean that the absolute value of the HOMO level is higher than the absolute value of the HOMO level of the reference compound. For example, the term "HOMO level of the matrix compound of the hole injection layer" further away from vacuum level than the HOMO level of N2,N2,N2',N2',N7,N7,N7',N7'-octakis(4-methoxyphenyl)-9,9'-spirobi[fluorene]-2,2',7,7'-tetraamine" is understood to mean that the absolute value of the HOMO level of the matrix compound of the hole injection layer is higher than the HOMO level of N2,N2,N2',N2', N7,N7, N7'N7'-octakis(4-methoxyphenyl)-9,9'-spirobi[fluorene]-2,2'7,7'-tetraamine.

The term "absolute value" is understood to mean the value without the "- "symbol if present. According to one embodiment of the present invention, the HOMO level of the matrix compound of the hole injection layer may be calculated by quantum mechanical methods.

### Advantageous Effects

Surprisingly, it was found that the organic electronic device of the present invention solves the problem underlying the present invention by enabling devices in various aspects superior over the organic electronic devices known in the art, in particular with respect to improved operating voltage, cd/A efficiency, external quantum efficiency and/or improved sheet resistance of the hole injection layer.

Furthermore, surprisingly it was found that the organic electronic device of the present invention solves the problem underlying the present invention by enabling device in various aspects superior over the organic electronic device known in the art, in particular with respect to devices comprising organic semiconductor layers which are formed of compounds of formula (I) and compounds of formula (II), wherein the compounds of formula (I) and/or compounds of formula (II) are suitable for evaporation in vacuum.

In the following the various aspects of the invention will be described in more detail, whereby all embodiments may be combined *ad libitum.*

### Compound of formula (I)

According to one embodiment, the compound of formula (I) may have a molecular weight, wherein the compound of formula (I) has a molecular weight Mw of ≥ 600 and ≤ 1500 g/mol, preferably a molecular weight Mw of ≥ 600 and ≤ 1200 g/mol, more preferred a molecular weight Mw of ≥ 600 and ≤ 1000 g/mol.

If the molecular weight of compound of formula (I) is selected in this range, the volatility of the compound of formula (I) may be in the range suitable for mass production of organic electronic devices via vacuum thermal evaporation.

According to an embodiment, T¹, T², and T³ may be independently selected from a single bond, phenylene, biphenylene or terphenylene. According to an embodiment T¹, T², and T³ may be independently selected from phenylene, biphenylene or terphenylene and one of T¹, T², and T³ is a single bond. According to an embodiment one or two of T¹, T², and T³ may be independently selected from phenylene or biphenylene and one of T¹, T², and T³ is a single bond. According to an embodiment wherein T¹, T², and T³ may be independently selected from phenylene or biphenylene and two of T¹, T², and T³ are a single bond.

According to an embodiment one or two of T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to one embodiment, the compound of formula (I) comprises only one nitrogen atom which is not part of a ring or ring system.

According to one embodiment of the present invention Ar¹, Ar², and Ar³ are independently selected from E1 to E17: 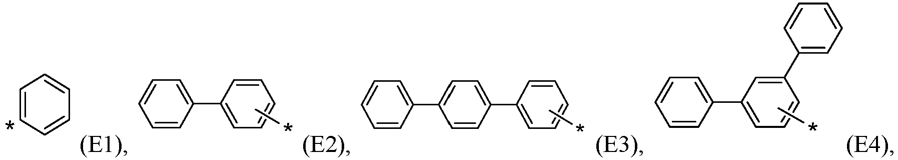 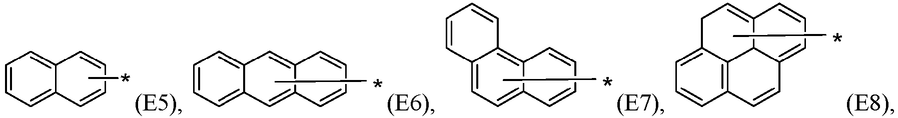 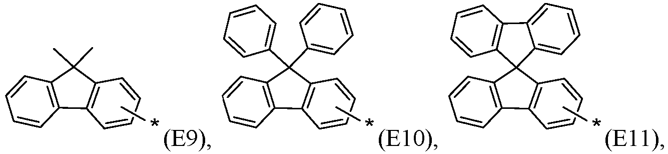 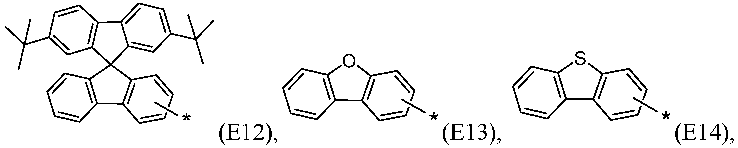 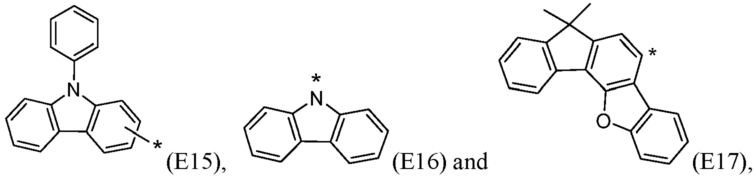 wherein the asterisk "*" denotes the binding position.

According to an embodiment, Ar¹, Ar², and Ar³ may be independently selected from E1 to E15; alternatively selected from E1 to E10 and E13 to E15.

According to an embodiment, wherein Ar¹, Ar², Ar³, Ar⁴ and Ar⁵ may be independently selected from the group consisting of E1, E2, E5, E7, E9, E10, E13 to E17.

The rate onset temperature may be in a range particularly suited to mass production, when Ar¹, Ar², and Ar³ are selected in this range.

The compound according to formula (I) may be also referred to as "hole transport compound".

According to one embodiment, the compound according to formula (I) comprises at least one naphthyl group, carbazole group, dibenzofuran group, dibenzothiophene group and/or substituted fluorenyl group, wherein the substituents are independently selected from methyl, phenyl or fluorenyl.

According to one embodiment of the invention, the compound of formula (I) has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.27 eV, the HOMO level of N4,N4,N4',N4'-tetrakis(4-methoxyphenyl)biphenyl-4,4'-diamine is -4.34 eV, and the HOMO level of N4,N4'-bis(9,9-dimethyl-9H-fluoren-2-yl)-N4,N4'-diphenyl-[1,1'-biphenyl]-4,4'-diamine is -4.64 eV, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the invention, the compound of formula (I) has a HOMO level smaller than -4.72 eV, preferably smaller than -4.8 eV, even more preferred smaller than -4.83 eV, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

According to an embodiment of the electronic device, the compound of formula (I) is selected from one of the following formulae K1 to K21:

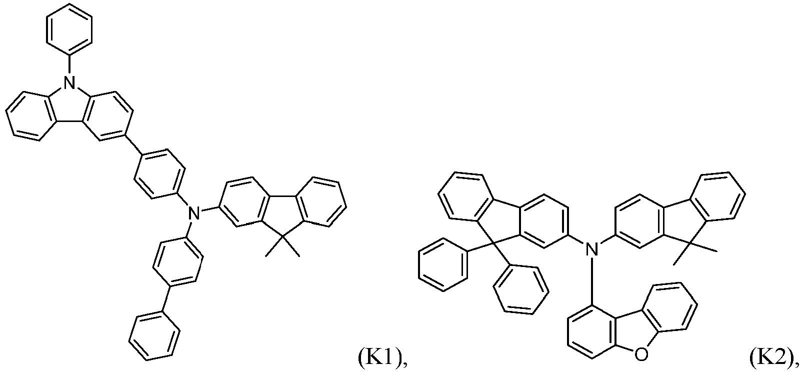

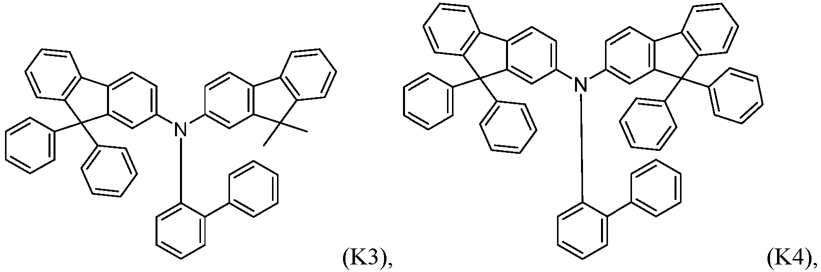

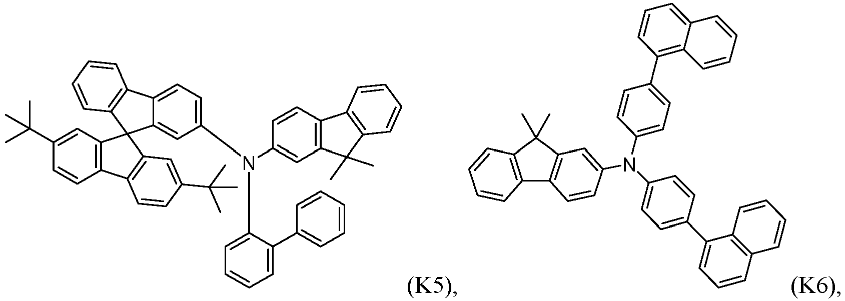

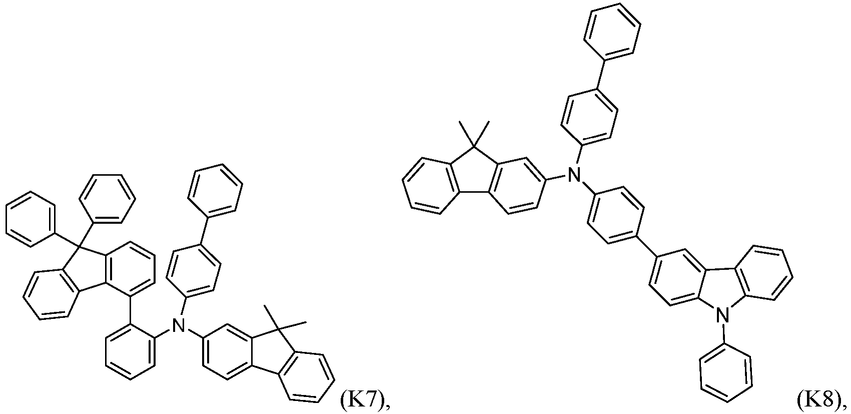

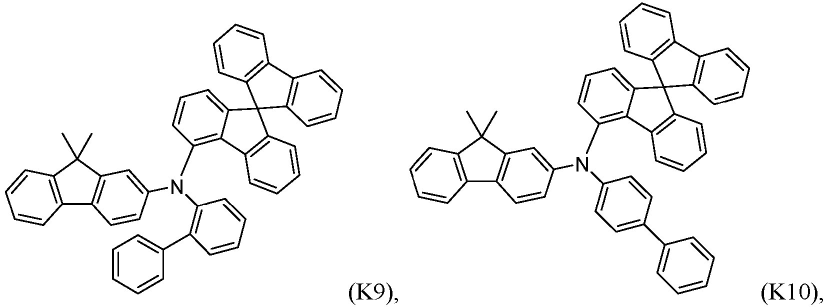

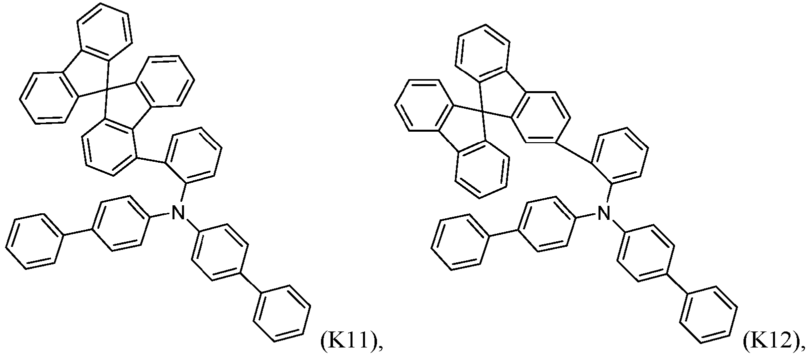

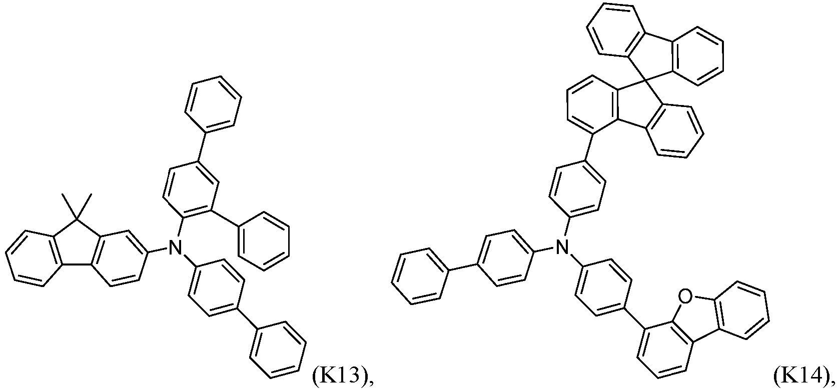

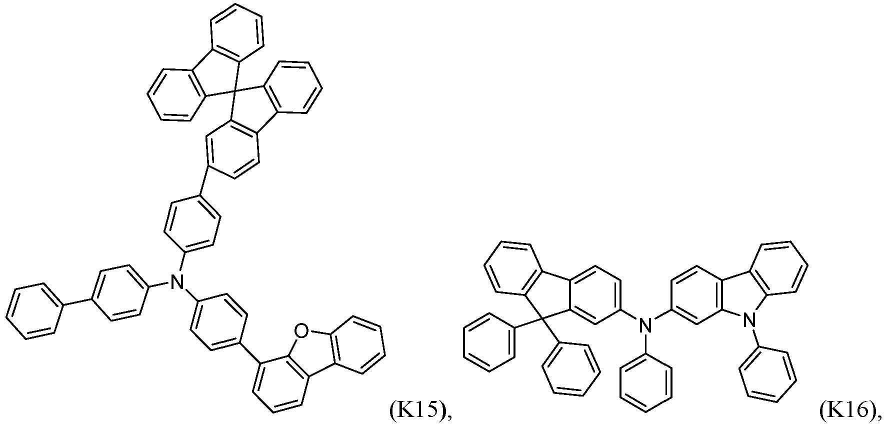

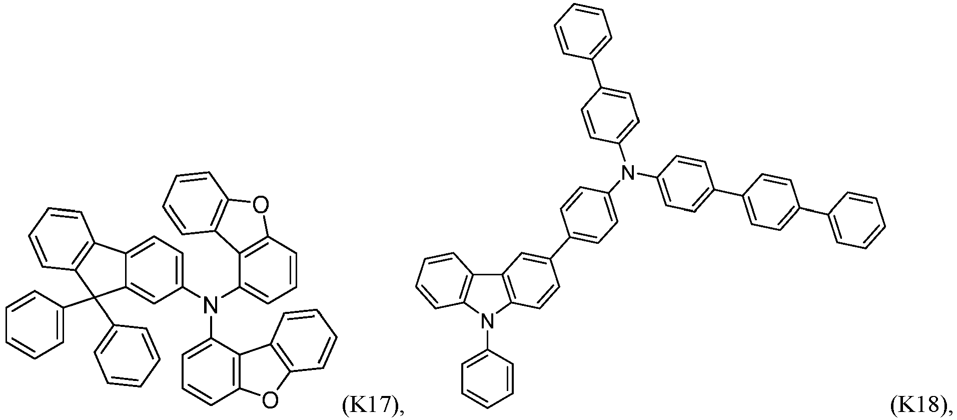

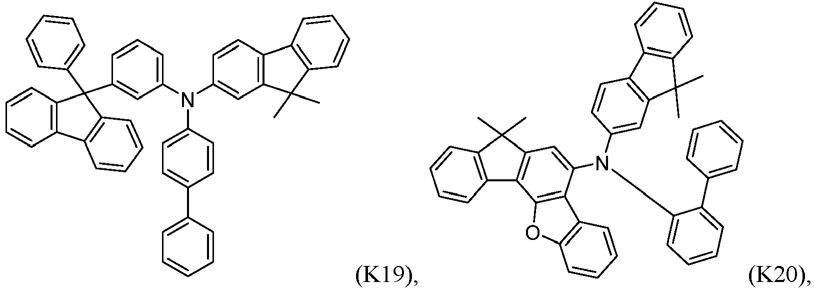

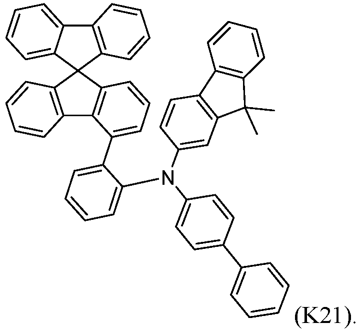

According to one embodiment, the compound of formula (I) is free of alkoxy groups.

According to one embodiment, the compound of formula (I) is free of halogen atoms.

According to an embodiment, the compound of formula (I) is free of m-MTDATA and/or TCTA.

According to an embodiment, the hole injection layers HIL1 and/or HIL2 are free of m-MTDATA, TPD, NPB, CBP and/or TCTA.

According to an embodiment, the compound of formula (I) and/or the hole injection layers HIL1 and/or HIL2 are free of HTM014, HTM081, HTM163, HTM222, EL-301, HTM226, HTM355, HTM133, HTM334, HTM604 and EL-22T and/or the compound of formula (I) is not selected of any of these compound. The abbreviations denote the manufacturers' names, for example, of Merck or Lumtec.

### Compound of formula (II)

According to one embodiment of the present invention, the compound of formula (II) may have a molecular weight Mw of ≥ 400 and ≤ 2500 g/mol, preferably a molecular weight Mw of ≥ 500 and ≤ 2000 g/mol, more preferred a molecular weight Mw of ≥ 500 and ≤ 2000 g/mol.

If the molecular weight of compound of formula (II) is selected in this range, the volatility of the compound of formula (II) may be in the range suitable for mass production of organic electronic devices via vacuum thermal evaporation.

According to one embodiment of the present invention, the compound of formula (II) has a LUMO level smaller than -2.9 eV, preferably smaller than -3 eV, when calculated by applying the applying the hybrid functional B3LYP with a ZORA-Def2-TZVP basis set and the SARC-ZORA-TZVP segmented all electron relativistically contracted basis sets for elements beyond krypton from the optimized geometries obtained by applying the functional BP86 with a ZORA-Def2-SVP basis set and the SARC-ZORA-TZVP segmented all electron relativistically basis sets for elements beyond Krypton as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany).

The term "having a LUMO level smaller than" in the context of the present invention means that the absolute value of the LUMO level is greater than the absolute value of the LUMO level to which it is compared to. Particularly, the term "having a LUMO level smaller than" in the context of the present invention means that the LUMO level is further away from vacuum level than the value of the LUMO level to which it is compared to.

According to one embodiment of the present invention, the compound of formula (II) is free of chlorine atoms, bromine atoms and/or iodine atoms.

According to one embodiment of the present invention, the compound of formula (II) is free of Iridium(III) and/or Ce(IV).

### Ligand L

According to one embodiment, the ligand L may comprise 5 or 6 fluorine atoms, preferably at least 6 fluorine atoms. Thereby particularly preferred thermal properties and/or LUMO energy may be obtained.

The monoanion or the monoanionic ligand L also named "ligand L" throughout the specification may have the formula (IIIa), (IIIb), (IIIc), (IIId) and (IIIe).

According to an embodiment, wherein the monoanion or the monoanionic ligand L is represented by one of the following formulas (IIIa), (IIIb), (IIIc), (IIId) and (IIIe): 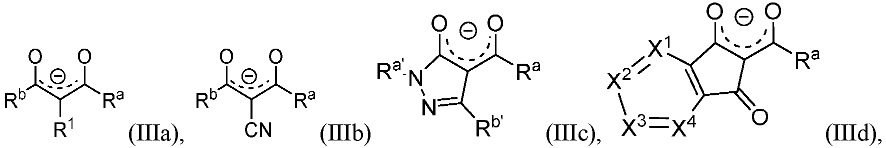 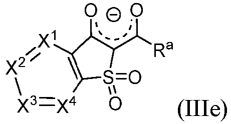 wherein
- R^{a} and R^{b}: are independently selected from H, D, electron-withdrawing group, halogen, F, CN, substituted or unsubstituted C₁ to C₁₂ alkyl, partially fluorinated C₁ to C₁₂ alkyl, perfluorinated C₁ to C₁₂ alkyl, CF₃, CF₂H, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having 0 to 20 carbon atoms; wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group, sulfinyl group, sulfonyl group, phosphine group, partially fluorinated C₁ to C₁₂ alkyl, perfluorinated C₁ to C₁₂ alkyl, CF₃, CF₂H, partially fluorinated C₁ to C₆ alkoxy, perfluorinated C₁ to C₆ alkoxy, OCF₃;
- R⁵: is selected from substituted or unsubstituted C₆ to C₄₀ aryl, substituted or unsubstituted C₂ to C₄₀ heteroaryl, substituted or unsubstituted C₁ to C₁₂ alkyl, partially fluorinated C₁ to C₁₂ alkyl, perfluorinated C₁ to C₁₂ alkyl, wherein the one or more substituents on R⁵ is selected from electron-withdrawing group, halogen, F, CN, NO₂, SF₅, isonitrile, ester group, carboxylic group, carbonyl group, acyl group, thio group, sulfinyl group, sulfonyl group, phosphine group, partially fluorinated C₁ to C₁₂ alkyl, perfluorinated C₁ to C₁₂ alkyl, CF₃, CF₂CF₃, CF₂H, partially fluorinated C₁ to C₆ alkoxy, perfluorinated C₁ to C₆ alkoxy, OCF₃, OCF₂CCF₃;
- R¹: is selected from H, D, CN, substituted or unsubstituted C₁ to C₈ alkyl, partially fluorinated C₁ to C₁₂ alkyl, perfluorinated C₁ to C₁₂ alkyl, CF₃, CHF₂, substituted or unsubstituted C₆ to C₄₀ aryl, substituted or unsubstituted C₂ to C₃₀ heteroaryl; wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CHF₂, partially fluorinated C₁ to C₆ alkoxy, perfluorinated C₁ to C₆ alkoxy, OCF₃, =N, =N-;
- R^{a'}: is independently selected from substituted or unsubstituted C₁ to C₁₂ alkyl, CH₃, CF₃, CF₂H, substituted or unsubstituted C₆ to C₁₉ aryl, substituted or unsubstituted C₂ to C₂₀ heteroaryl, or substituted or unsubstituted 6-membered heteroaryl; wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, F, CN, partially or perfluorinated C₁ to C₈ alkyl, CF₃, CF₂CF₃, CF₂H, partially or perfluorinated C₁ to C₈ alkoxy;
- R^{b'}: is selected from substituted or unsubstituted C₁ to C₁₂ alkyl, CH₃, CF₃, CF₂H, substituted or unsubstituted C₆ to C₁₉ aryl, substituted or unsubstituted C₂ to C₂₀ heteroaryl, substituted or unsubstituted 6-membered heteroaryl, or CN; wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, F, CN, partially or perfluorinated C₁ to C₈ alkyl, CF₃, CF₂CF₃, CF₂H, partially or perfluorinated C₁ to C₈ alkoxy;
- X¹: is selected from C-R^{1'} or N;
- X²: is selected from C-R^{2'} or N;
- X³: is selected from C-R^{3'} or N;
- X⁴: is selected from C-R^{4'} or N;
wherein
- 0, 1 or 2: of the group consisting of X¹, X², X³, and X⁴ are selected from N;
- R^{1'} to R^{4'}: are independently selected from H, D, substituted or unsubstituted C₁ to C₁₂ alkyl, CH₃, CF₃, CF₂H, substituted or unsubstituted C₆ to C₁₉ aryl, substituted or unsubstituted C₂ to C₂₀ heteroaryl, substituted or unsubstituted 6-membered heteroaryl, halogen, F, Cl or CN; and whereby optional any R^{k'} to R^{(k+1)'} with k is selected from 1, 2 or 3 form a ring, preferably a 5- or 6- membered ring;
wherein L comprises at least one six membered aromatic or heteroaromatic ring, which may be part of a ring system and wherein L comprises at least two fluorine atoms, preferably at least 3 fluorine atoms;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, F, CN, partially or perfluorinated C₁ to C₈ alkyl, CF₃, CF₂CF₃, CF₂H, partially or perfluorinated C₁ to C₈ alkoxy.

According to an embodiment, wherein the monoanion and/or monoanionic ligand L is represented by formula (IIIa) or (IIIb): 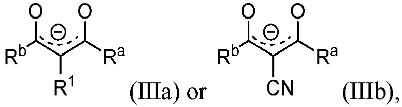 wherein
- R^{a} and R^{b}: are independently selected from H, D, electron-withdrawing group, halogen, F, CN, substituted or unsubstituted C₁ to C₁₂ alkyl, partially fluorinated C₁ to C₁₂ alkyl, perfluorinated C₁ to C₁₂ alkyl, CF₃, CHF₂, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵ , substituted or unsubstituted amine group having 0 to 20 carbon atoms; wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, partially fluorinated C₁ to C₆ alkoxy, perfluorinated C₁ to C₆ alkoxy, OCF₃;
- R⁵: is selected from substituted or unsubstituted C₆ to C₄₀ aryl, substituted or unsubstituted C₂ to C₄₀ heteroaryl, substituted or unsubstituted C₁ to C₁₂ alkyl, CH₃, CF₃, CF₂H, partially fluorinated C₁ to C₁₂ alkyl, perfluorinated C₁ to C₁₂ alkyl, wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CHF₂, CF₂CF₃, partially fluorinated C₁ to C₆ alkoxy, perfluorinated C₁ to C₆ alkoxy, OCF₃, OCF₂CCF₃;
- R¹: is selected from H, D, CN, substituted or unsubstituted C₁ to C₈ alkyl, partially fluorinated C₁ to C₁₂ alkyl, perfluorinated C₁ to C₁₂ alkyl, CF₃, CHF₂, substituted or unsubstituted C₆ to C₄₀ aryl, substituted or unsubstituted C₂ to C₃₀ heteroaryl; wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CHF₂, partially fluorinated C₁ to C₆ alkoxy, perfluorinated C₁ to C₆ alkoxy, OCF₃, =N, =N-;

wherein optional two adjacent substituents selected from the group of R^{a}, R^{b}, and R¹ are connected to form a heterocycle or carbocycle;
wherein L comprises at least one six membered aromatic or heteroaromatic ring, which may be part of a ring system and wherein L comprises at least two fluorine atoms, preferably at least 3 fluorine atoms.

According to an embodiment, the monoanionic ligand L is selected from formula (IIIa): 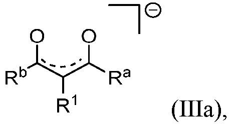
- R^{a} and R^{b}: are independently selected from H, D, electron-withdrawing group, halogen, F, CN, substituted or unsubstituted C₁ to C₁₂ alkyl, partially fluorinated C₁ to C₁₂ alkyl, perfluorinated C₁ to C₁₂ alkyl, CF₃, CHF₂, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having 0 to 20 carbon atoms; wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, partially fluorinated C₁ to C₆ alkoxy, perfluorinated C₁ to C₆ alkoxy, OCF₃;
- R⁵: is selected from substituted or unsubstituted C₆ to C₄₀ aryl, substituted or unsubstituted C₂ to C₄₀ heteroaryl, substituted or unsubstituted C₁ to C₁₂ alkyl, CH₃, CF₃, CF₂H, partially fluorinated C₁ to C₁₂ alkyl, perfluorinated C₁ to C₁₂ alkyl, wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CHF₂, CF₂CF₃, partially fluorinated C₁ to C₆ alkoxy, perfluorinated C₁ to C₆ alkoxy, OCF₃, OCF₂CCF₃;
- R¹: is selected from H, D, CN, substituted or unsubstituted C₁ to C₈ alkyl, acyl, sulfonyl; wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CHF₂, partially fluorinated C₁ to C₆ alkoxy, perfluorinated C₁ to C₆ alkoxy, OCF₃, =N, =N-;

wherein two adjacent substituents R^{a}, R^{b}, and R¹ can optionally be connected to form heterocycle or carbocycle;
wherein L comprises at least one six membered aromatic or heteroaromatic ring, which may be part of a ring system and wherein L comprises at least two fluorine atoms, preferably at least 3 fluorine atoms.

According to an embodiment, wherein at least one of R^{a}, R^{b} or R¹ is independently selected from the group consisting of formulae D1 to D111: 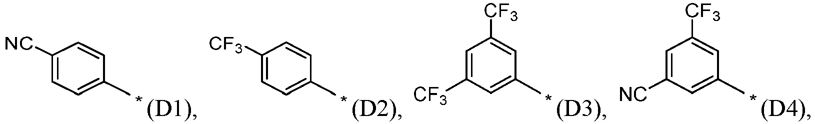 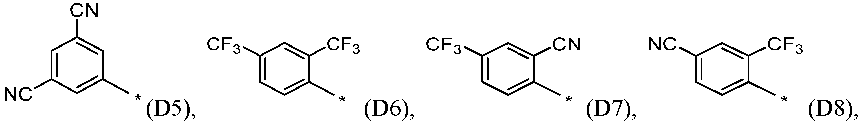 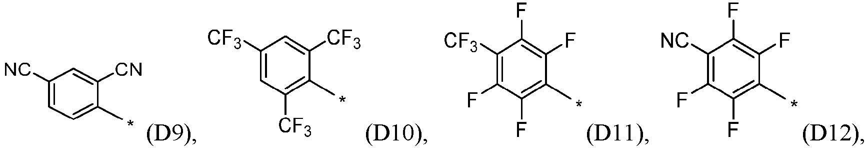 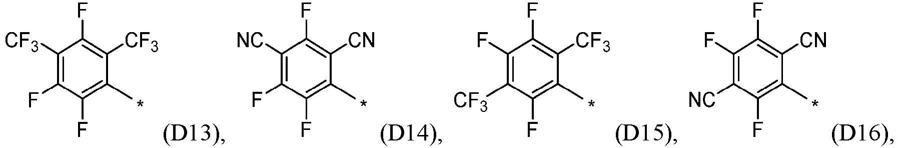 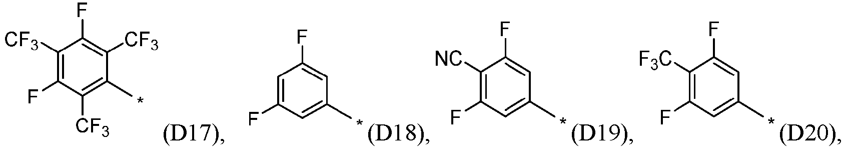 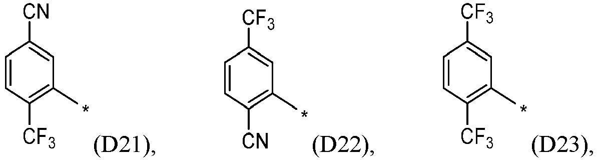 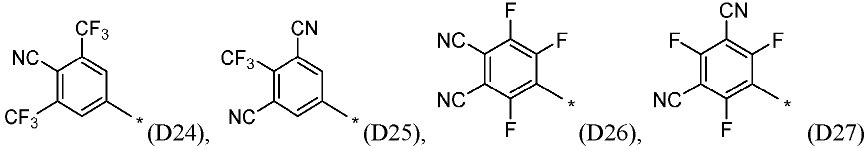 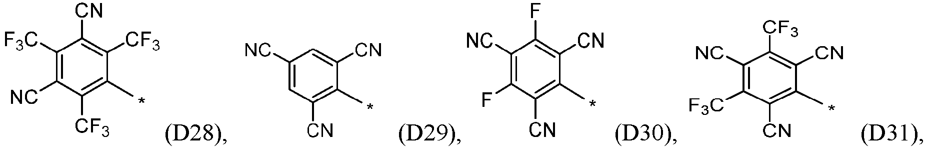 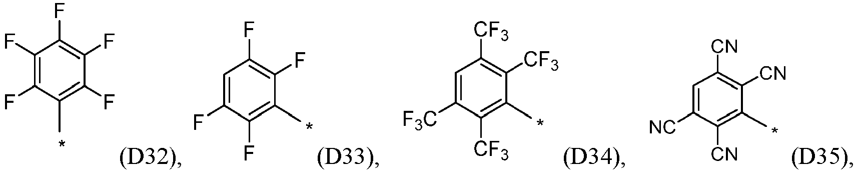 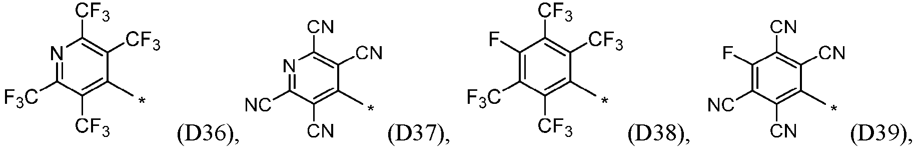 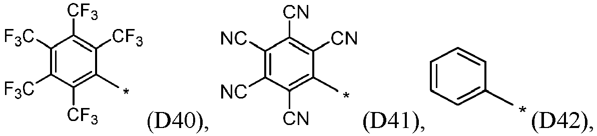 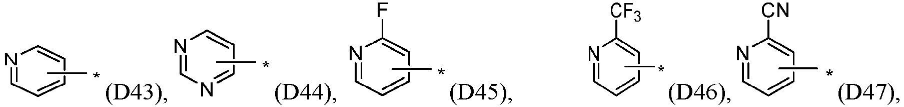 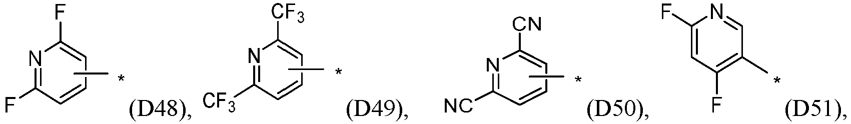 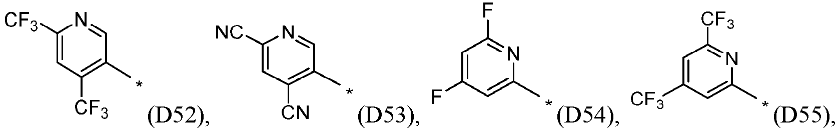 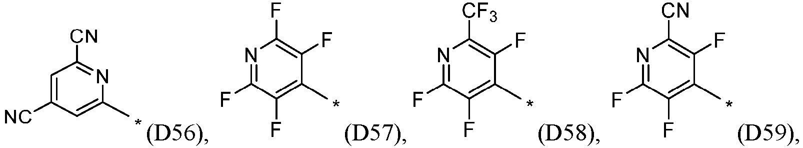 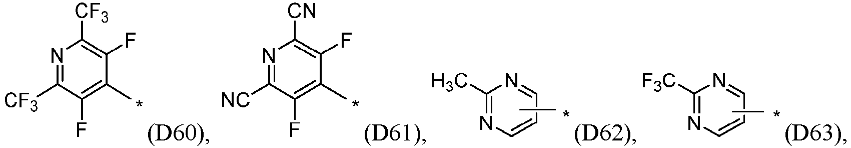 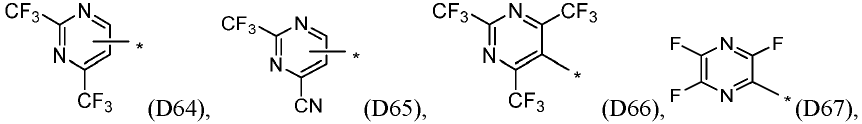 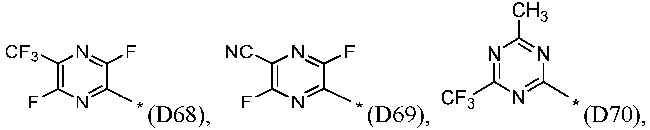 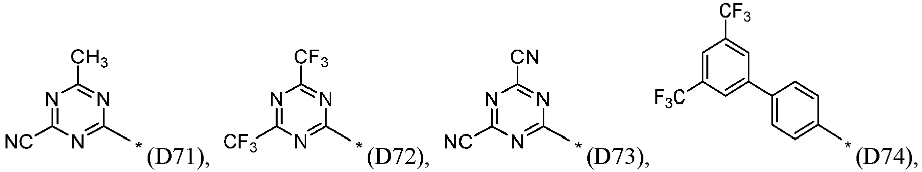 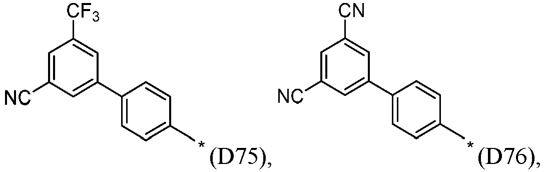 -CF₃ (D77), -C₂F₅ (D78), -C₃F₇ (D79), -CF₂CF₂CF₃ (D80), 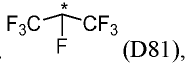 -C₄F₉ (D82), -CF₂CF₂CF₂CF₃ (D83), 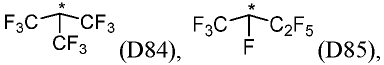 -C₅F₁₁ (D86), -C₆F₁₃ (D87), -CH₃ (D88), -C₂H₅ (D89) -CH(CH₃)₂ (D90), 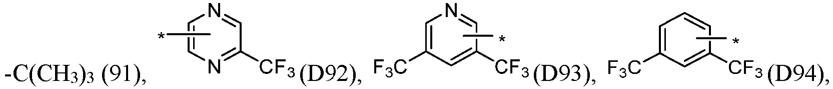 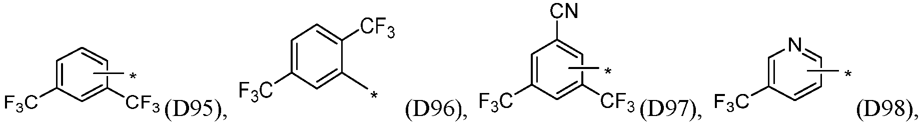 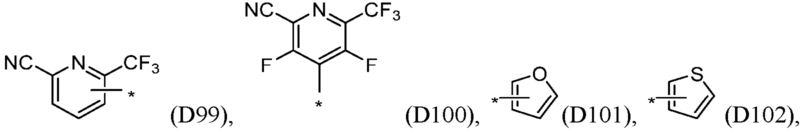 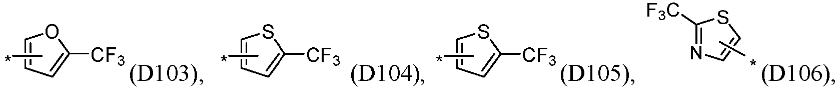 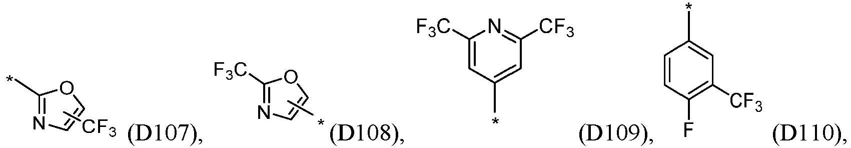 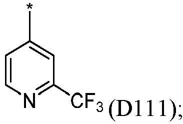 wherein the "*" or "-" denotes the binding position.

According to an embodiment, wherein one or two of R^{a} and R^{b} are independently selected from the group consisting of formulae D1 to D 111.

According to an embodiment, wherein R¹ is selected from the group consisting of formulae D1 to D111.

According to an embodiment, wherein the monoanion or the monoanionic ligand L of formula (IIIa), (IIIb), (IIIc), (IIId) and (IIIe) is selected from the group consisting of formulae L1 to L455:

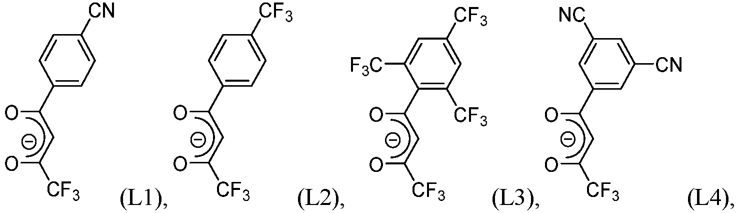

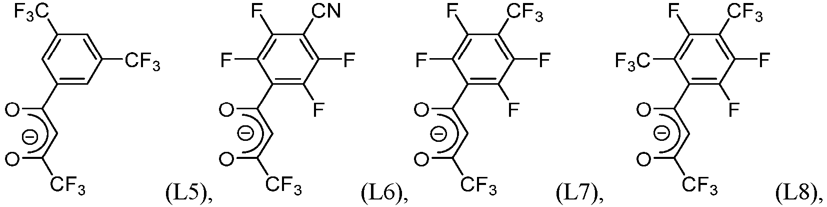

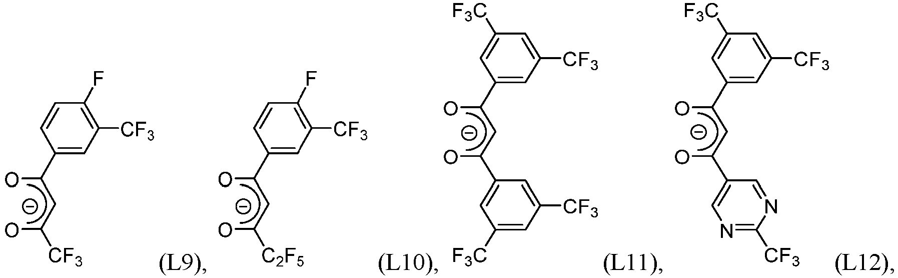

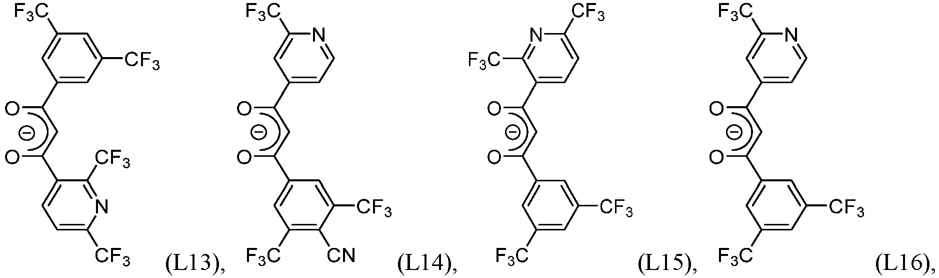

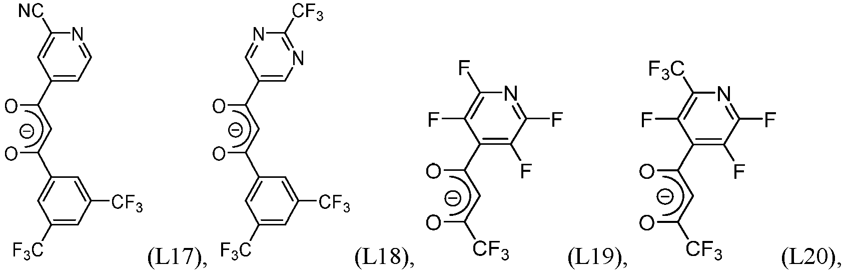

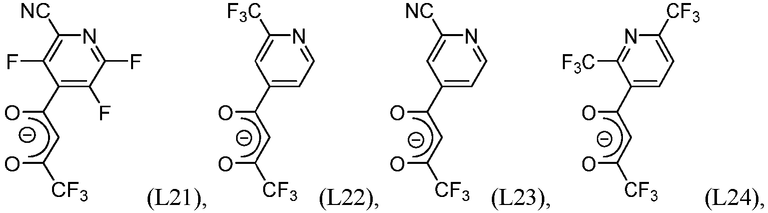

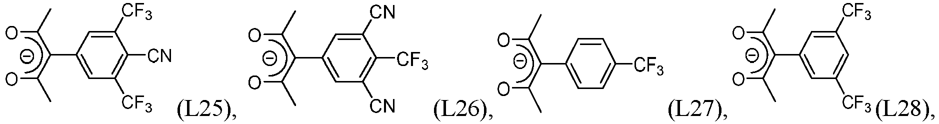

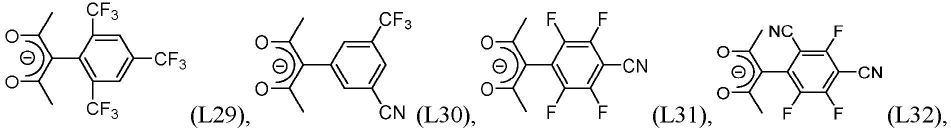

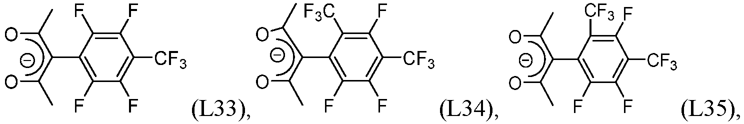

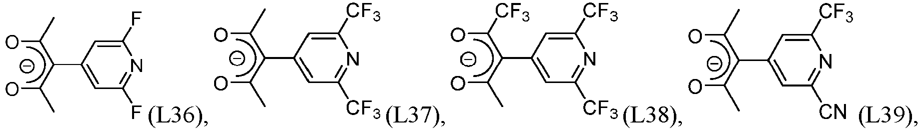

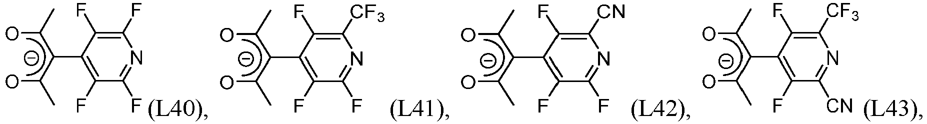

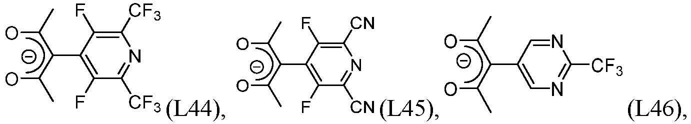

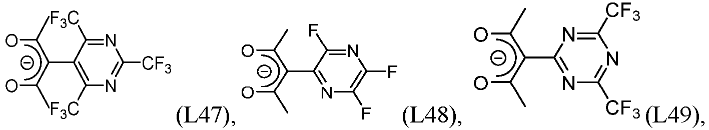

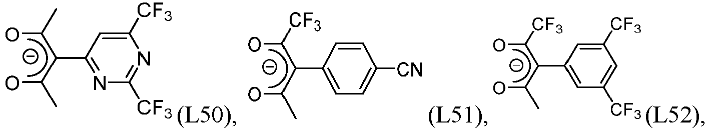

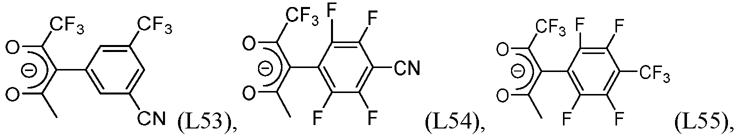

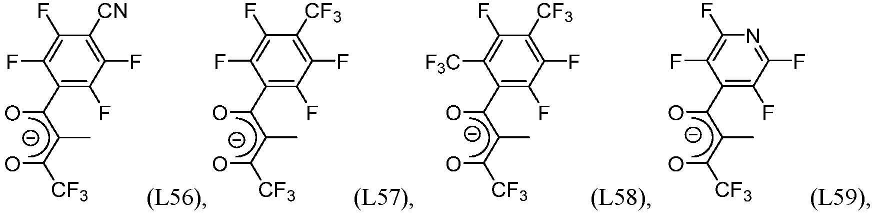

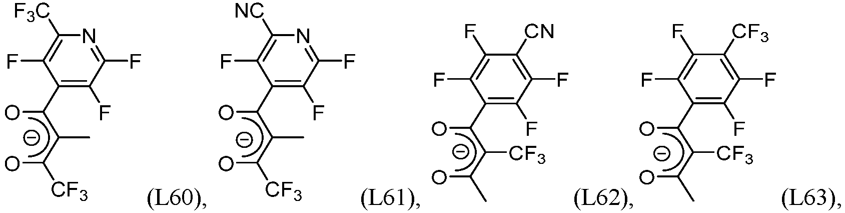

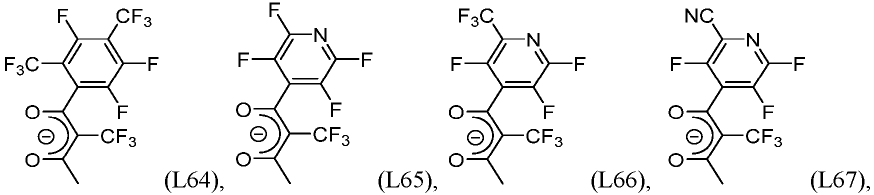

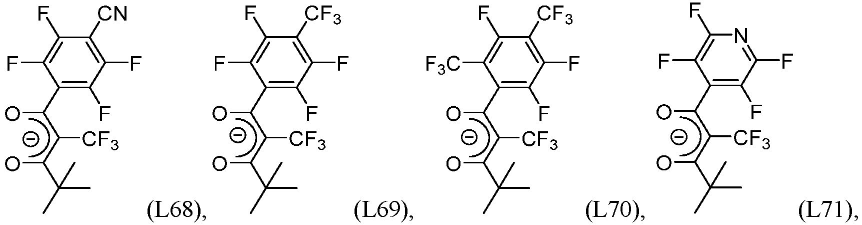

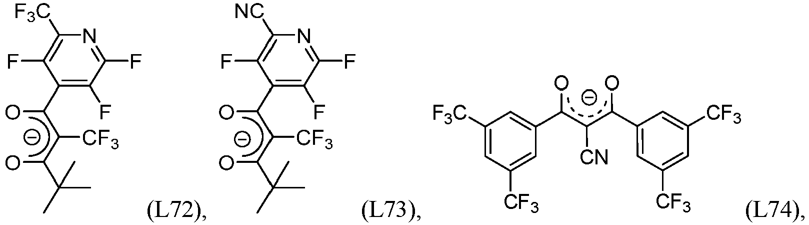

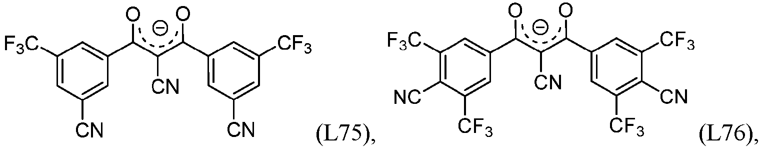

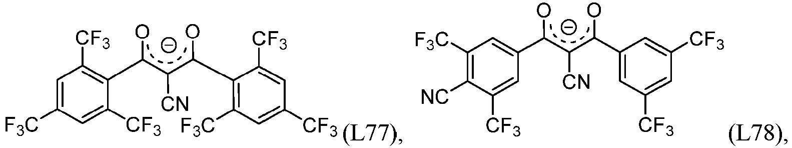

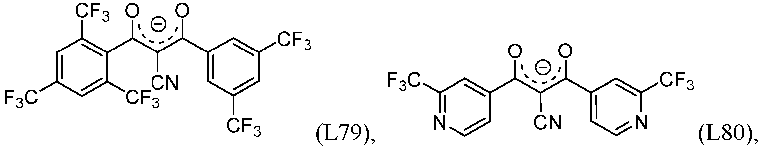

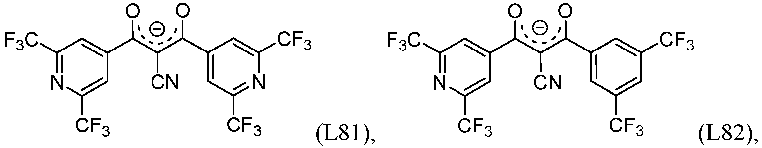

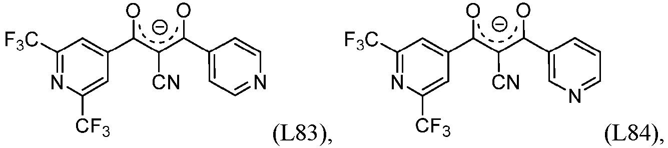

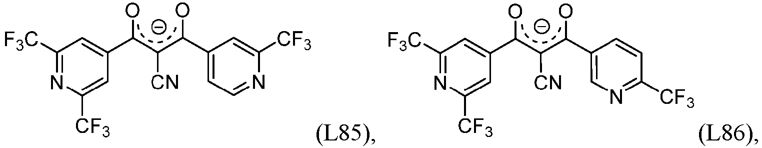

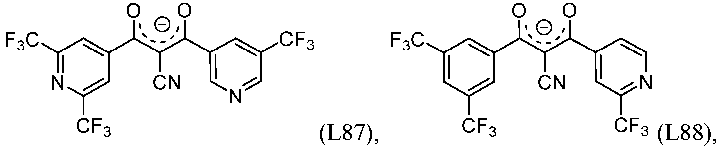

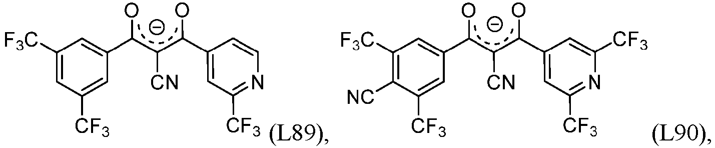

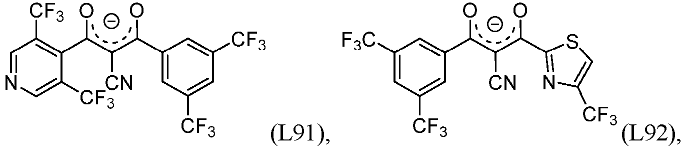

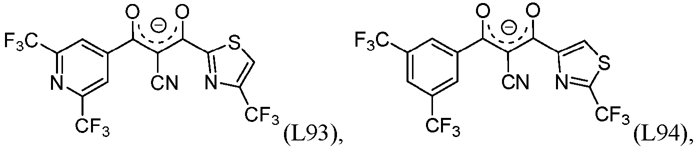

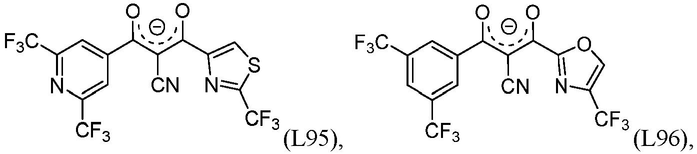

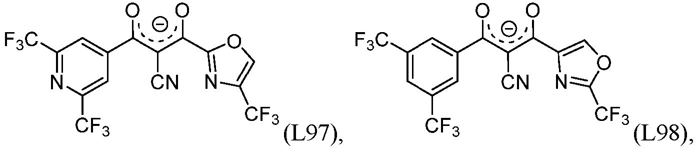

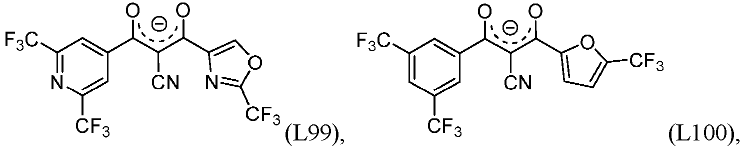

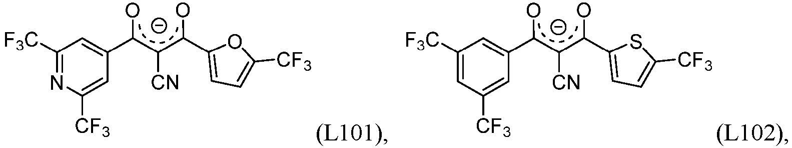

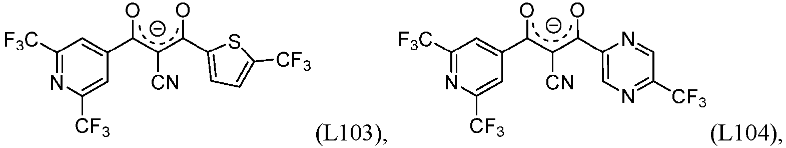

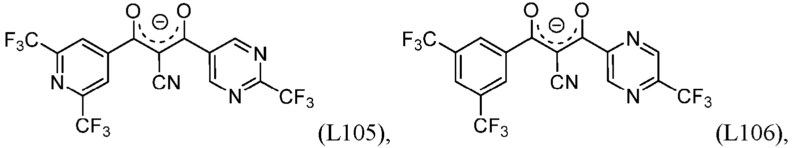

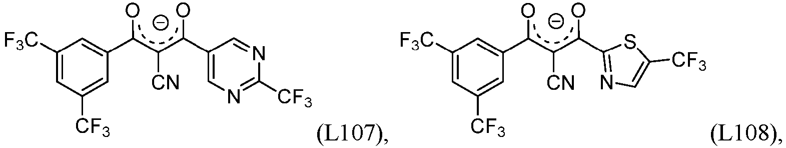

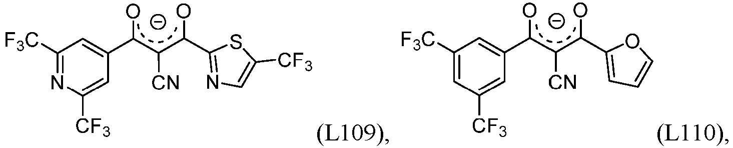

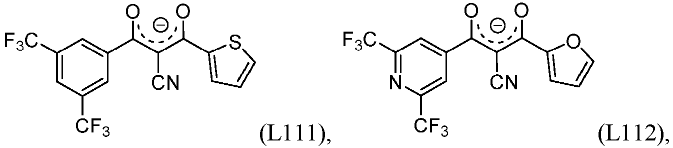

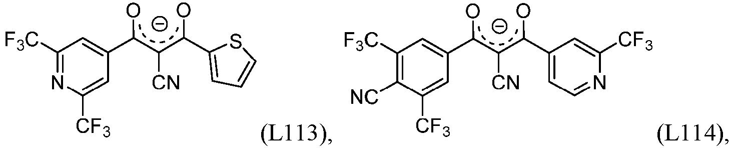

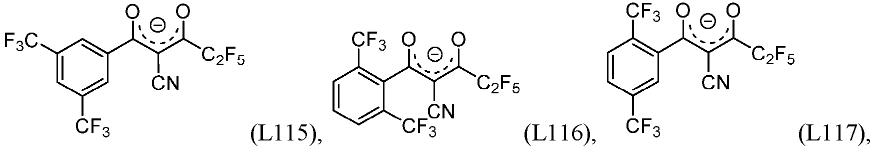

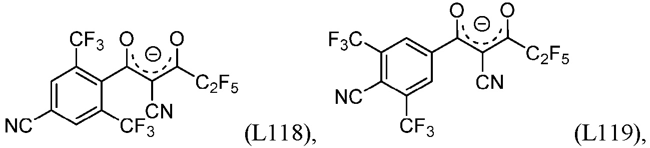

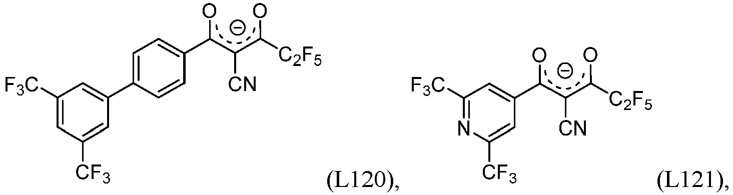

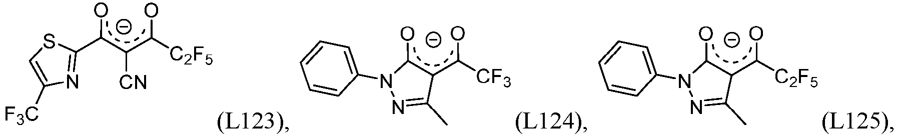

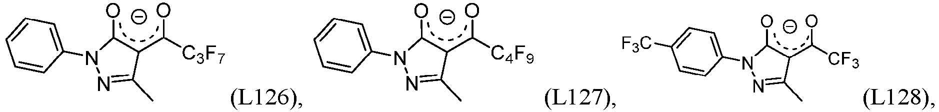

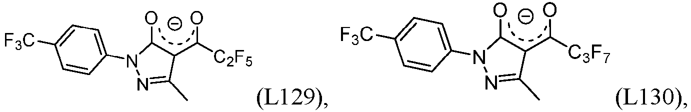

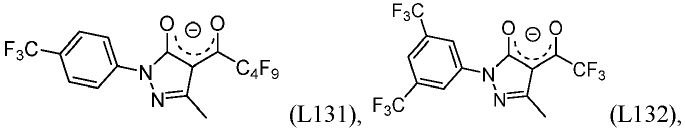

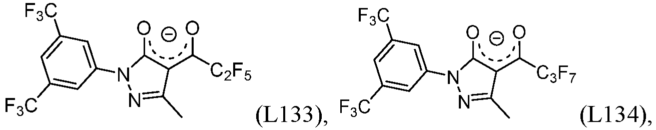

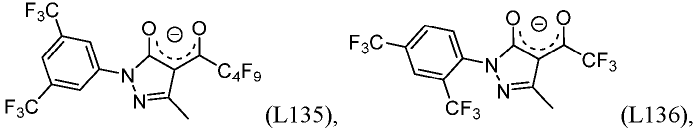

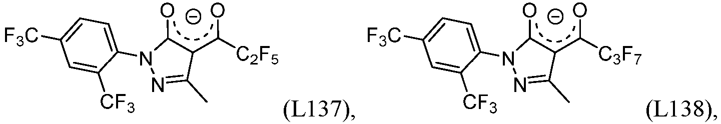

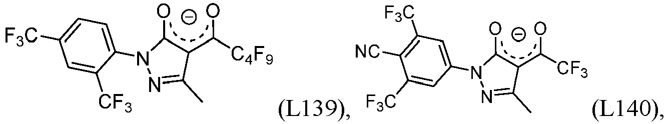

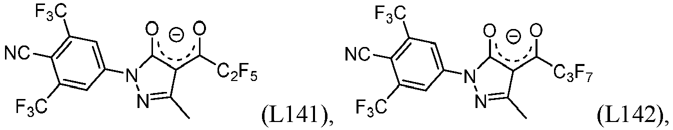

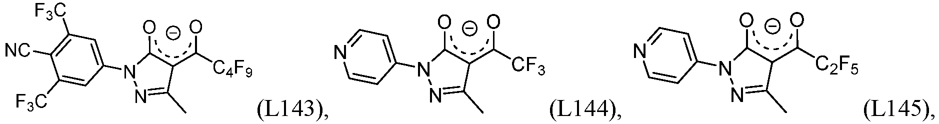

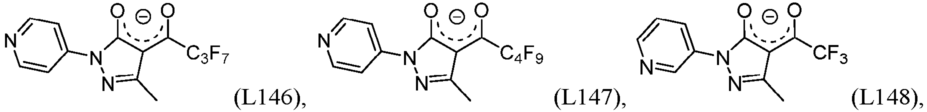

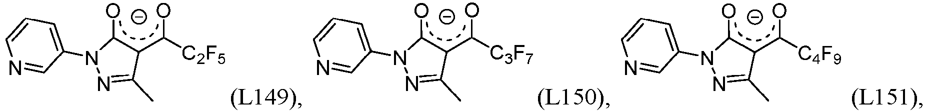

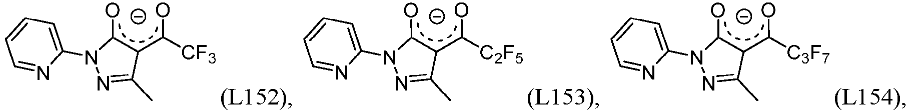

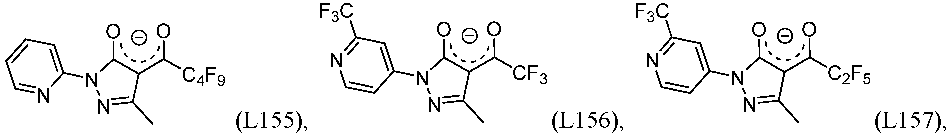

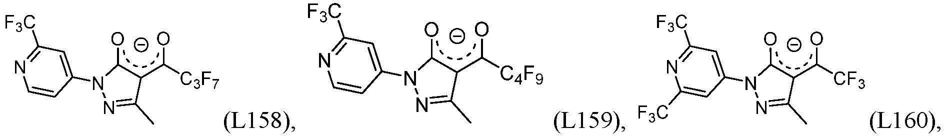

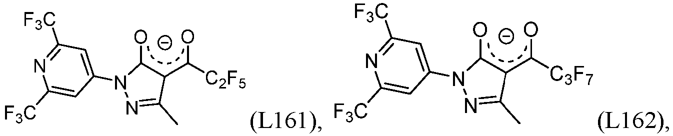

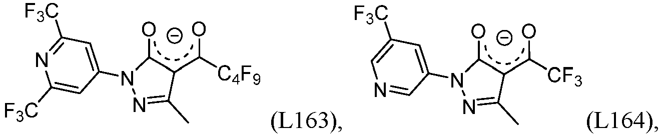

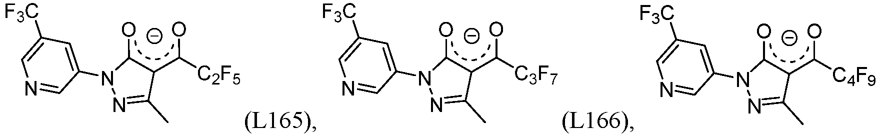

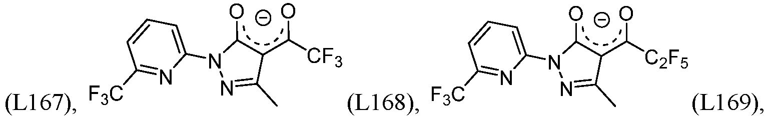

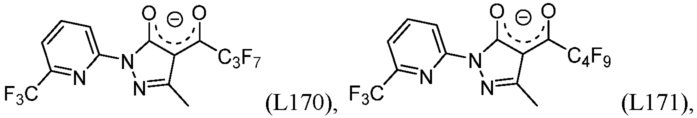

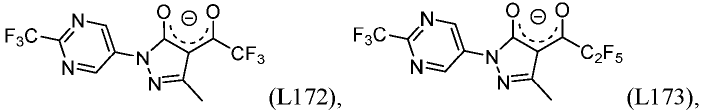

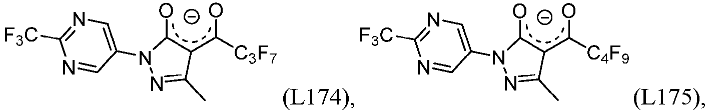

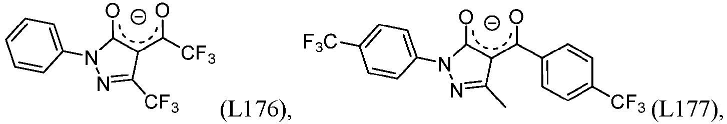

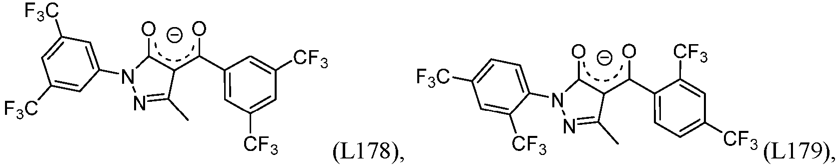

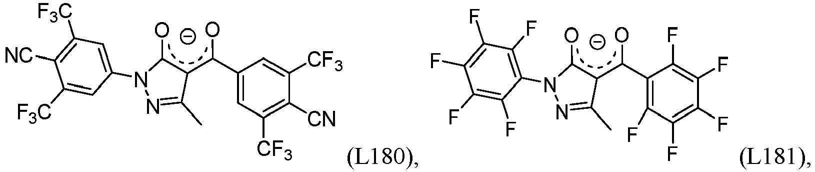

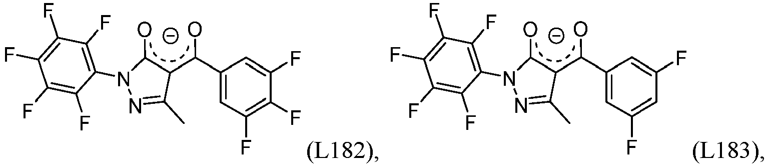

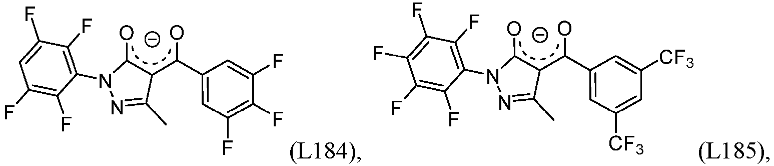

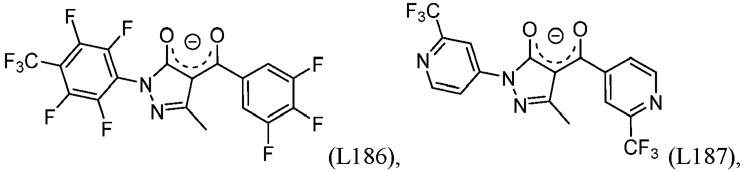

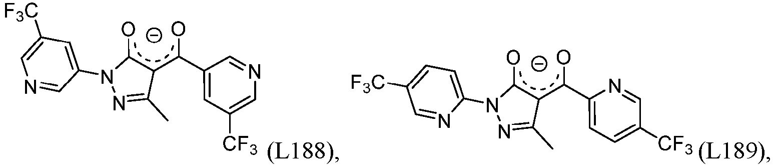

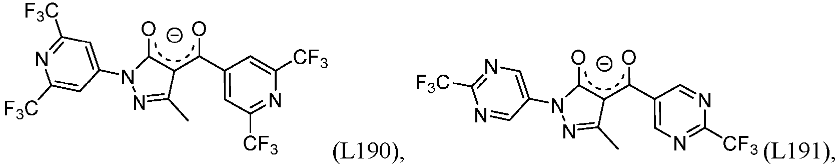

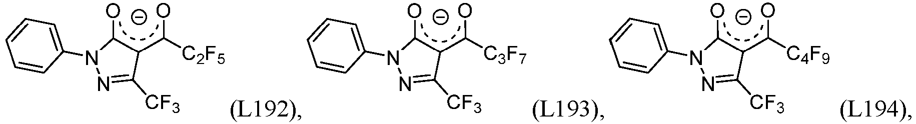

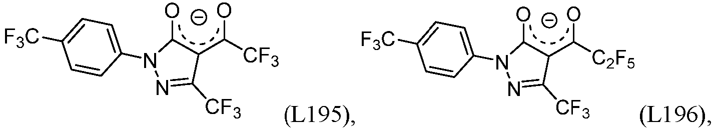

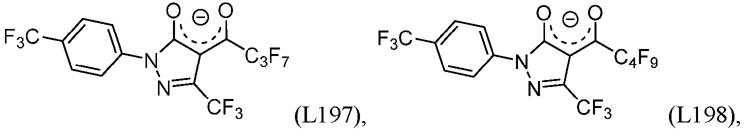

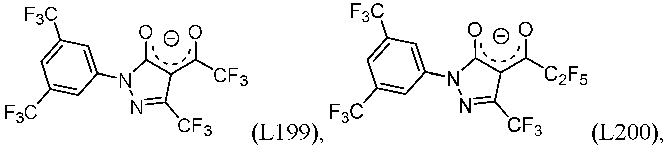

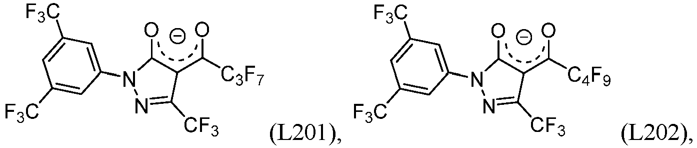

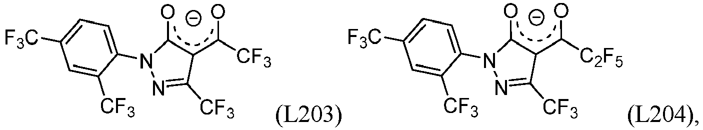

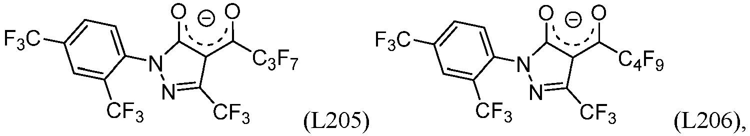

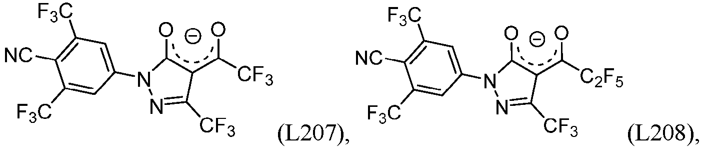

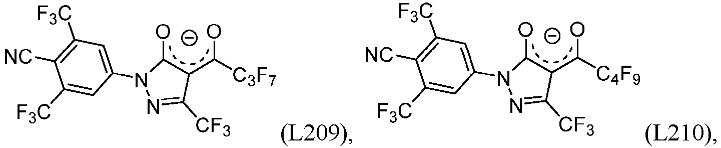

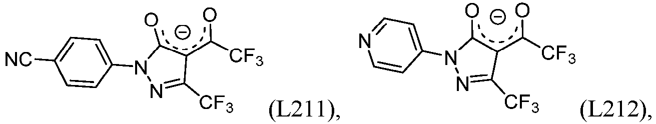

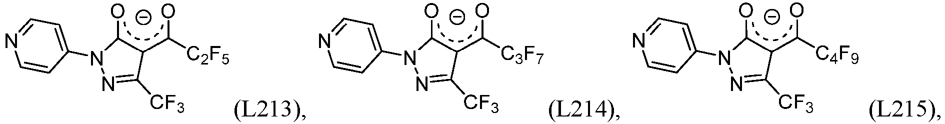

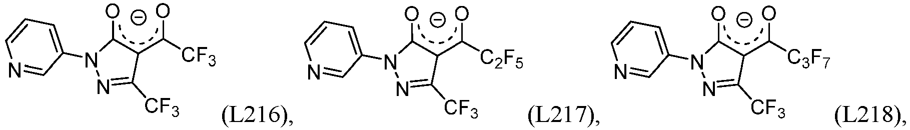

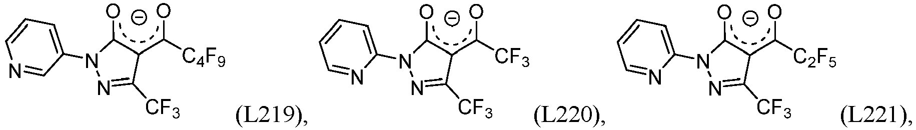

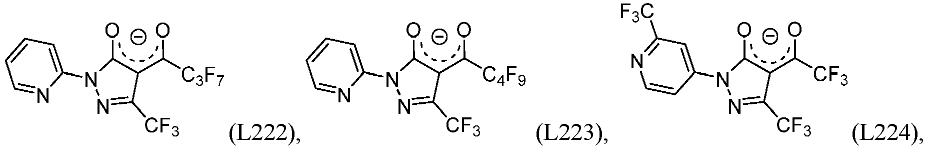

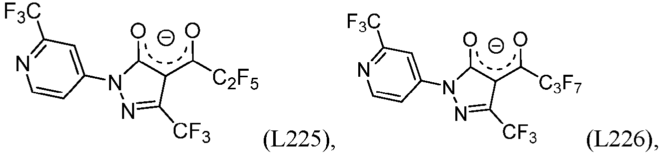

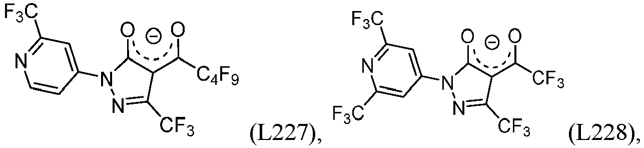

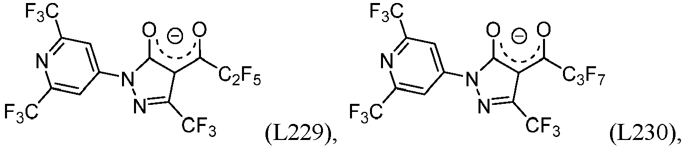

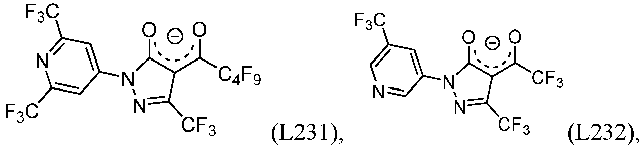

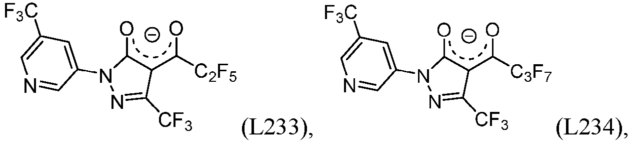

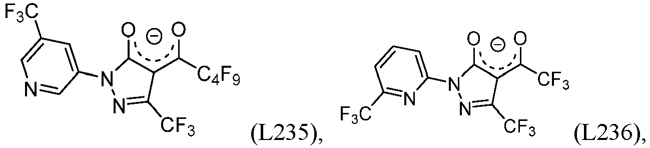

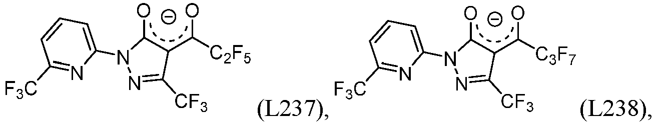

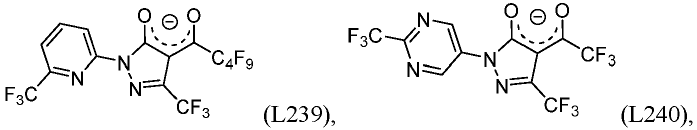

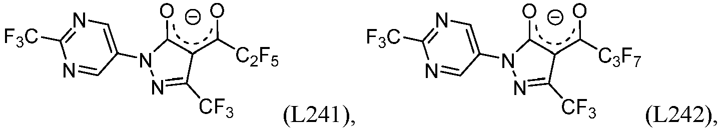

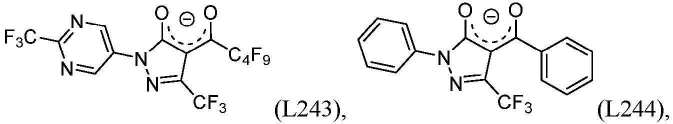

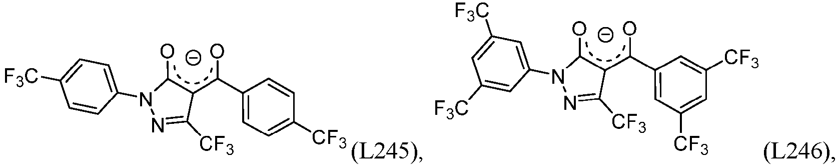

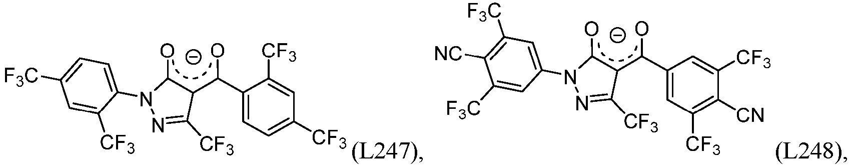

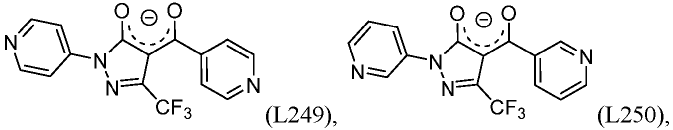

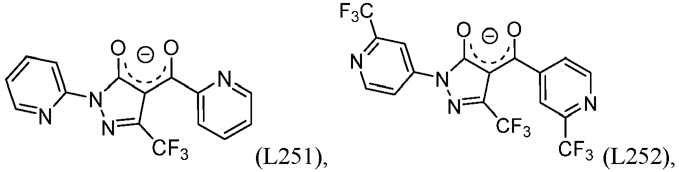

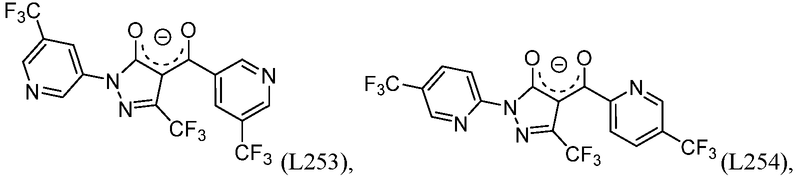

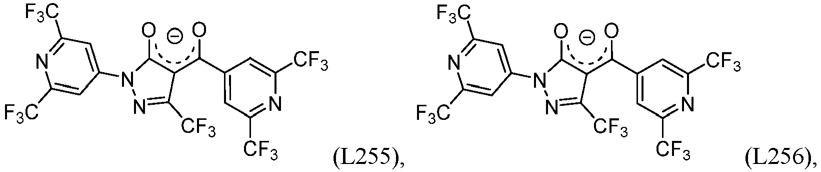

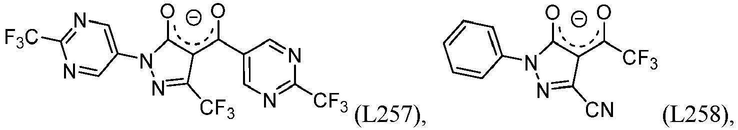

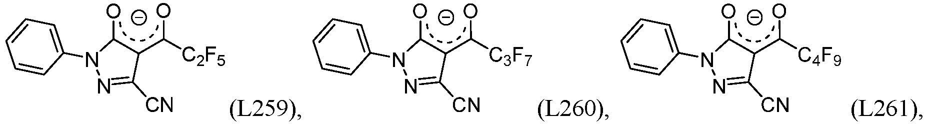

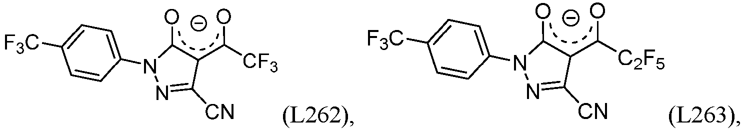

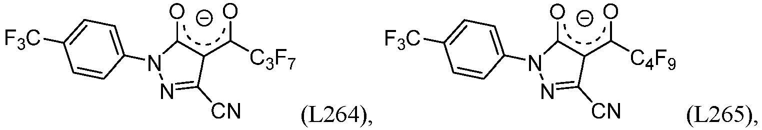

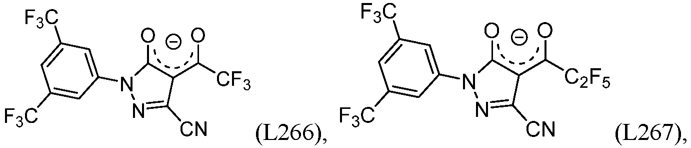

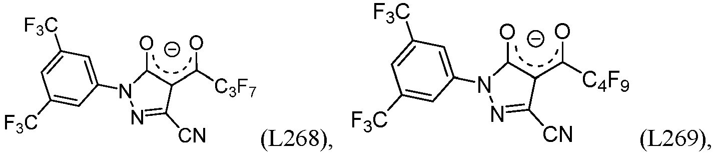

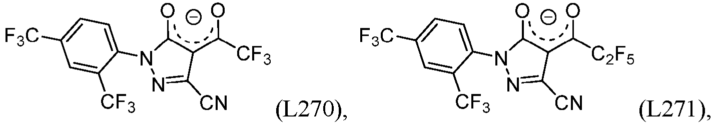

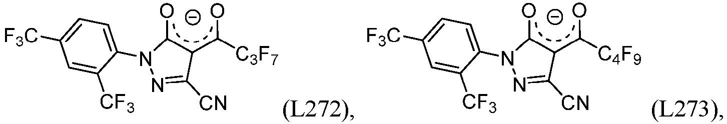

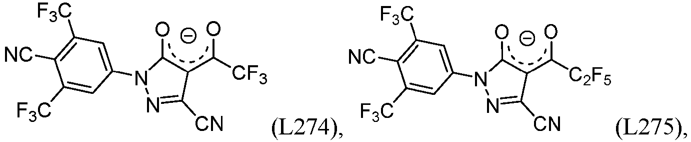

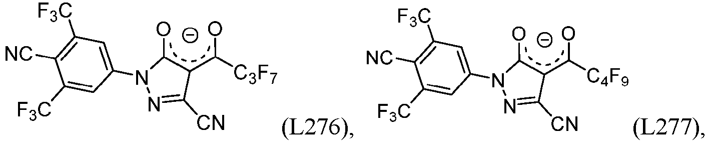

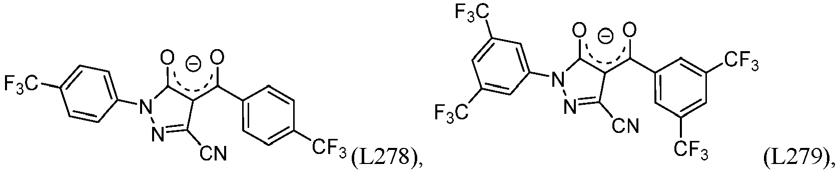

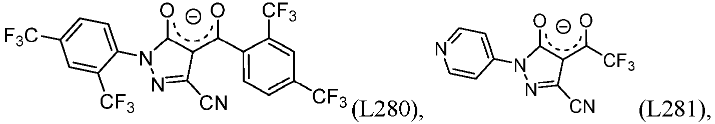

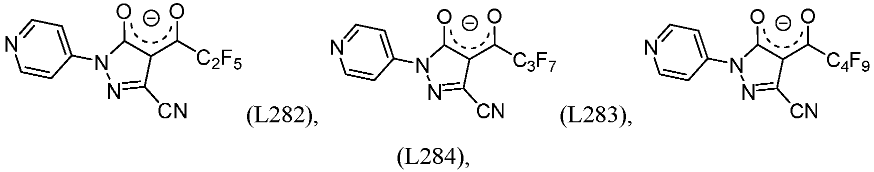

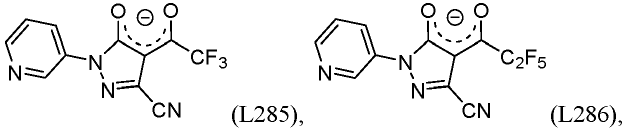

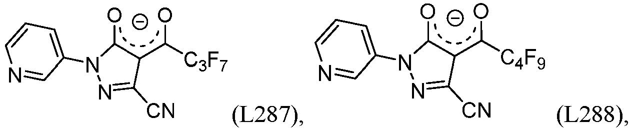

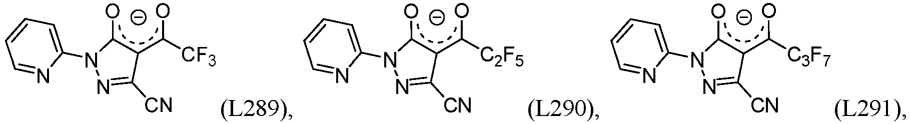

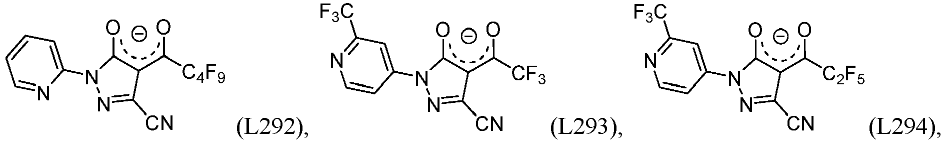

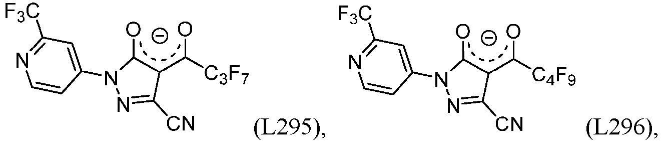

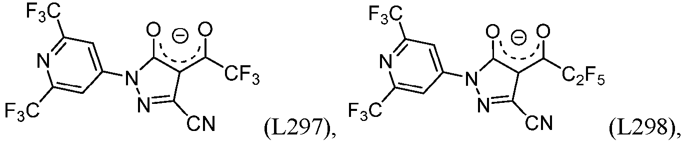

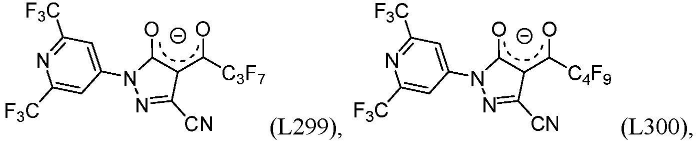

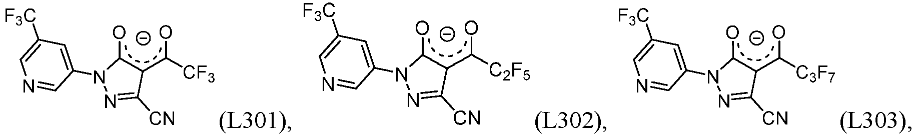

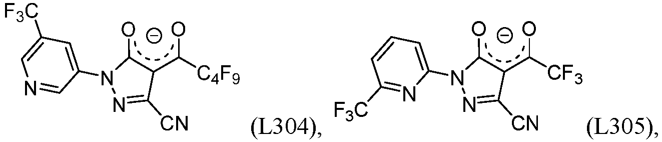

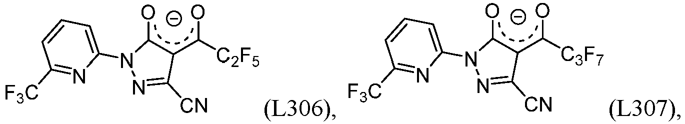

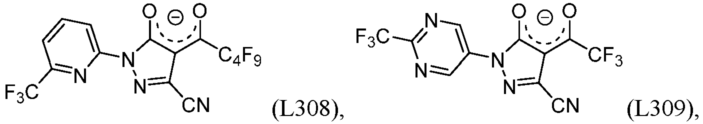

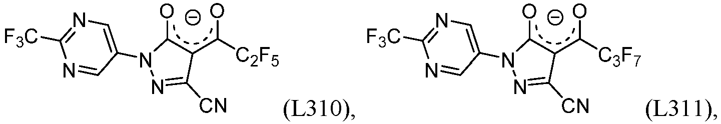

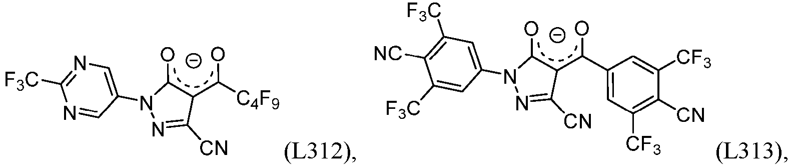

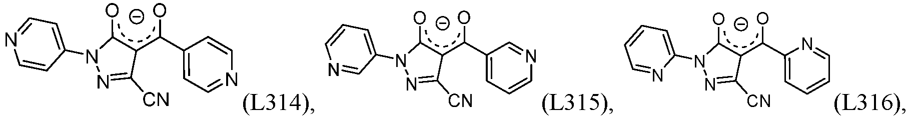

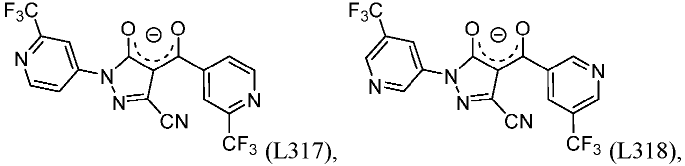

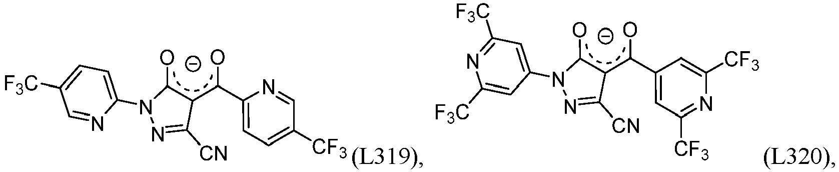

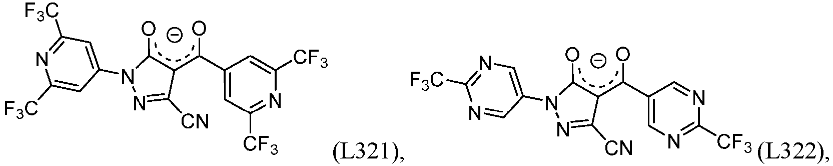

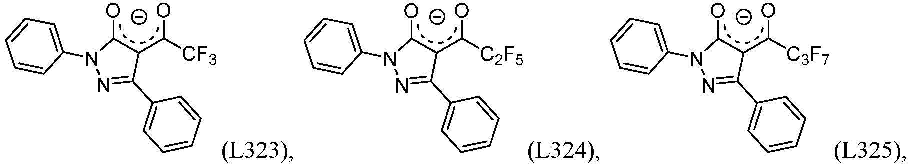

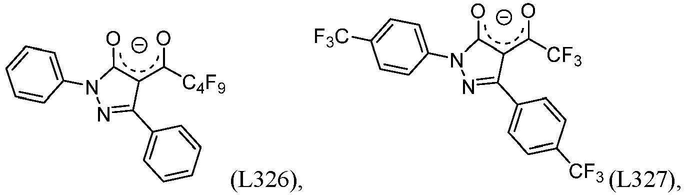

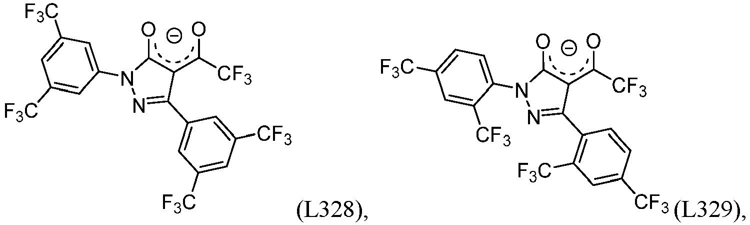

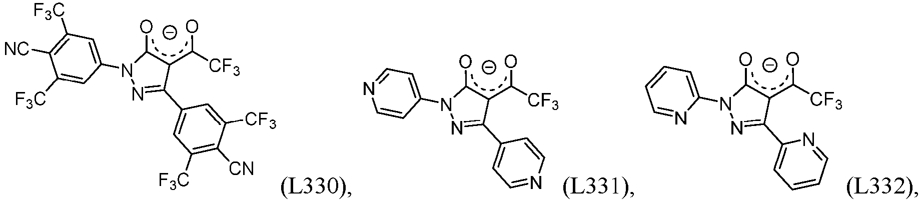

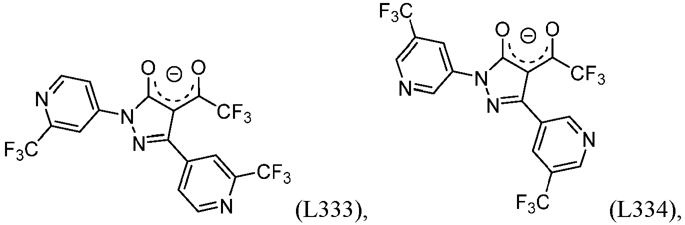

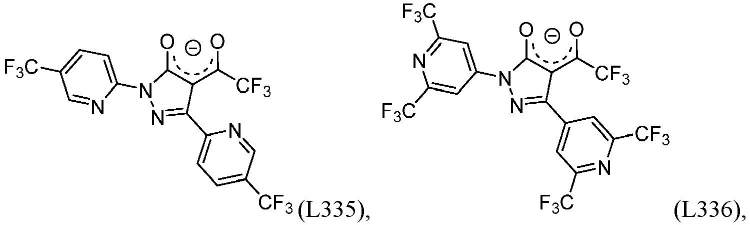

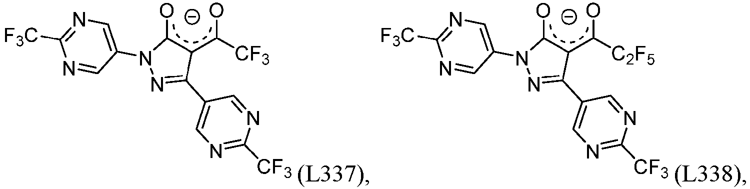

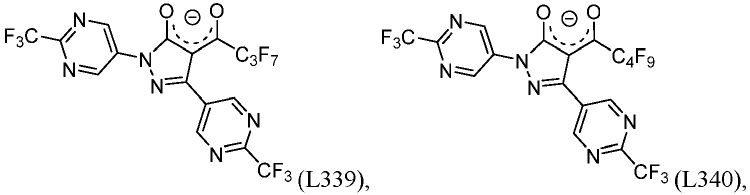

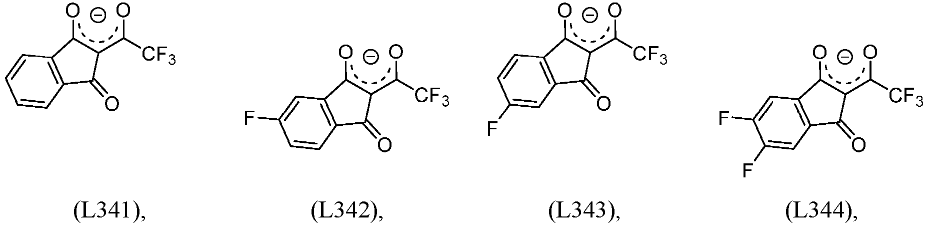

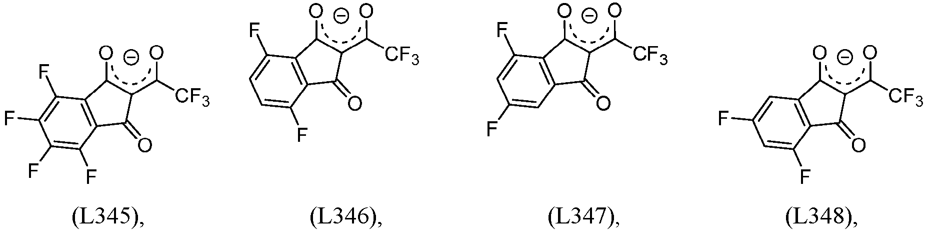

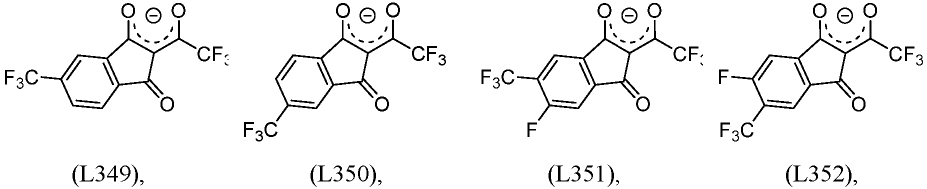

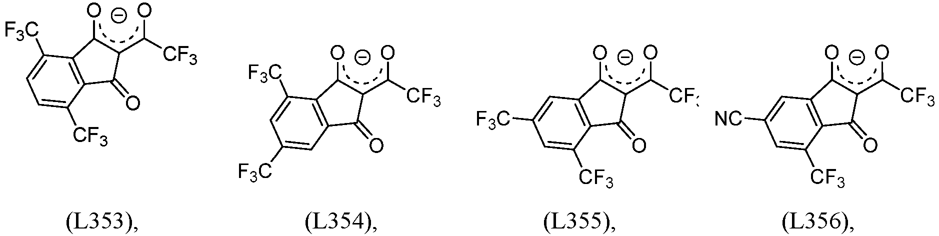

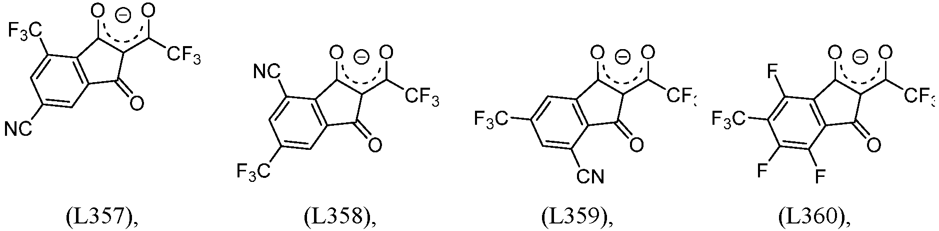

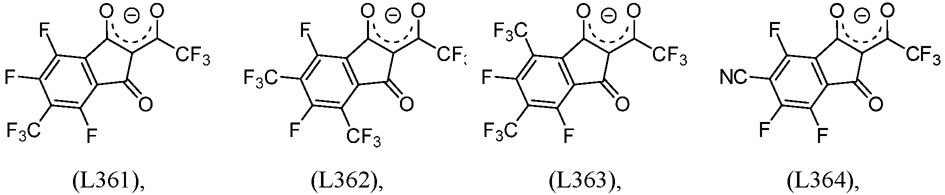

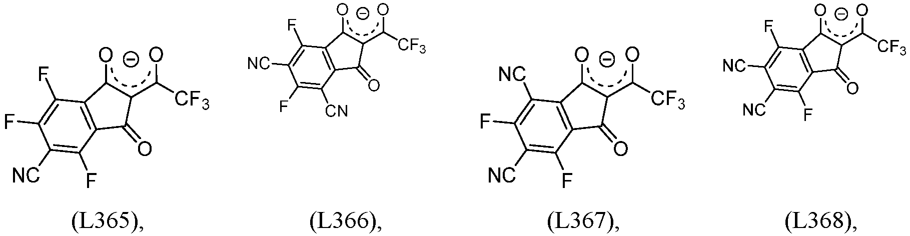

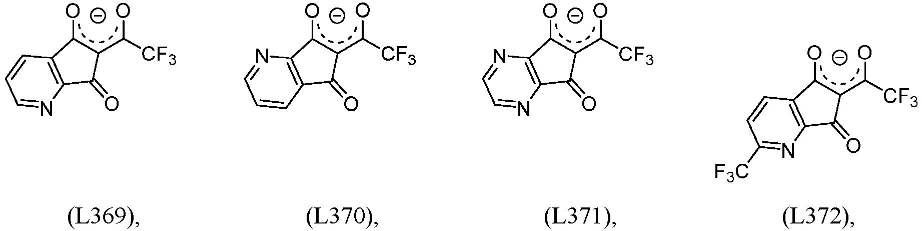

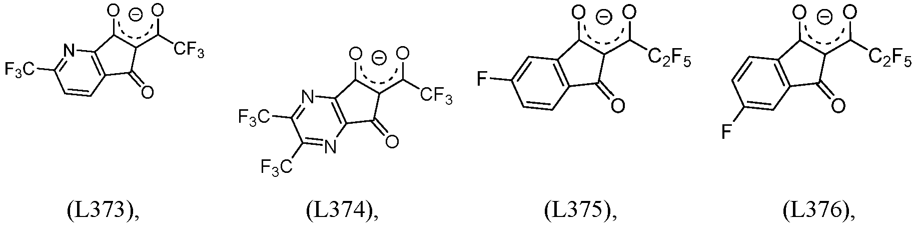

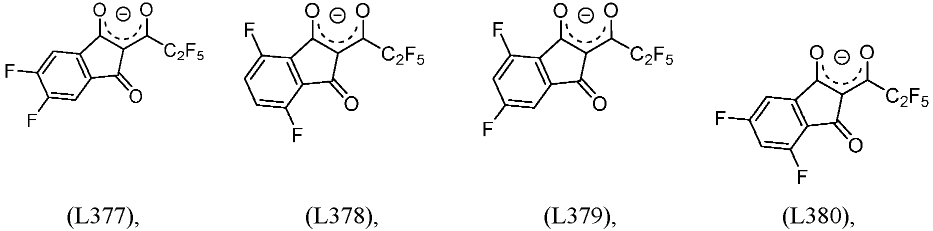

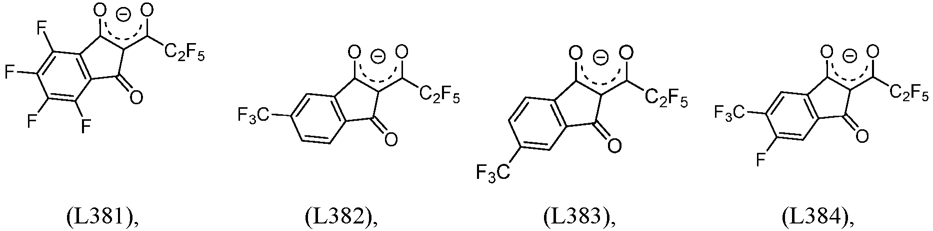

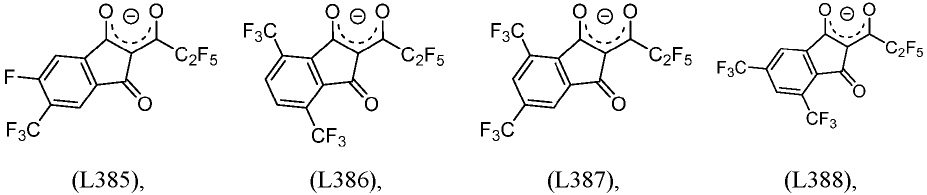

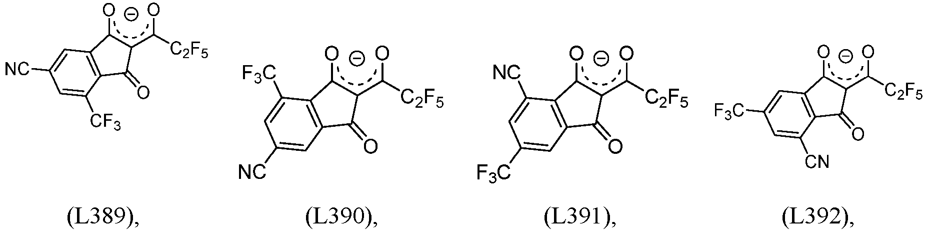

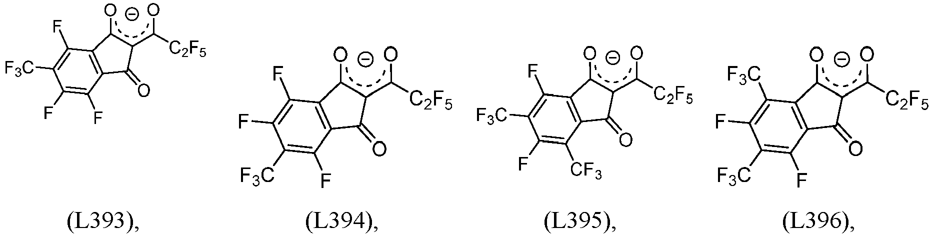

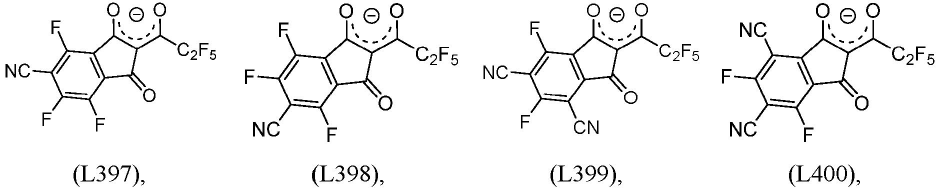

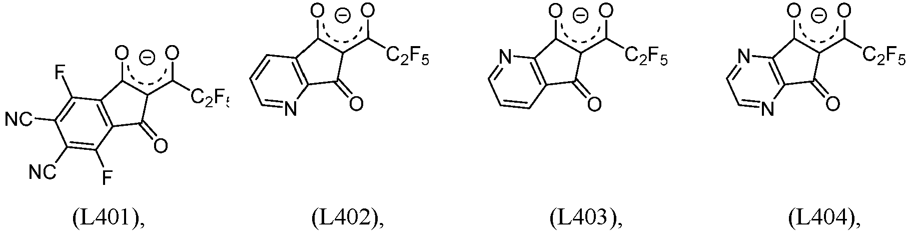

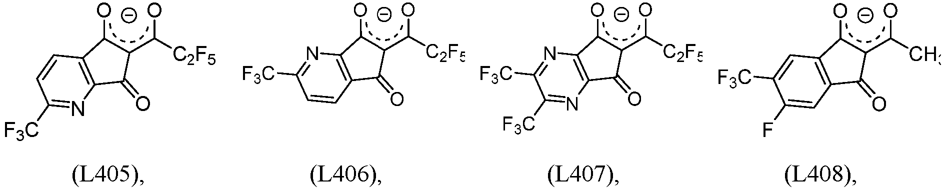

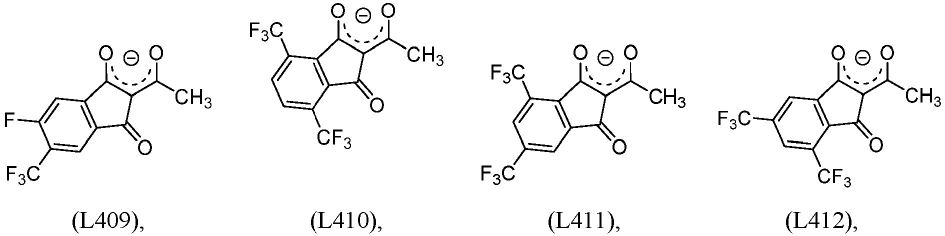

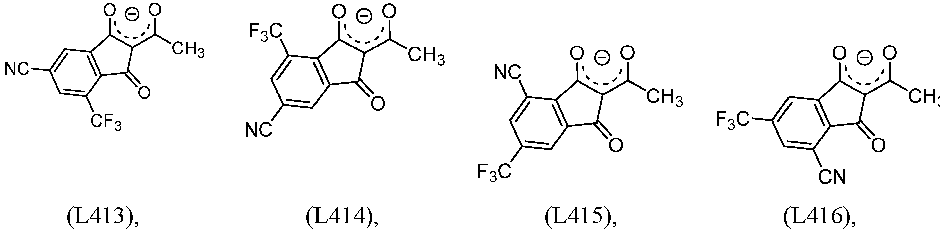

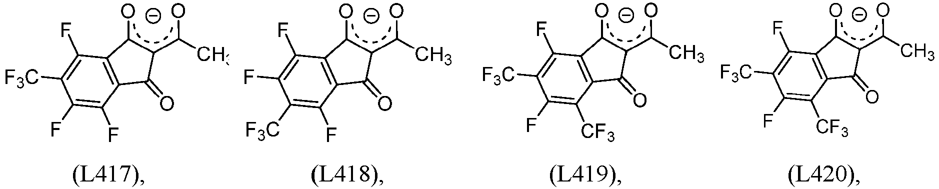

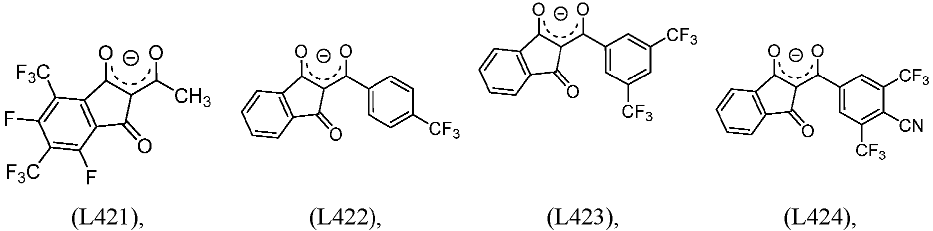

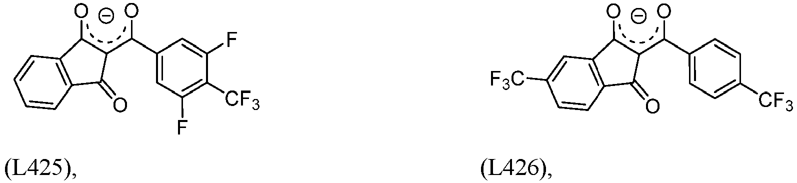

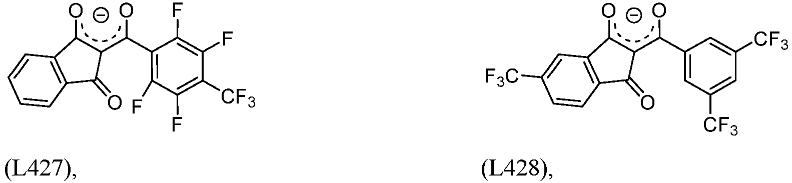

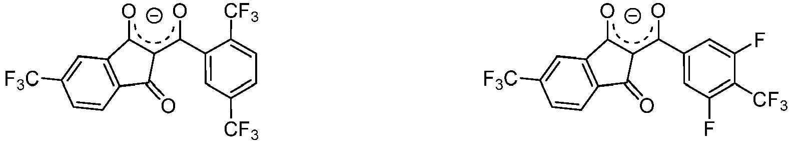

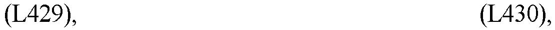

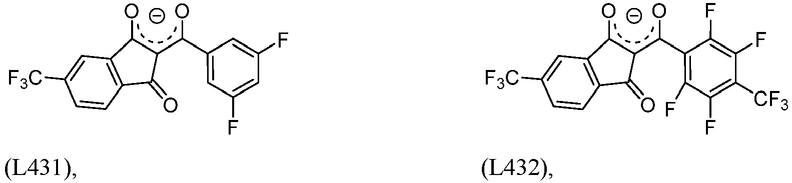

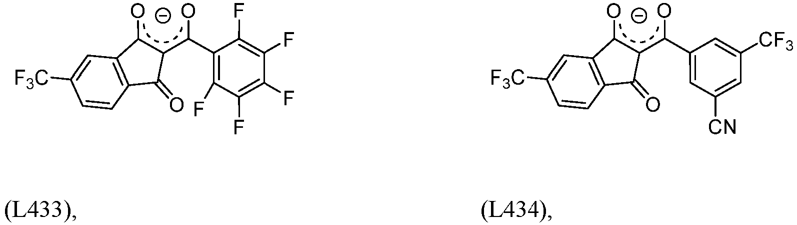

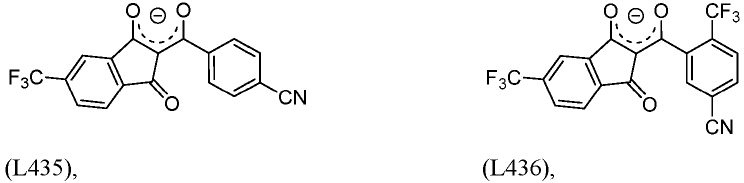

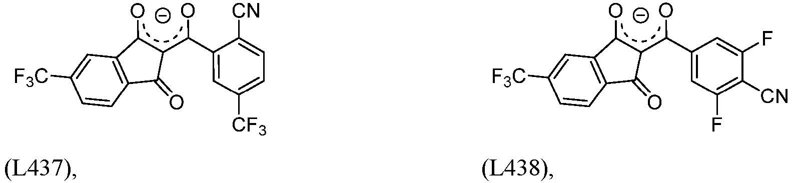

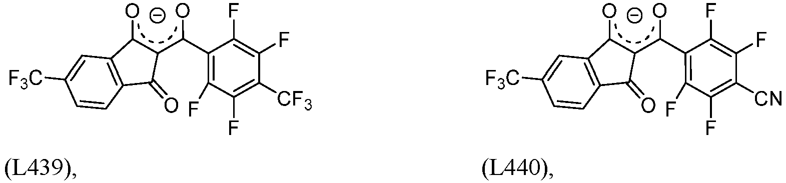

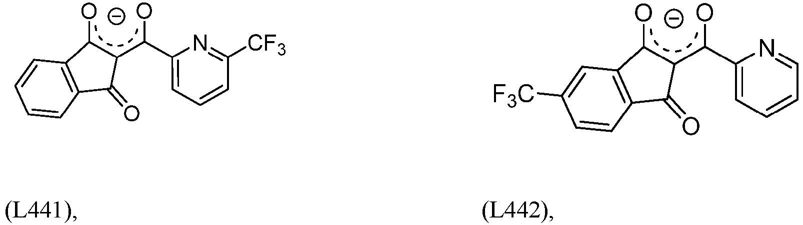

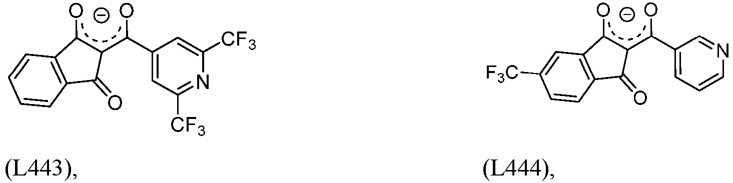

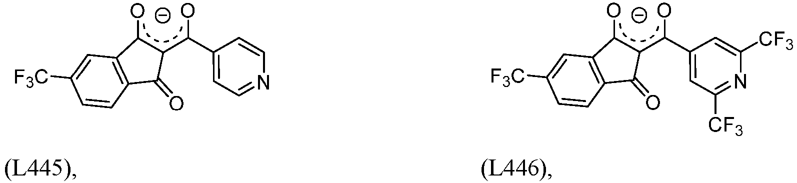

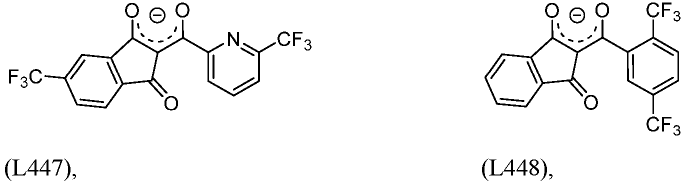

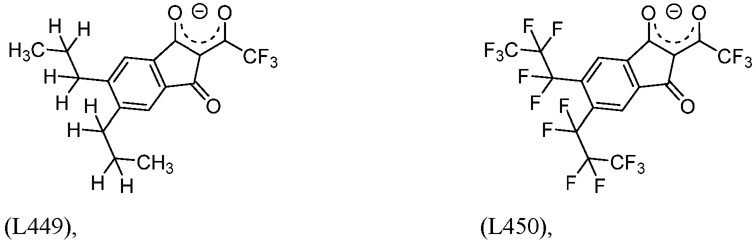

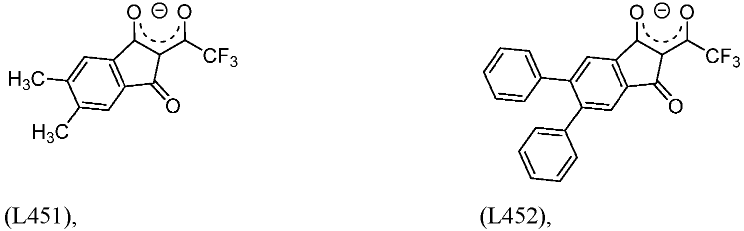

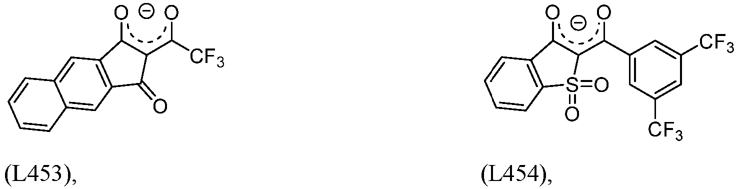

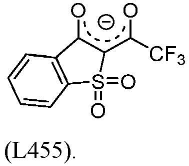

According to one embodiment, the ligand L is selected from the group consisting of formulae L1 to L24 and/or L56 to L455.
Particularly improved performance may be obtained when ligand L is selected from this group.

### M of the compound of Formula (II)

The term "M" represents a metal ion.

According to one embodiment, M of the compound of Formula (II) may be selected from a metal ion wherein the corresponding metal has an electronegativity value according to Pauling of ≥ 0.79 and ≤ 2.05.

The term "electronegativity value according to Pauling" especially refers to Pauling, Linus (1960). The Nature of the Chemical Bond. 3rd ed., Cornell University Press, p. 93, values can be obtained from https://en.wikipedia.org/wiki/Electronegativities_of_the_elements_(data_page)#Electronegativity _(Pauling_scale).

According to one embodiment, M of the compound of Formula (II) may be selected from a metal ion wherein the corresponding metal has an electronegativity value according to Allen of ≥ 0.65 and ≤ 1.9.

The term "electronegativity value according to Allen" especially refers to Allen, Leland C. (1989). "Electronegativity is the average one-electron energy of the valence-shell electrons in ground-state free atoms", Journal of the American Chemical Society 111 (25): 9003-9014.

According to one embodiment, M may be selected from a transition metal or group III or V metal.

According to one embodiment, the atomic mass of M is selected in the range of ≥ 54 Da and ≤ 200 Da, preferably in the range of ≥ 55 Da and ≤ 138 Da.

According to one embodiment, M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); more preferred M is a metal ion selected from Cu(II), Mn (II), Mn(III), Zn(II), Fe(III), Al(III), In(III), Ru(III) and/or Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); wherein the number in brackets denotes the oxidation state.

Thereby, the LUMO energy level and/or thermal properties of the compound of Formula (II) may be in the range suitable for use in organic electronic devices.

According to one embodiment, M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and L is selected from the formulae (IIIa), (IIIb), (IIIc), (IIId) and (IIIe).

Thereby, the LUMO energy level and/or thermal properties of the compound of Formula (II) may be in the range suitable for use in organic electronic devices.

According to one embodiment, M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and and L is selected from the formulae (IIIa), (IIIb), (IIIc), (IIId) and (IIIe), wherein at least one of R^{a}, R^{b} and/or R¹ is independently selected from the group consisting of formulae D1 to D 111; preferably one or two of R^{a} and R^{b} are independently selected from the group consisting of formulae D1 to D111.

Thereby, the LUMO energy level and/or thermal properties of the compound of Formula (II) may be in the range suitable for use in organic electronic devices.

According to one embodiment, M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and L is selected from the group consisting of formulae L1 to L455.

Thereby, the LUMO energy level and/or thermal properties of the compound of Formula (II) may be in the range suitable for use in organic electronic devices.

According to one embodiment, M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and L is selected from the group consisting of formulae L1 to L24 and/or L56 to L455.

Thereby, the LUMO energy level and/or thermal properties of the compound of Formula (II) may be in the range suitable for use in organic electronic devices.

According to one embodiment, the compound of formula (II) is selected from the group consisting of formulae M1 to M24:

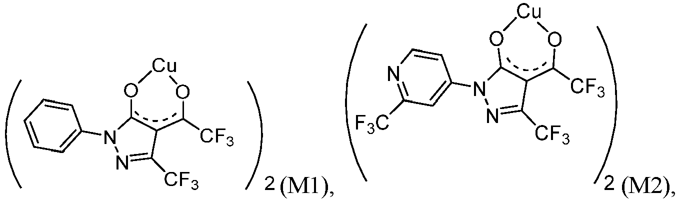

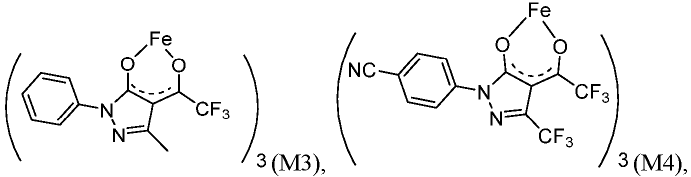

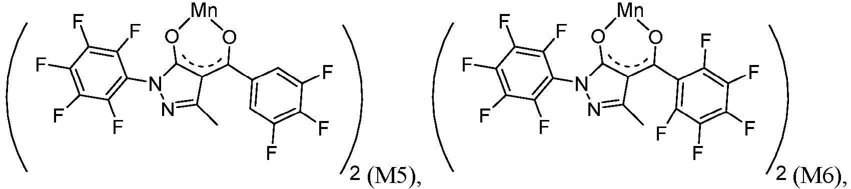

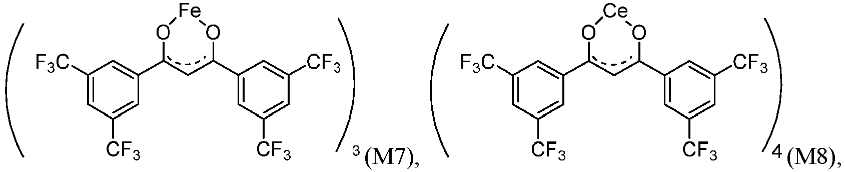

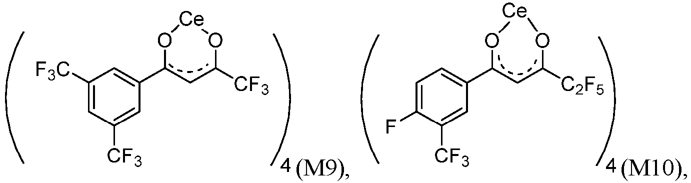

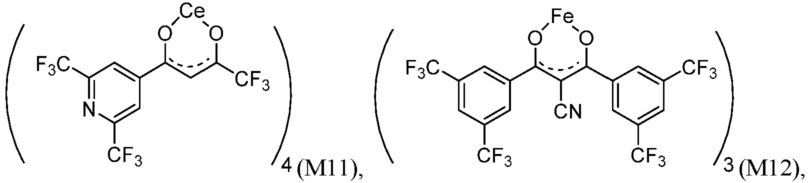

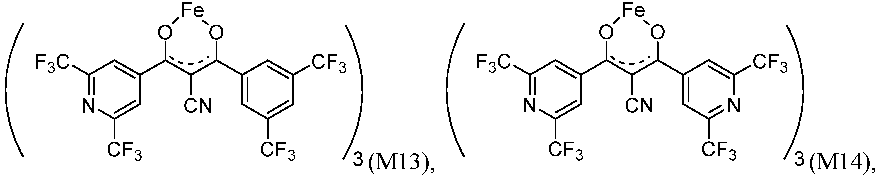

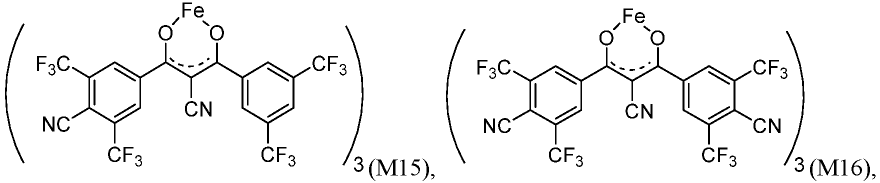

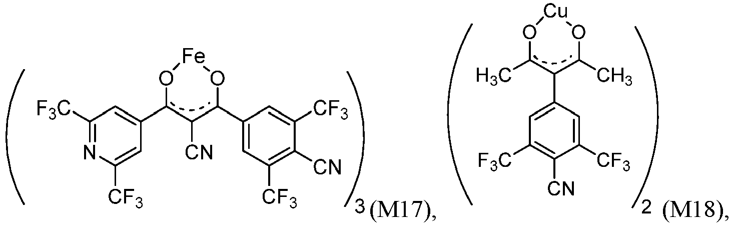

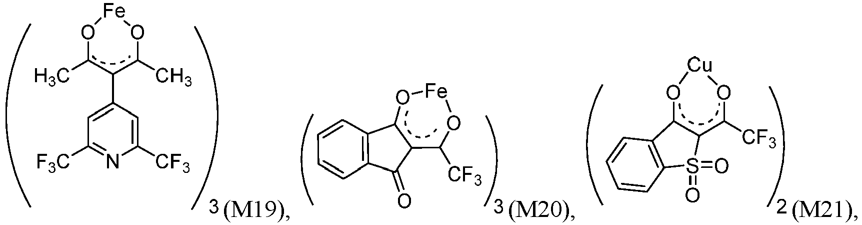

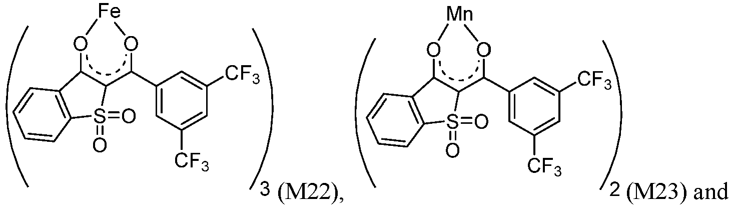

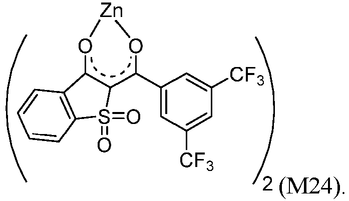

### n valency of M

The term "n" is the valency of M and selected from 1 to 4, preferably n = 1, 2, 3 or 4, further preferred n = 3 or 4. In addition preferred n = 1 or 2.

According to one embodiment "n" is an integer selected from 2, 3 and 4, which corresponds to the valency of M. According to one embodiment "n" is an integer selected from 2 or 3, which corresponds to the valency of M. According to one embodiment "n" is selected 2. According to another embodiment "n" is selected 4. According to another embodiment "n" is selected 3. According to another embodiment "n" is selected 4.

### Ancillary Ligand "AL"

According to one embodiment of the application, AL (the ancillary ligand) is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (AL-I); 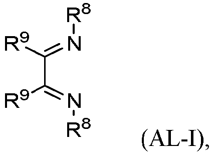 wherein
- R⁸ and R⁹: are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

### The term "m"

The term "m" is an integer selected from 0 to 2, which corresponds to the oxidation number of M. According to one embodiment "m" is an integer selected from 0 or 1. According to another embodiment "m" is an integer selected from 1. According to another embodiment "m" is an integer selected from 2. Preferably "m" is an integer and may be selected from 0.

According to another embodiment of compound of Formula (I), wherein n = 2 or 3; and/or m is an integer selected from 0 or 1, preferably 0.

### Hole injection layers (HILI / HIL2)

According to an embodiment of the present invention, the compound of formula (I) in the HIL1 and HIL2 is identical.

The thickness of the first hole injection layer (HIL1) may be in the range of 0.5 to 2 nm, preferably 0.5 to 1.5 nm.

The thickness of the second hole injection layer (HIL2) may be in the range of 1 to 20 nm, preferably 5 to 15 nm, also preferred 8 to 12 nm.

When the thickness of the first hole injection layer and/or second hole injection layer is within this range, the HIL may have excellent hole injecting characteristics, without a substantial penalty in driving voltage.

According to one embodiment of the present invention, the hole injection layer is deposited by vacuum thermal evaporation (VTE).

According to one embodiment of the present invention, the hole injection layer is free of metal-containing compounds and/or metal salts which are free of fluorine atoms.

According to one embodiment of the present invention, the first hole injection layer and/or the second hole injection layer is free of metal-containing compounds and/or metal salts which are free of fluorine atoms.

According to one embodiment of the present invention, the hole injection layer, first hole injection layer and/or second hole injection layer is free of LiQ, metal chloride, FeCl₃, metal phthalocyanine, haloginated metal phthalocyanine, CuPc, F₁₆CuPc, metal oxide, vanadium oxide, V₂O₅, molybdenum oxide, MoOs, rhenium oxide, Re₂O₇, indium tin oxide, zinc tin oxide and/or compound with CAS Registry number 262379-66-8.

According to one embodiment of the present invention, the compound of formula (I) comprises at least one naphthyl group, carbazole group, dibenzofuran group, dibenzothiophene group and/or substituted fluorenyl group, wherein the substituents are independently selected from methyl, phenyl or fluorenyl; and the compound of formula (II) comprises a ligand L of formula (IIIa), (IIIb), (IIIc), (IIId) and (IIIe).

According to one embodiment of the present invention, the compound of formula (I) comprises at least one naphthyl group, carbazole group, dibenzofuran group, dibenzothiophene group and/or substituted fluorenyl group, wherein the substituents are independently selected from methyl, phenyl or fluorenyl; and
the compound of formula (II) comprises a ligand L of formula (IIIa), (IIIb), (IIIc), (IIId) and (IIIe), wherein at least one of R^{a}, R^{b} or R¹ is independently selected from the group consisting of formulae D1 to D111.

According to one embodiment of the present invention, the compound of formula (I) comprises at least one naphthyl group, carbazole group, dibenzofuran group, dibenzothiophene group and/or substituted fluorenyl group, wherein the substituents are independently selected from methyl, phenyl or fluorenyl; and
the compound of formula (II) wherein L is selected from the group consisting of formulae L1 to L455.

According to one embodiment of the present invention, the compound of formula (I) comprises at least one naphthyl group, carbazole group, dibenzofuran group, dibenzothiophene group and/or substituted fluorenyl group, wherein the substituents are independently selected from methyl, phenyl or fluorenyl; and
the compound of formula (II) comprises a metal ion M selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and a ligand L of formula (IIIa), (IIIb), (IIIc), (IIId) and (IIIe).

According to one embodiment of the present invention, the compound of formula (I) comprises at least one naphthyl group, carbazole group, dibenzofuran group, dibenzothiophene group and/or substituted fluorenyl group, wherein the substituents are independently selected from methyl, phenyl or fluorenyl; and
the compound of formula (II) comprises a metal ion M selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and a ligand L of formula (IIIa), (IIIb), (IIIc), (IIId) and (IIIe), wherein at least one of R^{a}, R^{b} or R¹ is independently selected from the group consisting of formulae D1 to D 111.

According to one embodiment of the present invention, the compound of formula (I) comprises at least one naphthyl group, carbazole group, dibenzofuran group, dibenzothiophene group and/or substituted fluorenyl group, wherein the substituents are independently selected from methyl, phenyl or fluorenyl; and
the compound of formula (II) comprises a metal ion M selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II) or Fe(III) and Ce(IV); even more preferred M is a metal ion selected from Cu(II), Mn (II), Zn(II), Fe(III) and/or Ce(IV); especially preferred M is Cu(II), Zn(II), Mn(II) and/or Fe(III); and ligand L is selected from the group consisting of formulae L1 to L455.

### Hole transport layer

According to an embodiment, the compound of formula (I) in the second hole injection layer (HIL2) and the hole transport layer (HTL) is selected the same.

According to an embodiment, all three layers HIL1, HIL2 and HTL comprise an identical compound of formula (I).

According to an embodiment, the hole transport layer HTL is in direct contact with the second hole injection layer HIL2.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

Preferably, the hole transport layer is deposited by vacuum thermal evaporation (VTE).

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode layer

The anode layer, also named anode electrode, may be formed by depositing or sputtering a material that is used to form the anode layer. The material used to form the anode layer may be a high work-function material, so as to facilitate hole injection. The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

The anode layer may comprise two or more anode sub-layers.

According to one embodiment, the anode layer comprises a first anode sub-layer and a second anode sub-layer, wherein the first anode sub-layer is arranged closer to the substrate and the second anode sub-layer is arranged closer to the cathode layer.

According to one embodiment, the anode layer may comprise a first anode sub-layer comprising or consisting of Ag or Au and a second anode-sub-layer comprising or consisting of transparent conductive oxide.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and optionally a third anode sub-layer comprising or consisting of transparent conductive oxide. Preferably the first anode sub-layer may comprise or consists of Ag, the second anode-sublayer may comprise or consists of ITO or IZO and the third anode sub-layer may comprises or consists of ITO or IZO.

Preferably the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm.

It is to be understood that the third anode layer is not part of the substrate.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emitter dopant may be a phosphorescent or fluorescent emitter. Phosphorescent emitters and emitters which emit light via a thermally activated delayed fluorescence (TADF) mechanism may be preferred due to their higher efficiency

Examples of red emitter dopants are PtOEP, Ir(piq)3, and Btp2lr(acac), but are not limited thereto.

Examples of phosphorescent green emitter dopants are Ir(ppy)3 (ppy = phenylpyridine), Ir(ppy)2(acac), Ir(mpyp)3.

Examples of phosphorescent blue emitter dopants are F₂Irpic, (F₂ppy)₂Ir(tmd) and Ir(dfppz)₃.

These compounds are phosphorescent emitters, however, fluorescent red emitter dopants could also be used.

It may be provided that the emission layer does not comprise the compound of Formula (I).

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment of the present invention, the emission layer comprises a light-emitting compound of formula (IV): 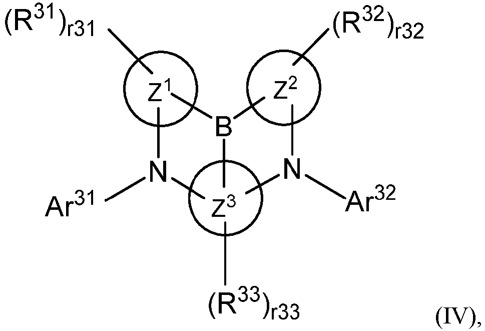 wherein
Z¹, Z² and Z³ are the same as or different from each other, and are each independently selected from the group comprising a monocyclic to polycyclic aromatic hydrocarbon ring or monocyclic to polycyclic aromatic hetero ring;
Ar³¹ and Ar³² are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
R³¹, R³² and R³³ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
r³¹, r³² and r³³ are each an integer from 0, 1, 2, 3 or 4, and when r³¹ to r³³ are 2 or higher, substituents in the parenthesis are the same as or different from each other.

According to one embodiment, for formula (III):
- Z¹, Z² and Z³: are the same as or selected different from each other, and are each independently selected from the group comprising a monocyclic to bicyclic aromatic hydrocarbon ring, or a monocyclic to bicyclic aromatic hetero ring containing O, N or S;
- Ar³¹ and Ar³²: are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;
- R³¹, R³² and R³³: are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group. According to one embodiment, wherein for formula (III):
- Z¹, Z² and Z³: are the same as or selected different from each other, and are each independently selected from the group comprising a benzene ring or a thiophene ring;
- Ar³¹ and Ar³²: are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;
- R³¹, R³² and R³³: are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (IV) is selected from formulae (BD1) to (BD9):

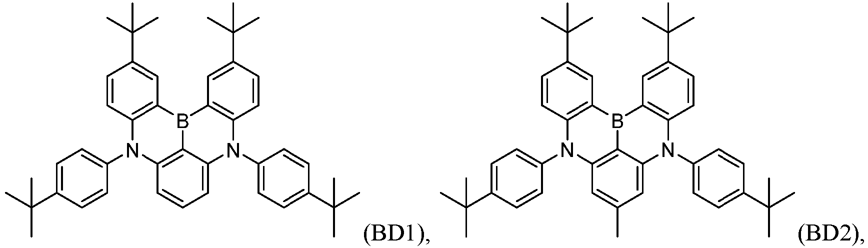

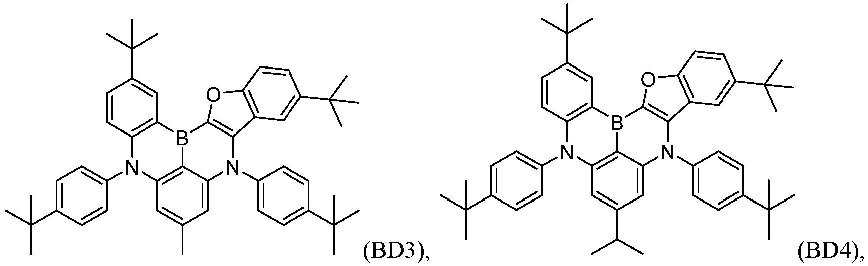

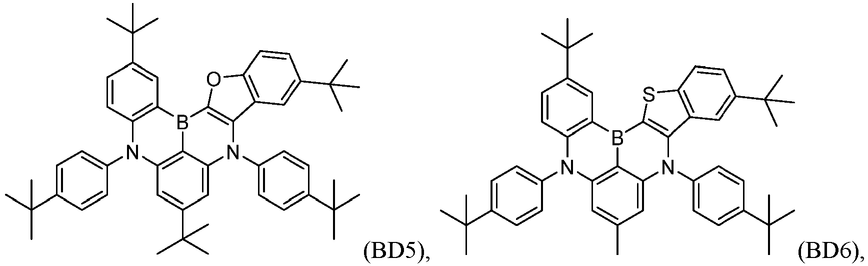

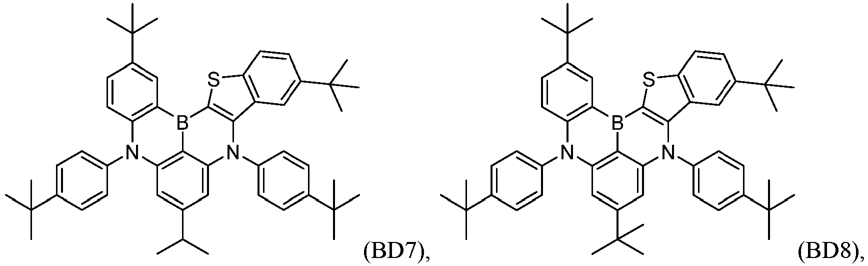

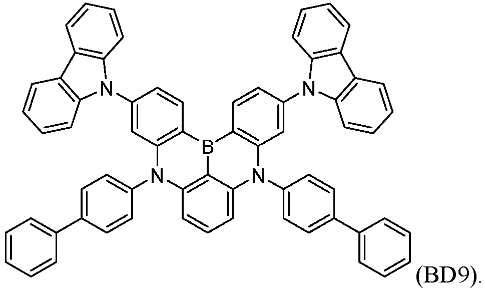

According to a preferred embodiment of the present invention, the emission layer comprises an organic emitter host compound, wherein the organic emitter host compound comprises
- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;
wherein the molecular weight Mw of the organic emitter host compound is in the range of ≥ 400 and ≤ 2000 g/mol.

According to a preferred embodiment of the present invention, the organic emitter host compound has the formula (V) 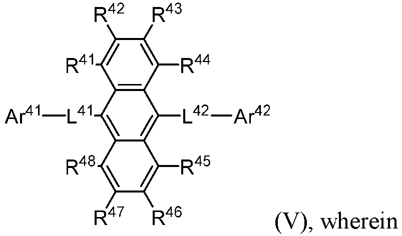
Ar⁴¹ and Ar⁴² are independently selected from substituted or unsubstituted C₆ to C₂₄ aryl, substituted or unsubstituted C₃ to C₂₄ heteroaryl;
L⁴¹ and L⁴² are independently selected from a direct bond or substituted or unsubstituted C₆ to C₂₄ arylene, substituted or unsubstituted C₃ to C₂₄ heteroarylene;
R⁴¹ to R⁴¹ are independently selected from H, D, substituted or unsubstituted C₁ to C₁₂ alkyl, CH₃, CF₃, CF₂H, substituted or unsubstituted C₆ to C₁₉ aryl, substituted or unsubstituted C₃ to C₁₂ heteroaryl;
wherein
the substituents on Ar⁴¹, Ar⁴², L⁴¹, L⁴², R⁴¹ to R⁴⁸ are independently selected from D, C₆ to C₁₀ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, halogen, F or CN.

According to a preferred embodiment of the present invention, the organic emitter host and/or compound of formula (V) is selected from formulae (BH1) to (BH13):

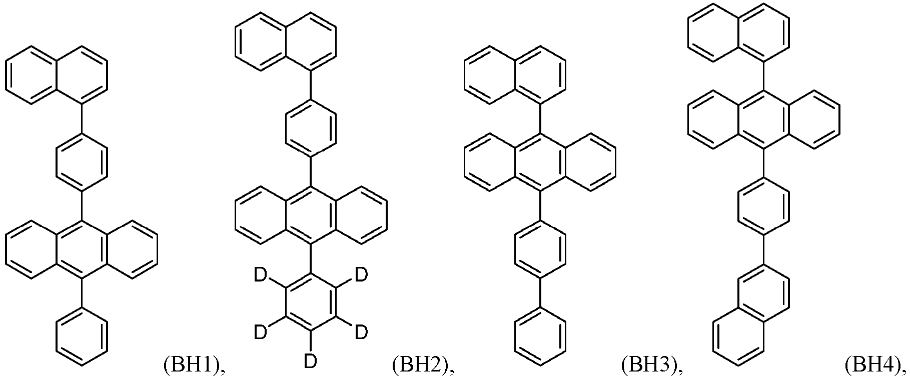

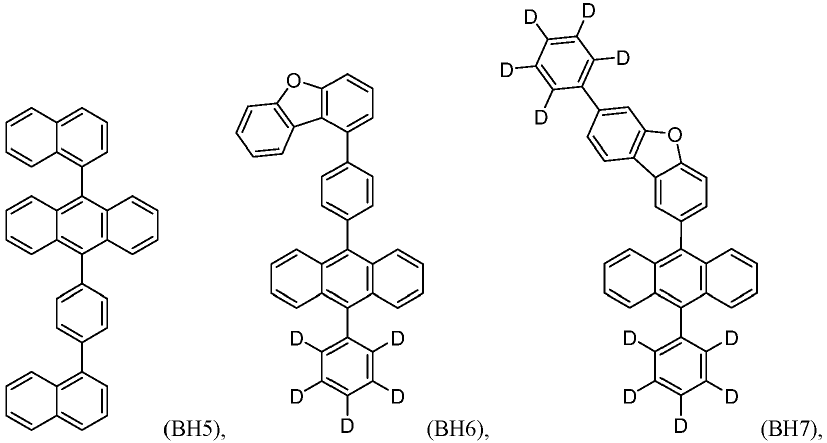

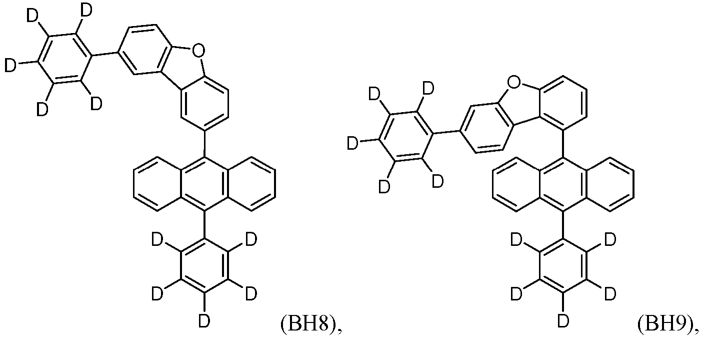

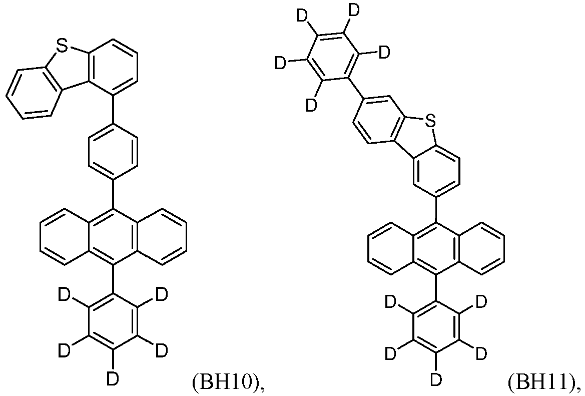

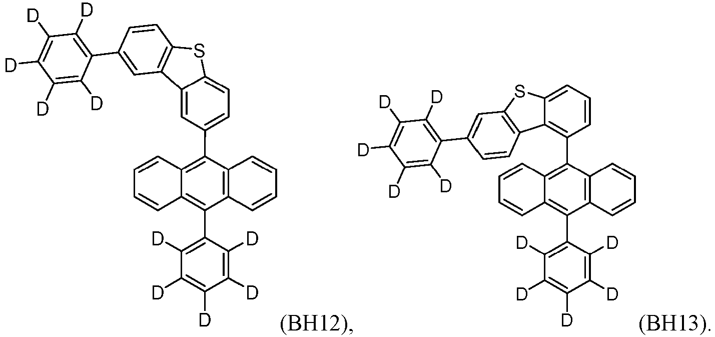

According to a preferred embodiment of the present invention, the emission layer comprises a light-emitting dopant of formula (IV) and an organic emitter host of formula (V).

According to one embodiment, the organic electronic device may further comprise a second emission layer, wherein the second emission layer is arranged between the at least one emission layer and the cathode layer.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial increase in operating voltage.

### Electron transport layer (ETL)

The organic electronic device according to the present invention may further comprise an electron transport layer (ETL), wherein the electron transport layer is arranged between the emission layer and the cathode layer.

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.5 nm to about 5 nm, for example, in the range from about 1 nm to about 3 nm. When the thickness of the EIL is within this range, the EIL may have satisfactory electron-injecting properties, without a substantial increase in operating voltage.

### Charge generation layer (CGL)

According to one embodiment of the present invention, the organic electronic device may further comprise one or more charge generation layers, wherein the one or more charge generation layers are arranged between the at least one emission layer and the cathode layer.

### Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

### Organic electronic device

According to one embodiment of the present invention, the organic electronic device is part of a display device or lighting device.

According to one embodiment of the invention, the organic electronic device is an electroluminescent device, preferably an organic light emitting diode, also named "OLED".

According to one embodiment of the invention, the organic electronic device is an organic electroluminescent device, preferably an organic light emitting diode and the light is emitted through the cathode layer.

The present invention furthermore relates to a display device comprising an organic electronic device according to the present invention.

According to one embodiment of the invention the organic electronic device is an electroluminescent device, preferably an organic light emitting diode.

The present invention furthermore relates to a display device comprising an organic electronic device according to the present invention.

According to another aspect of the present invention, there is provided a method of manufacturing an organic electronic device, the method using:
- at least one deposition source, preferably two deposition sources and more preferred at least three deposition sources.

According to various embodiments of the present invention, there is provided a method using:
- a first deposition source to release the compound of Formula (I) according to the invention, and
- a second deposition source to release the compound of Formula (II);
the method comprising the steps of forming the HIL1, the HIL2 and the HTL; whereby for an organic electronic device:
- the HIL1 is formed by releasing the compound of Formula (I) according to the invention from the first deposition source;
- the HIL2 is formed by releasing the compound of Formula (I) according to the invention from the first deposition source and the compound of Formula (II) from a second deposition source; and
- the HTL is formed by releasing the compound of Formula (I) according to the invention from the first deposition source or from a third deposition source.

According to various embodiments of the present invention, the method may further include forming on the anode layer, at least one layer selected from the group consisting of forming a hole blocking layer, and an emission layer between the anode layer and the first electron transport layer.

According to various embodiments of the present invention, the method may further include the steps for forming an organic electronic device, wherein
- on a substrate an anode layer is formed,
- on the anode layer the HIL1 comprising a compound of Formula (I) is formed,
- on the HIL1 a HIL2 is formed comprising the compound of Formula (I) and compound of Formula (II);
- on the HIL2 a hole transport layer comprising compound of Formula (I) is formed,
- on the hole transport layer an emission layer is formed,
- on the emission layer an electron transport layer is formed, optionally a hole blocking layer is formed on the emission layer,
- and finally a cathode layer is formed,
- optional a hole blocking layer is formed in that order between the first anode layer and the emission layer,
- optional an electron injection layer is formed between the electron transport layer and the cathode layer.

According to various embodiments, the organic electronic device may have the following layer structure, wherein the layers having the following order:
anode layer, HIL1, HIL2, hole transport layer, optional electron blocking layer, emission layer, optional hole blocking layer, electron transport layer, optional electron injection layer, and cathode layer.

According to another aspect of the present invention, there is provided a display device wherein the display device comprises at least one organic electronic device according to the present invention.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

### Figures 1 to 3

FIG. 1 is a schematic sectional view of an organic electronic device, according to an exemplary embodiment of the present invention;
FIG. 2 is a schematic sectional view of an organic electronic device, according to an exemplary embodiment of the present invention;
FIG. 3 is a schematic sectional view of an organic electronic device, according to an exemplary embodiment of the present invention.

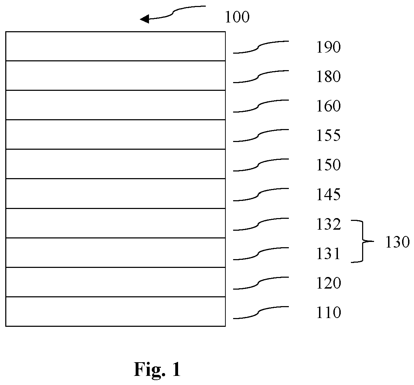

Hereinafter, the Figures 1 to 3 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device, which according to this embodiment is an organic electronic device (OLED) 100, according to an exemplary embodiment of the present invention. The OLED 100 includes a substrate (110), an anode layer (120), a hole injection layer (130) comprising a first hole injection layer (HIL1) (131) and a second hole injection layer (HIL2) (132), a hole transport layer (HTL) (140), an optional electron blocking layer (EBL) (145), an emission layer (EML) (150), an optional hole blocking layer (HBL) (155), an optional electron transport layer (ETL) (160), an optional electron injection layer (EIL) (180) and a cathode layer (190).

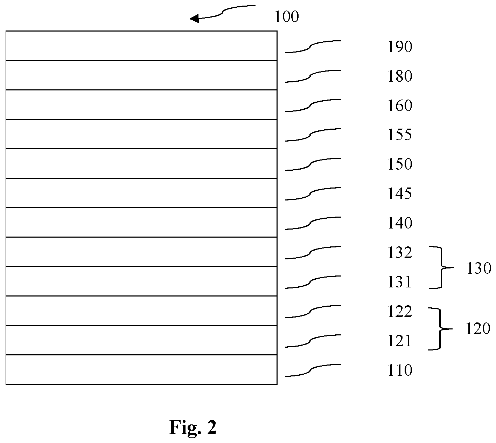

FIG. 2 is a schematic sectional view of an organic electronic device, which according to this embodiment is an organic electronic device (OLED) 100, according to an exemplary embodiment of the present invention. The OLED 100 includes a substrate (110), an anode layer (120) which comprises a first anode sub-layer (121) and a second anode sub-layer (122), a hole injection layer (130) comprising a first hole injection layer (HIL1) (131) and a second hole injection layer (HIL2) (132), a hole transport layer (HTL) (140), an optional electron blocking layer (EBL) (145), an emission layer (EML) (150), an optional hole blocking layer (HBL) (155), an optional electron transport layer (ETL) (160), an optional electron injection layer (EIL) (180) and a cathode layer (190).

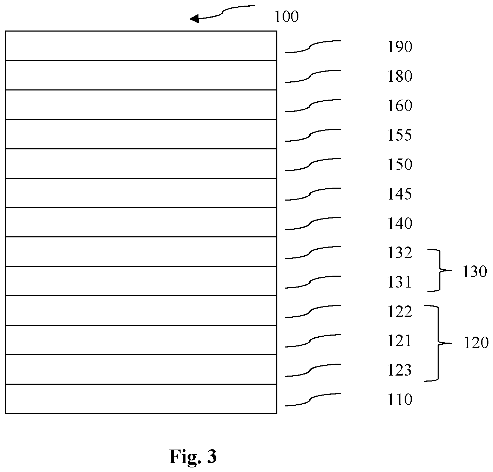

FIG. 3 is a schematic sectional view of an organic electronic device, which according to this embodiment is an organic electronic device (OLED) 100, according to an exemplary embodiment of the present invention. The OLED 100 includes a substrate (110), an anode layer (120) which comprises a first anode sub-layer (121), a second anode sub-layer (122) and a third anode sub-layer (123), a hole injection layer (130) comprising a first hole injection layer (HIL1) (131) and a second hole injection layer (HIL2) (132), a hole transport layer (HTL) (140), an optional electron blocking layer (EBL) (145), an emission layer (EML) (150), an optional hole blocking layer (HBL) (155), an optional electron transport layer (ETL) (160), an optional electron injection layer (EIL) (180) and a cathode layer (190). The layers are disposed exactly in the order as mentioned before.

In the description above the method of manufacture an organic electronic device (OLED) 100 of the present invention is started with a substrate (110) onto which an anode layer (120) is formed, on the anode layer (120), an hole injection layer (HIL) (130) comprising a first hole injection layer (HIL1) (131) and a second hole injection layer (HIL2) (132), a hole transport layer (140), optional an electron blocking layer (145), an emission layer (150), optional a hole blocking layer (155), optional an electron transport layer (160), optional an electron injection layer (180), and a cathode layer (190) are formed, exactly in that order or exactly the other way around.

While not shown in Fig. 1 to Fig. 3, a capping layer and/or a sealing layer may further be formed on the cathode layer (190), in order to seal the OLEDs 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### Experimental data

The compounds of formula (I) and compounds of formula (II) were prepared by methods known in the art.

### Calculated HOMO and LUMP energies of compounds of formula (I)

The HOMO and LUMO energies of compounds of formula (I) are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

The values in Table 1 were calculated by this method.

### Calculated HOMO and LUMP energies of compounds of formula (II)

The HOMO and LUMO energy levels of the compounds of formula (II) are calculated by applying the hybrid functional B3LYP with a ZORA-Def2-TZVP basis set and the SARC-ZORA-TZVP segmented all electron relativistically contracted basis sets for elements beyond krypton from the optimized geometries obtained by applying the functional BP86 with a ZORA-Def2-SVP basis set and the SARC-ZORA-TZVP segmented all electron relativistically basis sets for elements beyond Krypton as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). All the calculations were performed in the gas phase. All relativistic calculations were performed applying the zero order regular approximation (ZORA). If more than one conformation is viable, the conformation with the lowest total energy is selected.

The values in Table 2 were calculated by this method.

### Evaporation temperature Tₑᵥₐₚ

The evaporation temperature Tₑᵥₐₚ is the temperature at which the compound reaches a vapor pressure of 2* 10⁻³ mbar (1.5* 10⁻³ Torr).

### Decomposition temperature T_{dec}

The decomposition temperature T_{dec} is measured by loading a sample of 9 to 11 mg into a Mettler Toledo 100 µL aluminum pan without lid under nitrogen in a Mettler Toledo TGA-DSC 1 machine. The following heating program was used: 25°C isothermal for 3 min; 25°C to 600°C with 10 K/min.

The decomposition temperature was determined based on onset of exothermic peak in DSC accompanied by rapid mass loss in TGA.

### Difference in decomposition temperature and evaporation temperature Δ (T_{dec} - Tₑᵥₐₚ)

The difference Δ (T_{dec} - Tₑᵥₐₚ) is determined by subtracting the evaporation temperature Tₑᵥₐₚ from the decomposition temperature T_{dec}. The Δ (T_{dec} - Tₑᵥₐₚ) is determined in degrees Celsius (°C).

If the difference Δ (T_{dec} - Tₑᵥₐₚ) is > 15 °C, the compound of formula (II) may be evaporable without substantial decomposition. Thereby, the compound of formula (II) may be suitable for mass production of organic electronic devices via vacuum thermal evaporation of the compound of formula (II).

### General procedure for fabrication of organic electronic devices (OLEDs)

For inventive examples and comparative examples in Table 3 a glass substrate with an anode layer comprising a first anode sub-layer of 120 nm Ag, a second anode sub-layer of 8 nm ITO and a third anode sub-layer of 10 nm ITO was cut to a size of 25 mm x 25 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, the substrates were transferred to a vacuum chamber and the hole injection layer (HIL) comprising a first hole injection layer (HIL1) and second hole injection layer (HIL2) was deposited in vacuum.

The first hole injection layer (HIL1) was formed on the anode layer by depositing compound of formula (I) or comparative compound or comparative composition in vacuum. The composition and thickness of the first hole injection layer can be seen in Table 3.

Then, the second hole injection layer (HIL2) was formed on the first hole injection layer (HIL1) by co-deposition of the compound of formula (I) and the compound of formula (II) or comparative compound or comparative composition in vacuum. The composition and thickness of the second hole injection layer can be seen in Table 3.

Then, the compound of formula (I) was vacuum deposited on the HIL, to form the hole transport layer (HTL). The composition and thickness of the HTL can be seen in Table 3.

Then, N,N-di([1,1'-biphenyl]-4-yl)-3'-(9H-carbazol-9-yl)-[1,1'-biphenyl]-4-amine (CAS 1464822-27-2) was vacuum deposited on the HTL, to form an electron blocking layer (EBL) having a thickness of 5 nm.

Then the emission layer (EML) having a thickness of 20 nm was formed on the EBL by codepositing 99 vol.-% EML host compound BH9 and 1 vol.-% EML dopant BD8 in vacuum.

Then, a hole blocking layer (HBL) having a thickness of 5 nm was formed on the EML by depositing 4-([1,1'-biphenyl]-4-yl)-6-(3'-(9,9-dimethyl-9H-fluoren-4-yl)-[1,1'-biphenyl]-4-yl)-2-phenylpyrimidine (CAS 1955546-40-3).

Then, the electron transport layer (ETL) having a thickness of 31 nm was formed on the hole blocking layer by vacuum depositing 50 wt.-% 6,6'-(naphthalene-1,2-diylbis(4,1-phenylene))bis(2,4-diphenyl-1,3,5-triazine) (CAS 2244287-14-5) and 50 wt.-% of LiQ.

Then an electron injection layer (EIL) was formed on the electron transport layer by vacuum depositing a layer of 1.3 nm Yb.

Then Ag:Mg (90:10 vol.-%) was evaporated at a rate of 0.01 to 1 Å/s at 10⁻⁷ mbar to form a cathode layer with a thickness of 13 nm on the EIL.

Then, N-([1,1'-biphenyl]-4-yl)-9,9-dimethyl-N-(4-(9-phenyl-9H-carbazol-3-yl)phenyl)-9H-fluoren-2-amine was deposited on the cathode layer to form a capping layer with a thickness of 75 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 10 mA/cm² is determined by interpolating the luminance-voltage and current-voltage characteristics, respectively.

In bottom emission devices, the emission is predominately Lambertian and quantified in percent external quantum efficiency (EQE). The light is emitted through the anode layer. To determine the efficiency EQE in % the light output of the device is measured using a calibrated photodiode at 10 mA/cm2.

In top emission devices, the emission is forward directed through the cathode layer, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm².

Lifetime LT of the device is measured at ambient conditions (20°C) and 20 mA/cm², using a Keithley 2400 source meter, and recorded in hours.

The brightness of the device is measured using a calibrated photo diode. The lifetime LT is defined as the time till the brightness of the device is reduced to 97 % of its initial value.

### General method for determining the sheet resistance of the organic electronic device (OLED)

The sheet resistance of the OLED, also named "OLED-Rs", is determined in giga Ohm per square (GΩ/sq).

The sheet resistance Rs may be determined via the transfer length method. The measurement may be conducted by methods known in the art or as described in WO2022263524A1.

For the examples according to the invention and comparative examples in Table 3, the OLED-Rs is determined as follows:
In a first step, the complete OLED layer arrangement as described in the examples and comparative examples in Table 3 is deposited.

In a second step, the sheet resistance Rs is determined for each device by using the transfer length method, while the cathode is not connected.

The higher the sheet resistance, the lower is the current flow between adjacent pixels. Thereby, individual pixels in an electronic device can be addressed without adjacent pixels lighting up. Thereby, the so-called pixel crosstalk may be reduced.

### Technical Effect of the invention

In Table 1 are shown the HOMO energies and Δ (T_{dec} - Tₑᵥₐₚ) of compounds of formula (I) and comparative compound NPD.

**Table 1: Properties of compounds of formula (I) and comparative compound**

| Referred to as: | Structure | HOMO (eV) | Δ (T_{dec} - Tₑᵥₐₚ) [°C] |
|---|---|---|---|
| K1 | 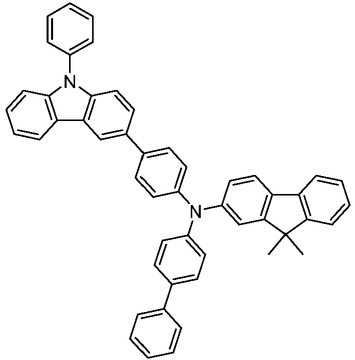 | -4.88 | > 15 |
| K2 | 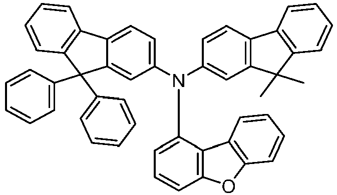 | -5.03 | > 15 |
| K7 | 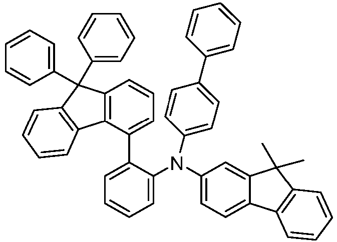 | -5.04 | > 15 |
| K16 | 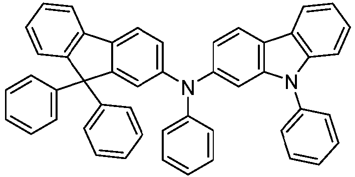 | -4.96 | > 15 |
| K18 | 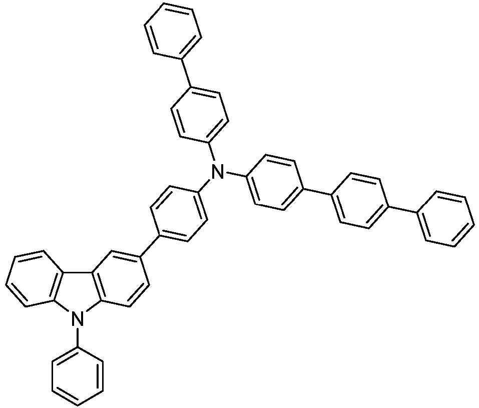 | -4.95 | > 15 |
| K19 | 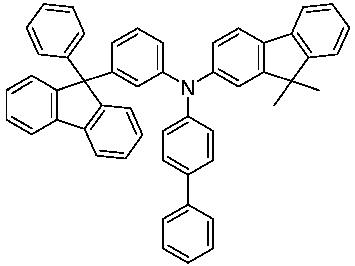 | -4.99 | > 15 |
| K20 | 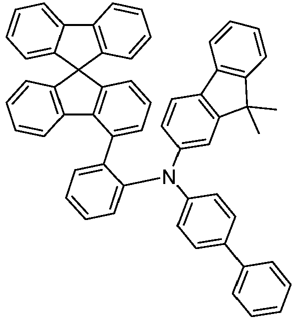 | -4.84 | > 15 |
| NPD (comparative) | 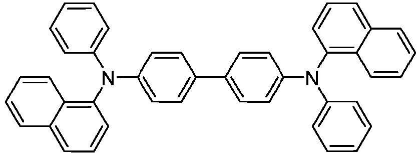 | -4.72 | > 15 |

As can be seen in Table 1 above, the HOMO energies of compounds of formula (I) are in a range which may be suitable for the hole injection layer in organic electronic devices. Additionally, the Δ (T_{dec} - Tₑᵥₐₚ) is > 15 °C. The compounds of formula (I) may be evaporated without substantial decomposition.

In compound NPD, the HOMO is -4.72 eV. The Δ (T_{dec} - Tₑᵥₐₚ) is > 15 °C.

In Table 2 are shown the calculated LUMO energies and Δ (T_{dec} - Tₑᵥₐₚ) of compounds of formula (II) and comparative metal compounds.

**Table 2: Calculated LUMO energies and Δ (T_{dec} - Tₑᵥₐₚ) for compounds of formula (II) and comparative metal compounds**

| Metal compound | Chemical Formula | LUMO [eV] | Δ (T_{dec} - Tₑᵥₐₚ) [°C] |
|---|---|---|---|
| Comparative compound 1 (CC-1) | 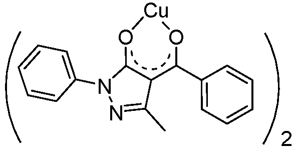 | -2.91 | < 15 |
| (M1) | 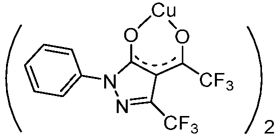 | -3.97 | > 15 |
| (M2) | 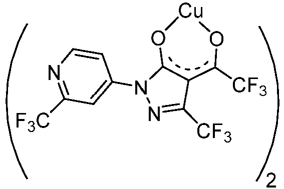 | -5.28 | n.d. ¹⁾ |
| (M3) | 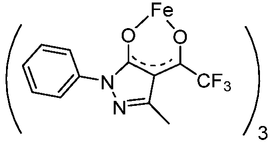 | -4.07 | n.d. |
| (M4) | 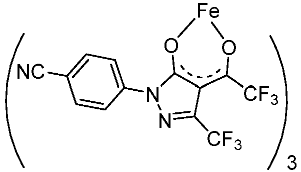 | -5.54 | n.d. |
| (M5) | 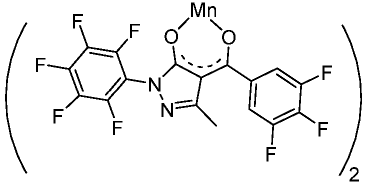 | -2.93 | > 15 |
| (M6) | 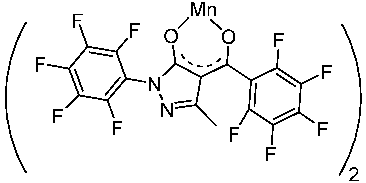 | -2.92 | n.d. |
| (M7) | 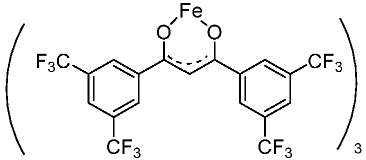 | -4.19 | > 15 |
| (M8) | 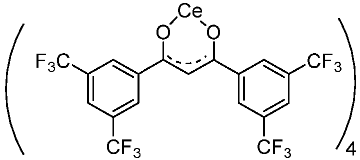 | -4.54 | n.d. |
| (M9) | 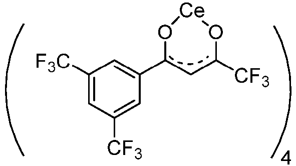 | -4.67 | > 15 |
| (M10) | 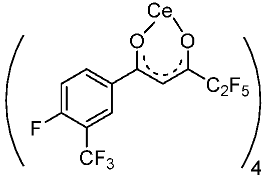 | -4.46 | n.d. |
| (M11) | 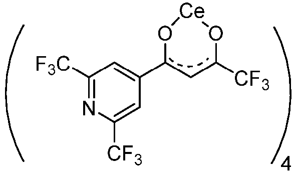 | -5.12 | n.d. |
| (M12) | 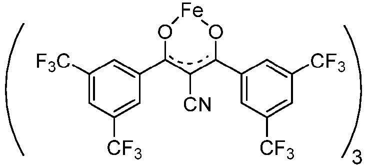 | -4.94 | > 15 |
| (M13) | 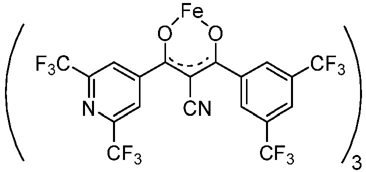 | -5.29 | n.d. |
| (M14) | 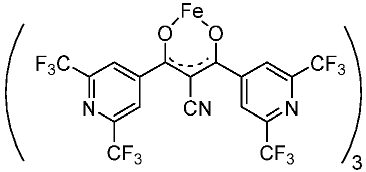 | -5.69 | n.d. |
| (M15) | 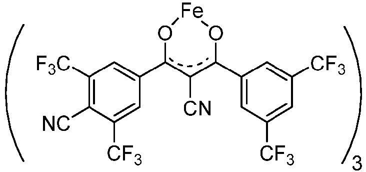 | -5.34 | n.d. |
| (M16) | 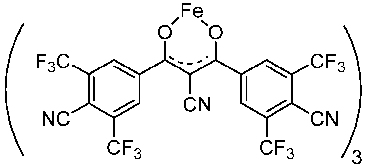 | -5.69 | n.d. |
| (M17) | 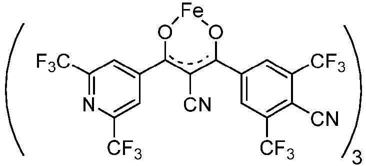 | -5.70 | n.d. |
| (M18) | 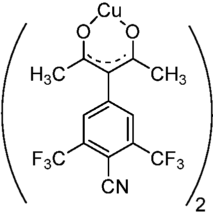 | -3.13 | n.d. |
| (M19) | 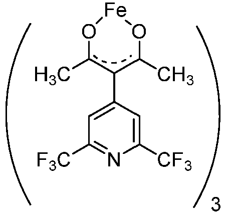 | -3.80 | n.d. |
| (M20) | 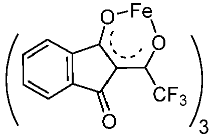 | -4.44 | n.d. |
| (M21) | 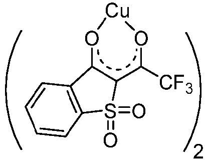 | -3.93 | n.d. |
| (M22) | 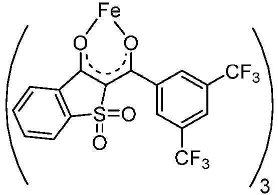 | -4.47 | n.d. |
| (M23) | 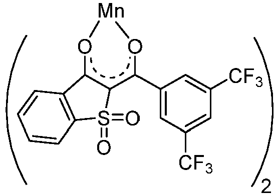 | -3.58 | n.d. |
| (M24) | 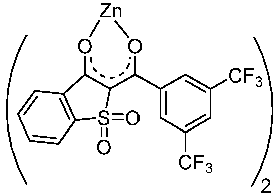 | -3.38 | > 15 |

| | | | |
|---|---|---|---|
| ¹⁾ "n.d." = not determined | | | |

In comparative compound 1 (CC-1), the LUMO is -2.91 eV. The Δ (T_{dec} - Tₑᵥₐₚ) is < 15 °C. The compound is free of fluorine atoms. The LUMO is in a range which may not be suitable for efficient hole injection in the organic electronic device. Additionally, the compound may not be suitable for mass production of organic electronic devices via vacuum thermal evaporation, as the decomposition temperature may be too close to the evaporation temperature. Substantial decomposition may occur when the compound is evaporated at the rate required for mass production of organic electronic devices.

Compound of formula (II) (M1) comprises 6 fluorine atoms. The LUMO is -3.97 eV. The LUMO is in the range which is suitable for efficient hole injection in the organic electronic device. The Δ (T_{dec} - Tₑᵥₐₚ) is > 15 °C. The compound can be evaporated without substantial decomposition.

Compounds of formula (II) (M2) to (M24) have LUMO energies in the range which may be suitable for efficient hole injection in the organic electronic device. The Δ (T_{dec} - Tₑᵥₐₚ) is > 15 °C. The compounds can be evaporated without substantial decomposition.

In Table 3, the setup and shown performance data of organic electronic devices according to the present invention and comparative examples is shown.

Comparative example 1 comprises a first hole injection layer (HIL1) comprising 96 vol.-% comparative matrix compound NPD, see Table 1, and 4 vol.-% compound of formula (II) (M12), see Table 3.

The thickness of the first hole injection layer is 10 nm. Comparative example 1 is free of a second hole injection layer (HIL2). The hole transport layer consists of NPD. The operating voltage is 3.29 V. The cd/A efficiency (Ceff) is 9.4 cd/A and the external quantum efficiency (EQE) is 19.7 %. The sheet resistance Rₛ of the first hole injection layer is 174 GΩ/sq.

Comparative example 2 comprises a first hole injection layer consisting of comparative matrix compound NPD. The thickness of the first hole injection layer is 1 nm. The second hole injection layer (HIL2) comprises 96 vol.-% comparative matrix compound NPD and 4 vol.-% compound of formula (II) (M12), see Table 3. The hole transport layer consists of NPD. The operating voltage is 3.29 V. The cd/A efficiency (Ceff) is 9.3 cd/A and the external quantum efficiency (EQE) is 19.7 %. The sheet resistance Rₛ of the second hole injection layer is 192 GS2/sq.

In summary, no substantial improvement in performance of organic electronic devices is obtained, when the organic electronic device comprises a first hole injection layer consisting of comparative matrix compound NPD.

Inventive example 1 comprises a first hole injection layer consisting of compound of formula (I) K16 and a second hole injection layer comprising 96 vol.-% compound of formula (I) K16 and 4 vol.-% compound of formula (II) (M12). The hole transport layer consists of K16. To achieve the same CIE-y as in comparative examples 1 and 2, the thickness is 128 nm. Inventive example 1 differs from comparative example 2 in the matrix compound. The operating voltage is 3.32 V. The Ceff is improved to 10.6 cd/A and the EQE is improved to 22.5 %. The sheet resistance Rₛ of the second hole injection layer is improved to 323 GΩ/sq.

In inventive example 2, the second hole injection layer comprises 96 vol.-% compound of formula (I) K16 and 4 vol.-% compound of formula (II) (M24). The operating voltage is 3.33 V. The Ceff is 10.5 cd/A and the EQE is 22.6 %. The sheet resistance Rₛ of the second hole injection layer is further improved to 388 GΩ/sq.

In inventive example 3, the second hole injection layer comprises 96 vol.-% compound of formula (I) K16 and 4 vol.-% compound of formula (II) (M5). The operating voltage is 3.34 V. The Ceff is 10.5 cd/A and the EQE is 22.5 %. The sheet resistance Rₛ of the second hole injection layer is further improved to 6241 GΩ/sq.

In inventive example 4, the second hole injection layer comprises 96 vol.-% compound of formula (I) K16 and 4 vol.-% compound of formula (II) (M5). The operating voltage is 3.36 V. The Ceff is 10.5 cd/A and the EQE is 22.6 %. The sheet resistance Rₛ of the second hole injection layer is improved to 6081 GΩ/sq.

In inventive example 4, the second hole injection layer comprises 96 vol.-% compound of formula (I) K16 and 4 vol.-% compound of formula (II) (M9). The operating voltage is 3.36 V. The Ceff is improved to 10.7 cd/A and the EQE is 22.7 %. The sheet resistance Rₛ of the second hole injection layer is improved to 7413 GΩ/sq.

In summary, an improvement in operating voltage, cd/A efficiency, external quantum efficiency, and/or sheet resistance has been obtained.

Low operating voltage and/or high efficiency may be important for reduced power consumption, in particular in mobile devices.

Improved sheet resistance of the hole injection layer may result in improved pixel crosstalk. Thereby, the colour purity in a display device may be improved.

**Table 3: Setup and performance data for inventive organic electronic devices and comparative examples**

| | Compositio n HIL1 | Thicknes s HIL1 [nm] | Compositio n HIL2 | Thicknes s HIL2 [nm] | Compositio n HTL | CIE-y | Thicknes s HTL [nm] | Voltage at 10mA/cm ² [V] | Ceff at 10mA/cm ² [cd/A] | EQE at 10mA/cm 2 [%] | OLED-Rs [GΩ/sq ] |
|---|---|---|---|---|---|---|---|---|---|---|---|
| Comparativ e example 1 | NPD (96 vol.%): (M12) (4 vol.-%) | 10 | - | 0 | NPD | 0.04 5 | 125 | 3.29 | 9.4 | 19.7 | 174 |
| Comparativ e example 2 | NPD | 1 | NPD (96 vol.%): (M12) (4 vol.-%) | 10 | NPD | 0.04 5 | 125 | 3.29 | 9.3 | 19.7 | 192 |
| Inventive example 1 | K16 | 1 | K16 (96 vol.%): (M12) (4 vol.-%) | 10 | K16 | 0.04 4 | 128 | 3.32 | 10.6 | 22.5 | 323 |
| Inventive example 2 | K16 | 1 | K16 (96 vol.-%): (M24) (4 vol.-%) | 10 | K16 | 0.04 4 | 128 | 3.33 | 10.5 | 22.6 | 388 |
| Inventive example 3 | K16 | 1 | K16 (96 vol.-%): (M5) (4 vol.-%) | 10 | K16 | 0.04 4 | 128 | 3.34 | 10.5 | 22.5 | 6241 |
| Inventive example 4 | K16 | 1 | K16 (96 vol.-%): (M1) (4 vol.-%) | 10 | K16 | 0.04 5 | 128 | 3.36 | 10.5 | 22.6 | 6081 |
| Inventive example 5 | K16 | 1 | K16 (96 vol.-%): (M9) (4 vol.-%) | 10 | K16 | 0.04 5 | 128 | 3.36 | 10.7 | 22.7 | 7413 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic electronic device comprising an anode layer, a cathode layer, at least one emission layer, a first hole injection layer (HII,1) and a second hole injection layer (HIL2), and a hole transport layer (HTL),
wherein
- The first hole injection layer (HIL1) is in direct contact with the anode layer and the second hole injection layer (HIL2);
- The hole transport layer (HTL) is arranged between the second hole injection layer (HIL2) and the at least one emission layer;
- The emission layer is arranged between the hole transport layer and the cathode layer;
wherein the first hole injection layer (HII,1) comprises a compound of formula (I) 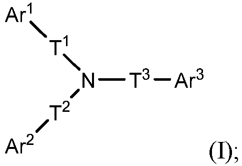
whereby
T¹, T², T³ are independently selected from a single bond, phenylene, biphenylene, terphenylene or naphthenylene, preferably a single bond or phenylene;
Ar¹, Ar², Ar³ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle; wherein
the substituents of Ar¹, Ar², Ar³ are selected the same or different from the group comprising H, D, F, CN, Si(R')₃, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R' may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
the second hole injection layer (HIL2) comprises a compound of formula (I) and a compound of formula (II)
M^{n⊕}(L^{⊖})ₙ (AL)ₘ (II),
wherein
M is a metal ion,
n is the valency of M and selected from 1 to 4;
L is a mono-anionic ligand comprising between 7 and 40 carbon atoms, wherein L comprises at least one six membered aromatic or heteroaromatic ring, which may be part of a ring system; wherein L comprises at least two fluorine atoms, preferably at least 3 fluorine atoms;
AL is an ancillary ligand which coordinates to the metal ion M;
m is an integer selected from 0 to 2;
whereby both the first hole injection layer (HIL1) and the hole transport layer (HTL) are free of a compound of formula (II).

2. The organic electronic device according to claim 1, wherein the compound of formula (I) in the first hole injection layer (HIL1) and the second hole injection layer (HIL2) is selected the same.

3. The organic electronic device according to claim 1 or 2, wherein the compound of formula (I) in second hole injection layer (HIL2) and the hole transport layer (HTL) is selected the same.

4. The organic electronic device according to any one of claims 1 to 3, wherein all three layers HIL1, HIL2 and HTL comprise an identical compound of formula (I).

5. The organic electronic device according to any of the claims 1 to 4, whereby the hole transport layer (HTL) is in direct contact with the second hole injection layer (HIL2).

6. The organic electronic device according to any one of claims 1 to 5, wherein the compound of formula (I) has a molecular weight Mw of ≥ 600 and ≤ 1500 g/mol, preferably a molecular weight Mw of ≥ 600 and ≤ 1200 g/mol, more preferred a molecular weight Mw of ≥ 600 and ≤ 1000 g/mol.

7. The organic electronic device according to any of the claims 1 to 6, whereby in the compound of formula (I), one or two of T¹, T² and T³ may be independently selected from phenylene and one of T¹, T² and T³ is a single bond.

8. The organic electronic device according to any one of claims 1 to 7, whereby in the compound of formula (I) Ar¹, Ar², and Ar³ are independently selected from E1 to E17: 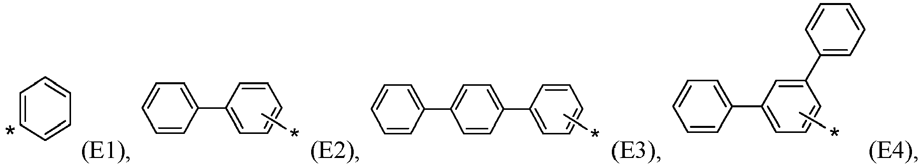 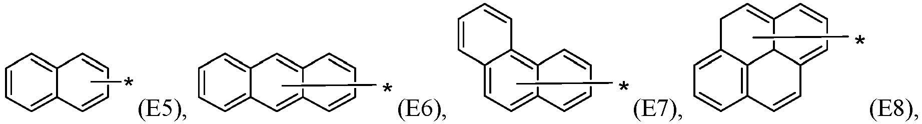 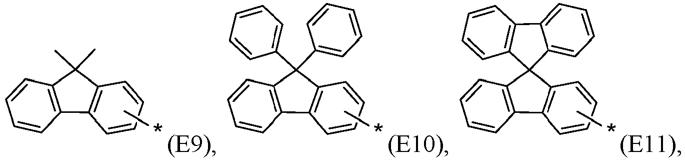 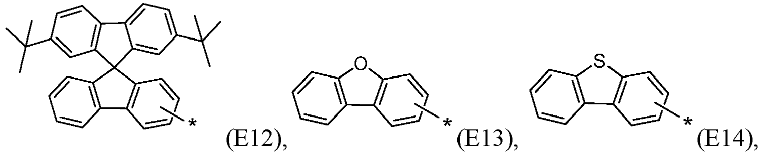 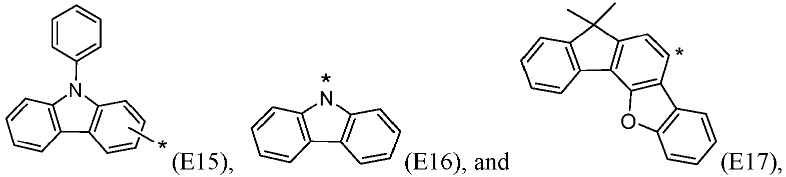 wherein the "*" or "-" denotes the binding position.

9. The organic electronic device according to any one of claims 1 to 8, wherein the compound of formula (II) has a molecular weight Mw of ≥ 400 and ≤ 2500 g/mol, preferably a molecular weight Mw of ≥ 500 and ≤ 2000 g/mol, more preferred a molecular weight Mw of ≥ 500 and ≤ 2000 g/mol.

10. The organic electronic device according to any one of claims 1 to 9, wherein M of the compound of Formula (II) is selected from a metal ion wherein the corresponding metal has an electronegativity value according to Pauling of ≥ 0.79 and ≤ 2.05.

11. The organic electronic device according to any one of claims 1 to 10, whereby M is a metal ion selected from Li(I), K(I), Rb(I), Cs(I), Ag(I), Cu(II), Zn(II), Pd(II), Ir(III), Al(III), Ga(III), Mn(II), Mn(III), Ru(III), In(III), Fe(II), Fe(III) and Ce(IV).

12. The organic electronic device according to any one of claims 1 to 11, wherein the ligand L of the compound of formula (II) is selected from the following formulae (IIIa) to (IIIe): 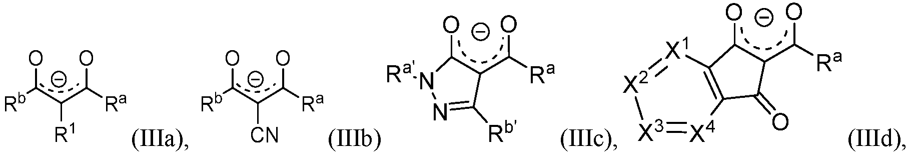 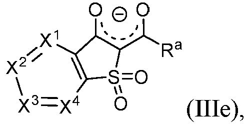 wherein
R^{a} and R^{b} are independently selected from H, D, electron-withdrawing group, halogen, F, CN, substituted or unsubstituted C₁ to C₁₂ alkyl, partially fluorinated C₁ to C₁₂ alkyl, perfluorinated C₁ to C₁₂ alkyl, CF₃, CF₂H, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having 0 to 20 carbon atoms;
wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group, sulfinyl group, sulfonyl group, phosphine group, partially fluorinated C₁ to C₁₂ alkyl, perfluorinated C₁ to C₁₂ alkyl, CF₃, CF₂H, partially fluorinated C₁ to C₆ alkoxy, perfluorinated C₁ to C₆ alkoxy, OCF₃;
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially fluorinated C₁ to C₁₂ alkyl, perfluorinated C₁ to C₁₂ alkyl,
wherein the one or more substituents on R⁵ is selected from electron-withdrawing group, halogen, F, CN, NO₂, SF₅, isonitrile, ester group, carboxylic group, carbonyl group, acyl group, thio group, sulfinyl group, sulfonyl group, phosphine group, partially fluorinated C₁ to C₁₂ alkyl, perfluorinated C₁ to C₁₂ alkyl, CF₃, CF₂CF₃, CF₂H, partially fluorinated C₁ to C₆ alkoxy, perfluorinated C₁ to C₆ alkoxy, OCF₃, OCF₂CCF₃;
R¹ is selected from H, D, CN, substituted or unsubstituted C₁ to C₈ alkyl, partially fluorinated C₁ to C₁₂ alkyl, perfluorinated C₁ to C₁₂ alkyl, CF₃, CHF₂, substituted or unsubstituted C₆ to C₄₀ aryl, substituted or unsubstituted C₂ to C₃₀ heteroaryl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, partially fluorinated C₁ to C₆ alkoxy, perfluorinated C₁ to C₆ alkoxy, OCF₃, =N, =N-;
R^{a}' is independently selected from substituted or unsubstituted C₁ to C₁₂ alkyl, substituted or unsubstituted C₆ to C₁₉ aryl, substituted or unsubstituted C₂ to C₂₀ heteroaryl, or substituted or unsubstituted 6-membered heteroaryl;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, F, CN, partially or perfluorinated C₁ to C₈ alkyl, CF₃, CF₂CF₃, CF₂H, partially or perfluorinated C₁ to C₈ alkoxy;
R^{b}' is selected from substituted or unsubstituted C₁ to C₁₂ alkyl, CH₃, CF₃, CF₂H, substituted or unsubstituted C₆ to C₁₉ aryl, substituted or unsubstituted C₂ to C₂₀ heteroaryl, substituted or unsubstituted 6-membered heteroaryl, or CN;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, F, CN, partially or perfluorinated C₁ to C₈ alkyl, CF₃, CF₂CF₃, CF₂H, partially or perfluorinated C₁ to C₈ alkoxy;
X¹ is selected from C-R¹' or N;
X² is selected from C-R²' or N;
X³ is selected from C-R³' or N;
X⁴ is selected from C-R⁴' or N;
wherein
0, 1 or 2 of the group consisting of X¹, X², X³, and X⁴ are selected from N;
R¹' to R⁴' are independently selected from H, D, substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, halogen, F or CN; and whereby optional any R^{k}' to R^{(k,1)}', wherein k is selected 1, 2 or 3, form a ring, preferably a 5- or 6- membered ring;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, F, CN, partially or perfluorinated C₁ to C₈ alkyl, CF₃, CF₂CF₃, CF₂H, partially or perfluorinated C₁ to C₈ alkoxy;
wherein L comprises at least one six membered aromatic or heteroaromatic ring, which may be part of a ring system and wherein L comprises at least two fluorine atoms, preferably at least 3 fluorine atoms.

13. The organic electronic device according to Claim 12, wherein at least one of R^{a}, R^{b}, R^{a}' or R^{b}' is independently selected from the group consisting of formulae D1 to D111: 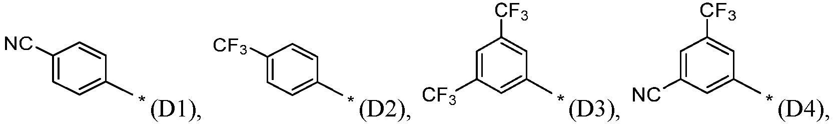 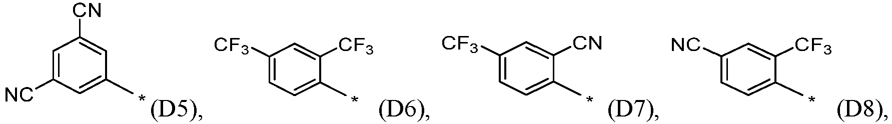 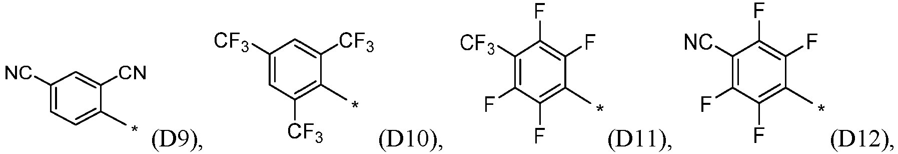 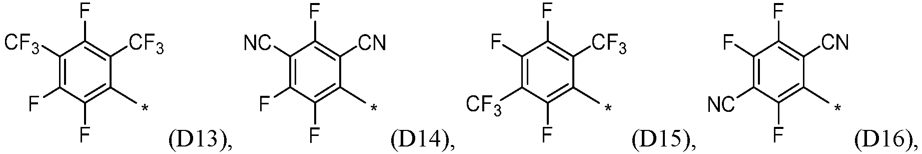 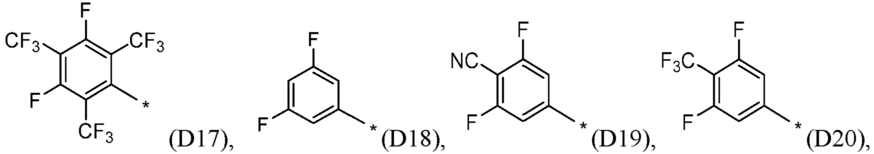 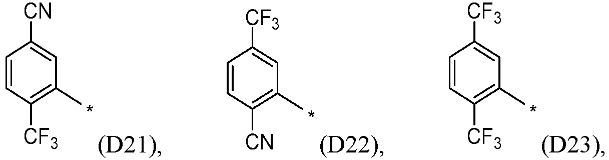 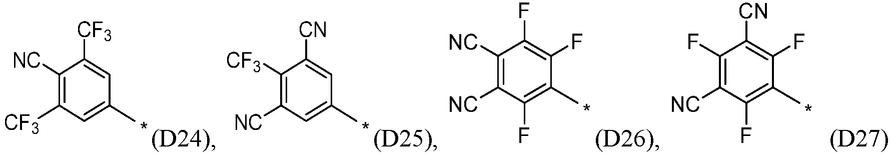 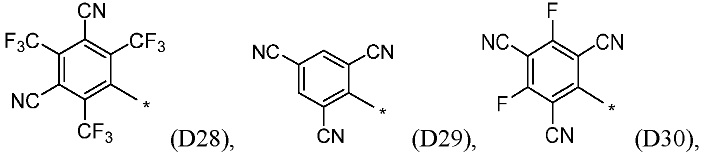 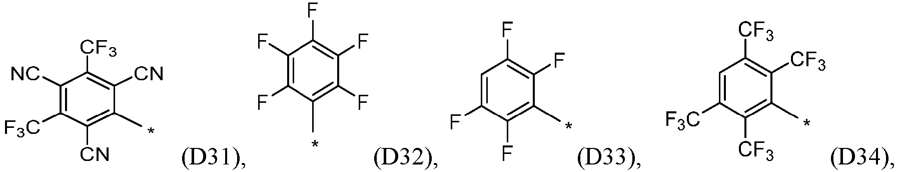 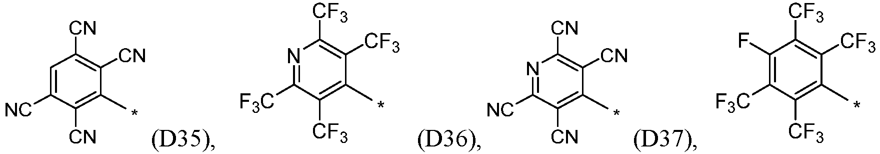 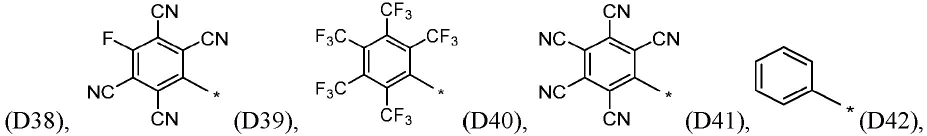 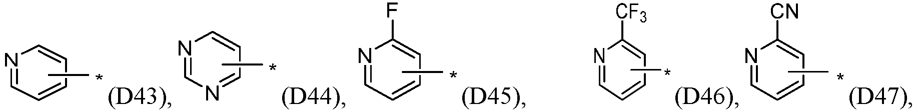 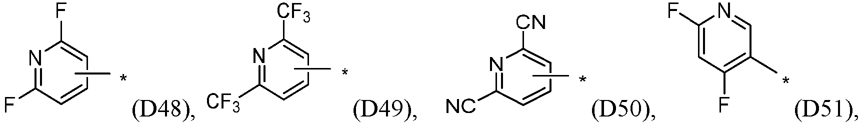 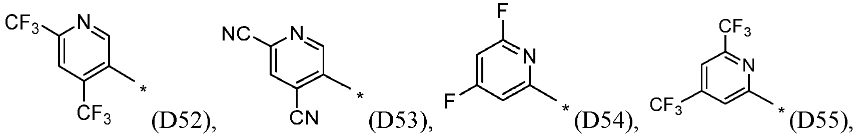 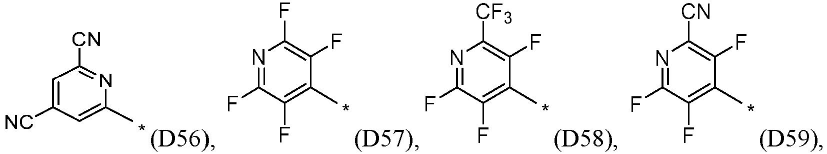 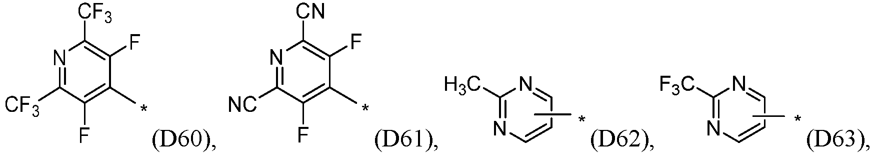 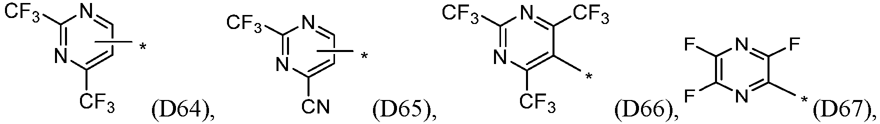 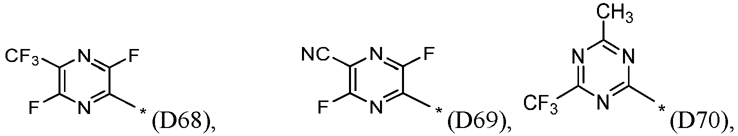 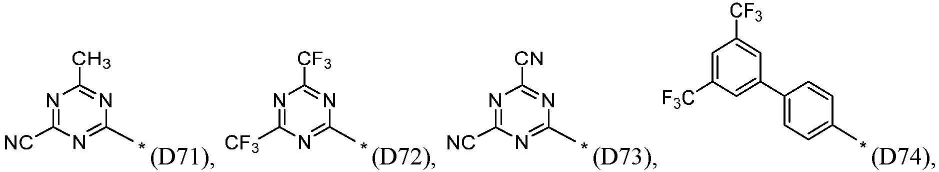 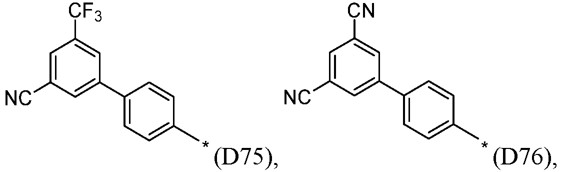 -CF₃ (D77), -C₂F₅ (D78), -C₃F₇ (D79), -CF₂CF₂CF₃ (D80), 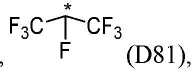 -C₄F₉ (D82), -CF₂CF₂CF₂CF₃ (D83), 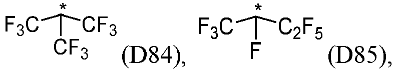 -C₅F₁₁ (D86), -C₆F₁₃ (D87), -CH₃ (D88), -C₂H₅ (D89) -CH(CH₃)₂ (D90), -C(CH₃)₃ (91), 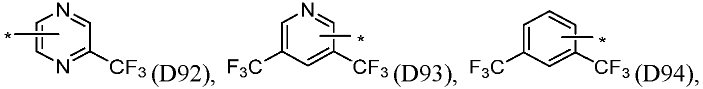 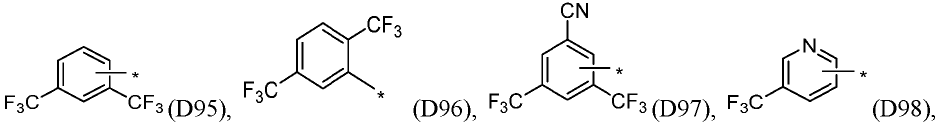 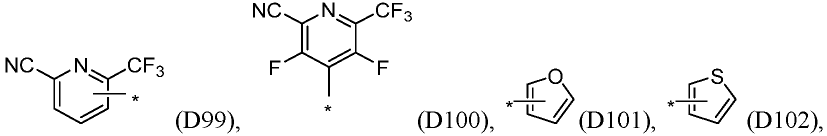 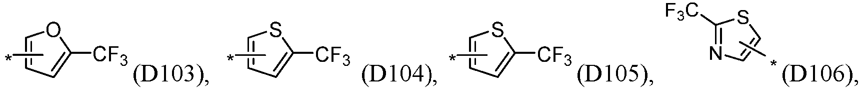 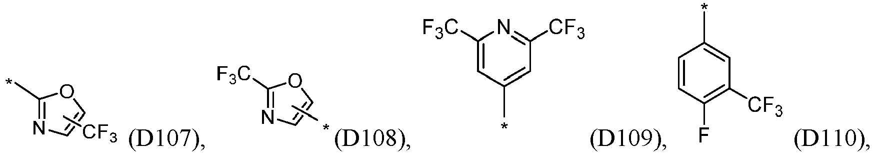 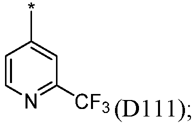 wherein the "*" or "-" denotes the binding position.

14. The organic electronic device according to any of the claims 1 to 13, wherein the ligand L of the compound of formula (II) is selected from the group consisting of formulae L1 to L455:

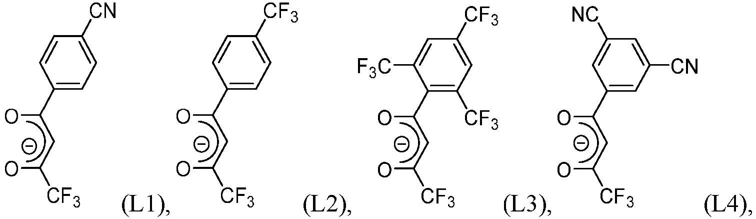

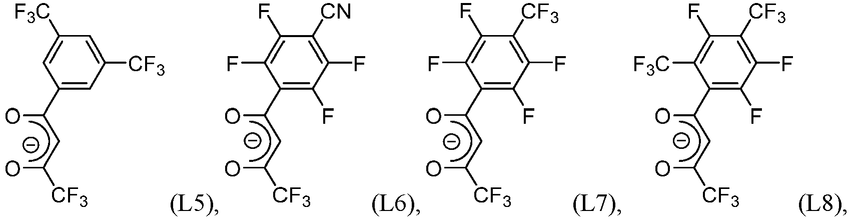

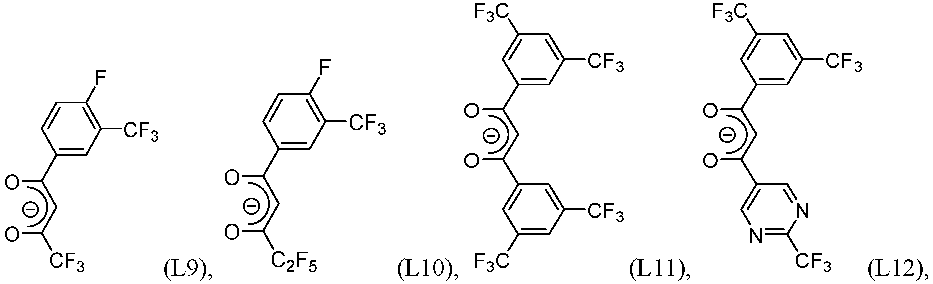

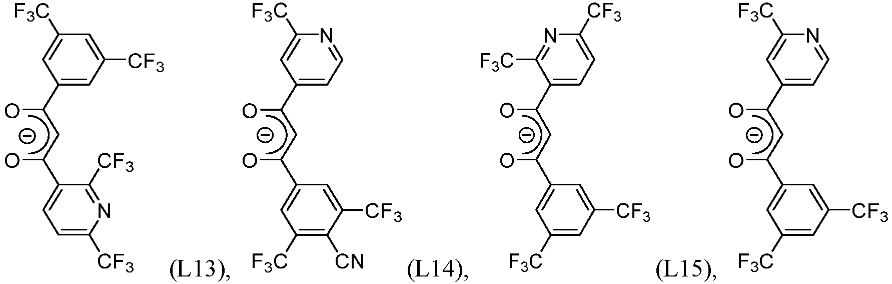

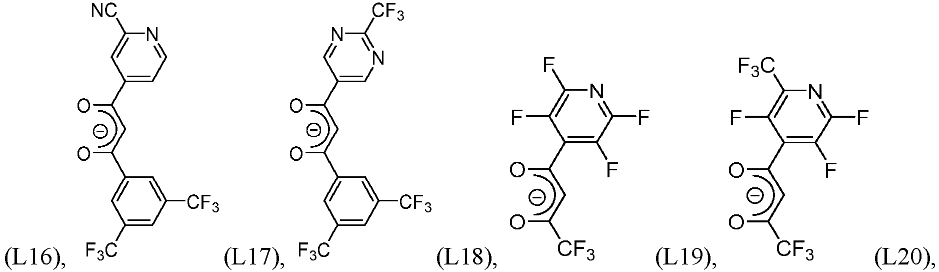

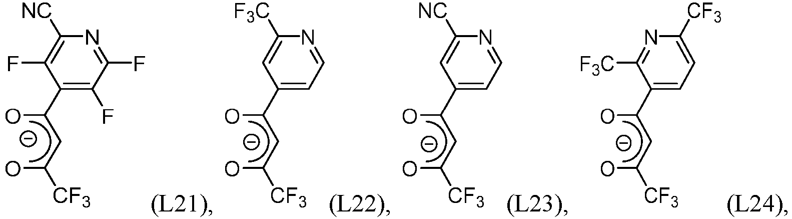

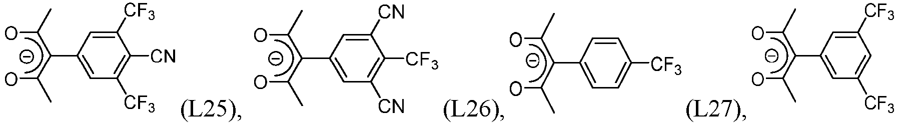

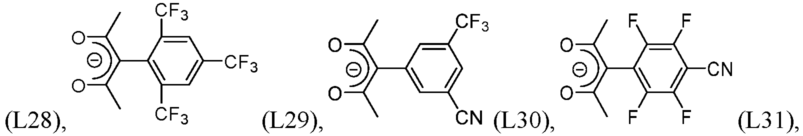

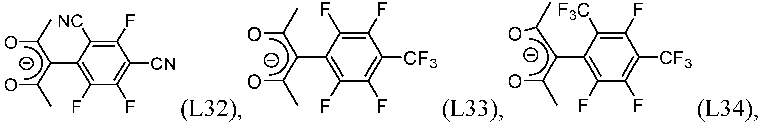

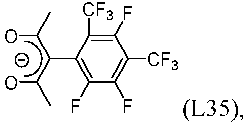

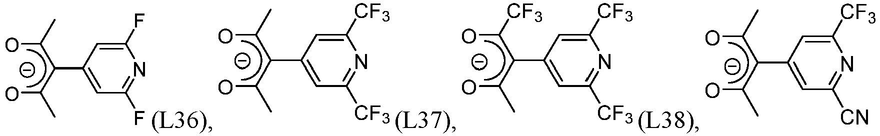

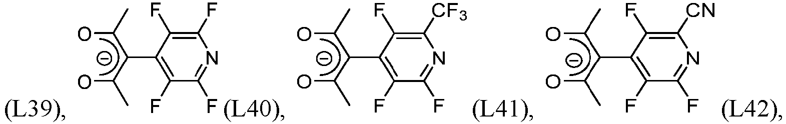

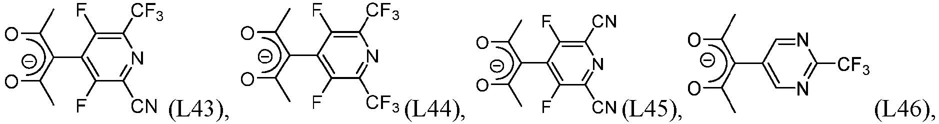

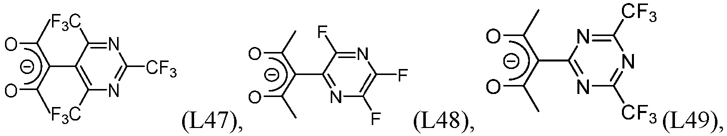

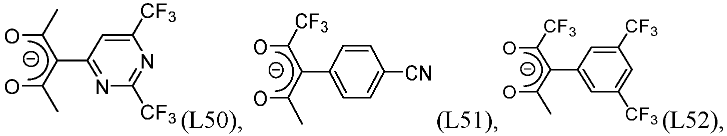

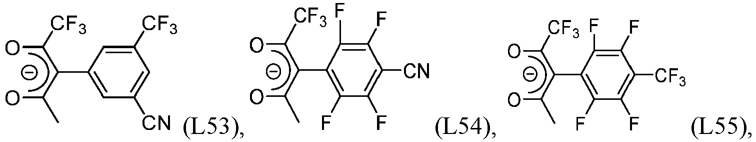

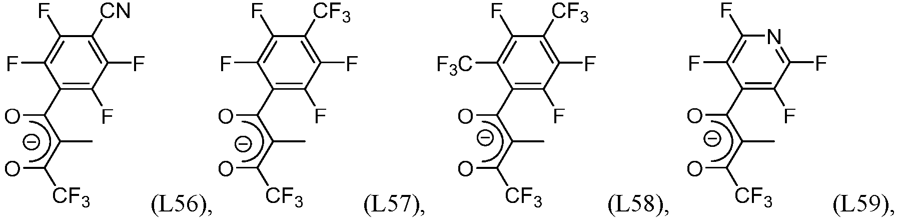

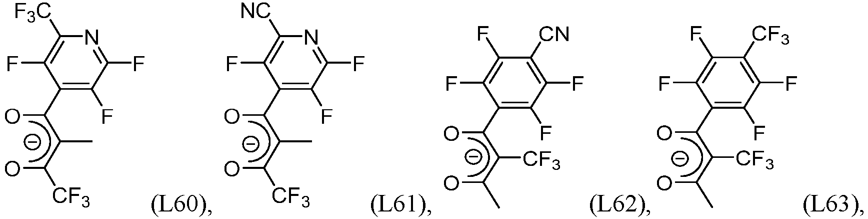

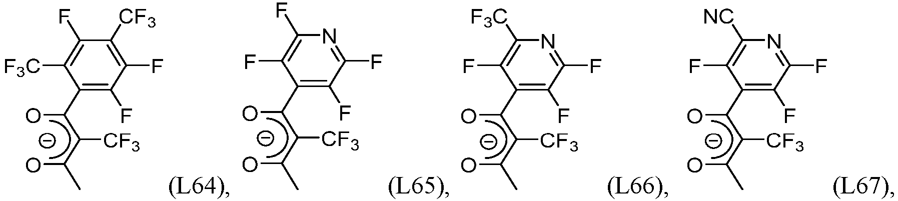

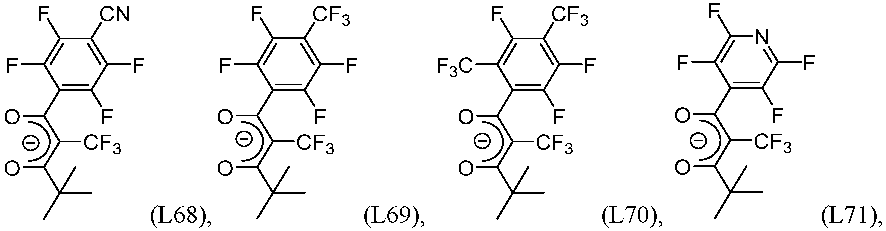

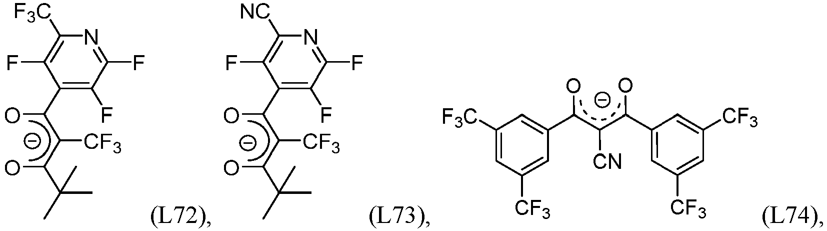

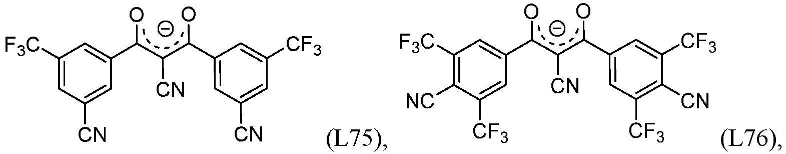

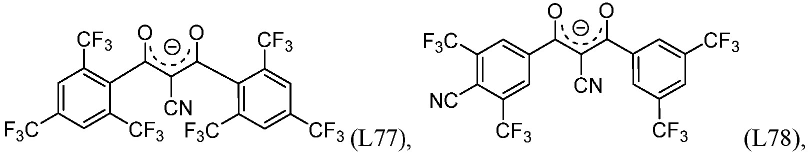

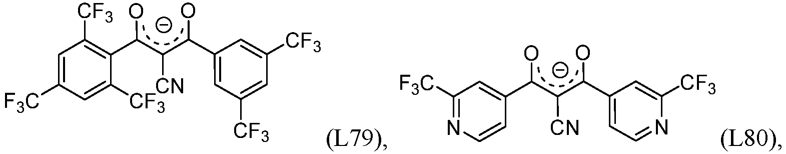

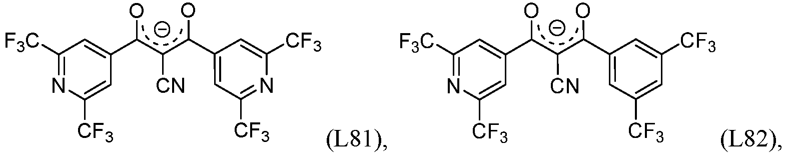

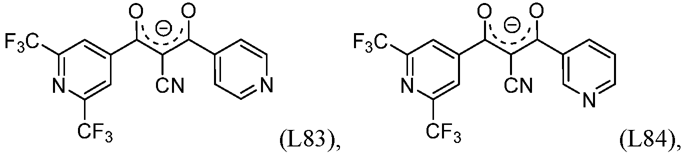

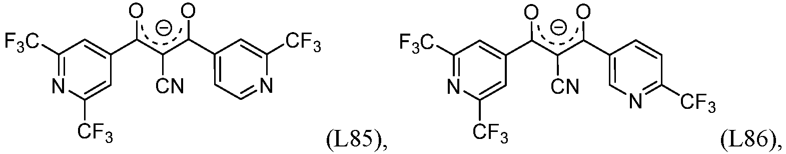

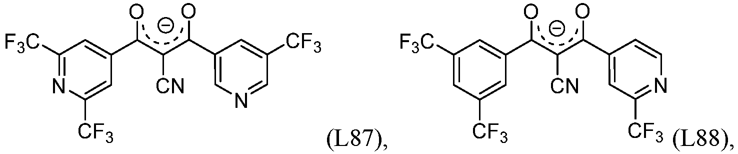

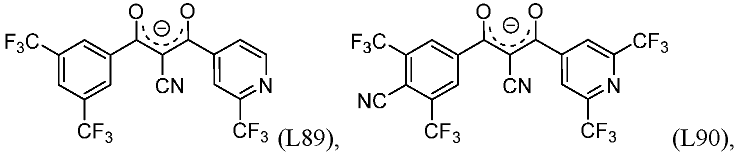

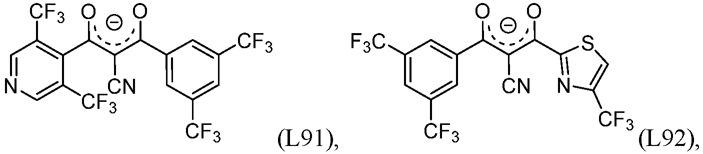

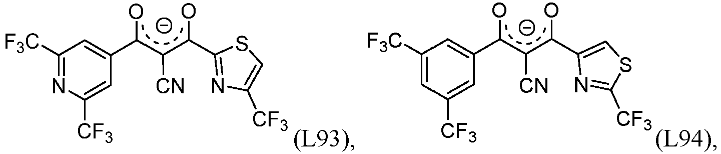

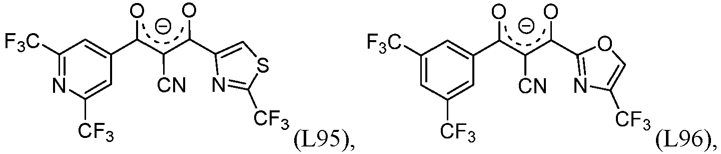

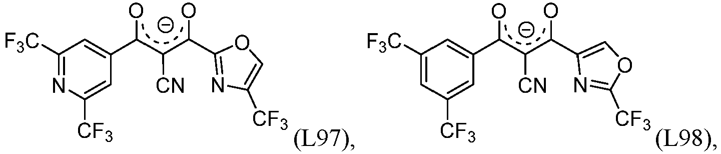

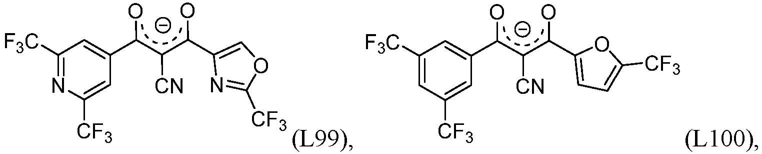

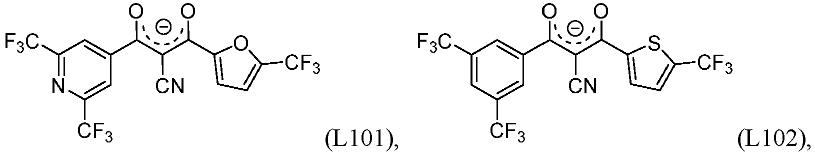

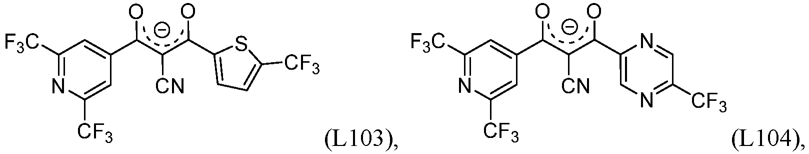

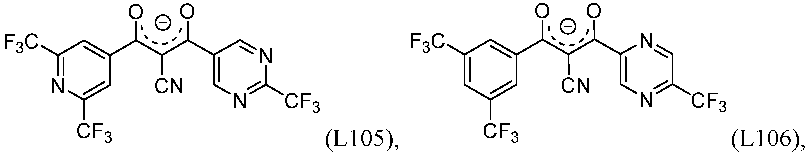

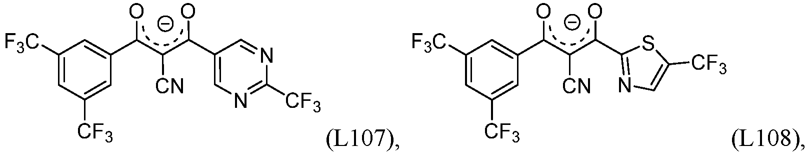

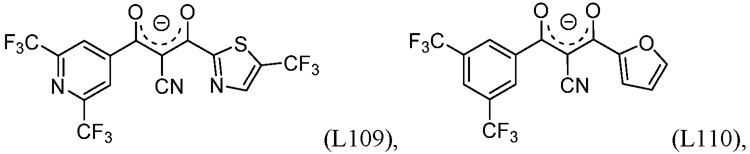

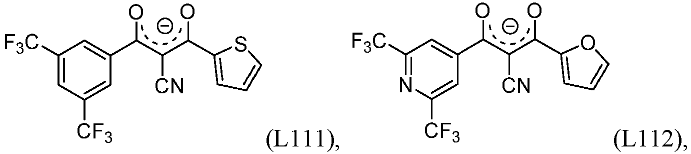

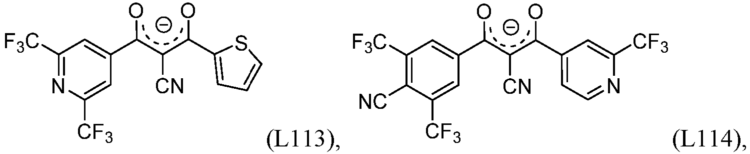

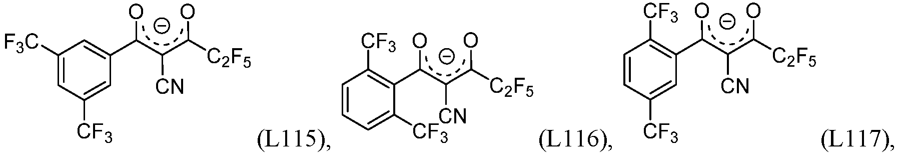

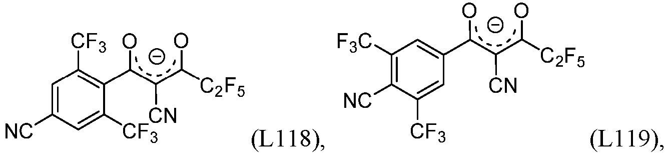

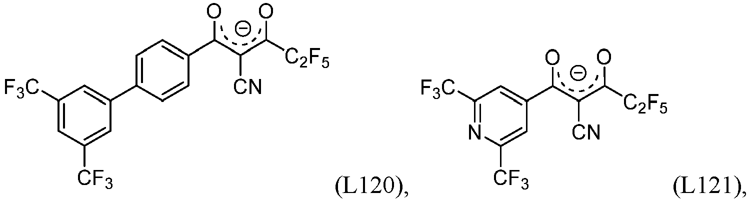

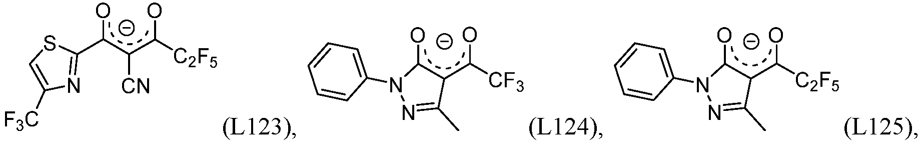

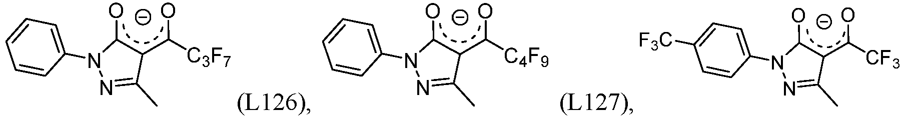

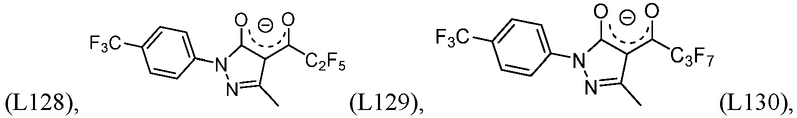

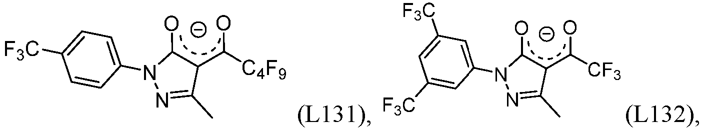

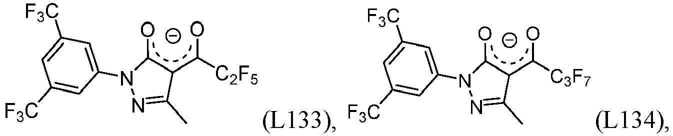

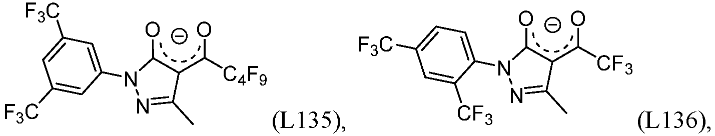

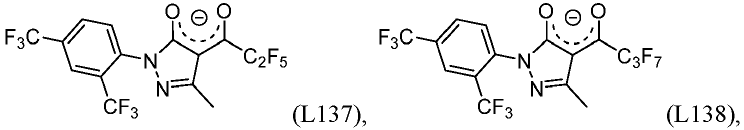

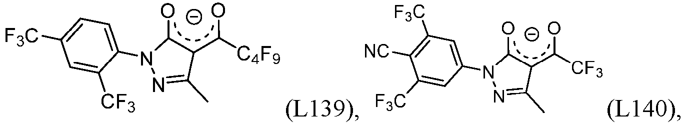

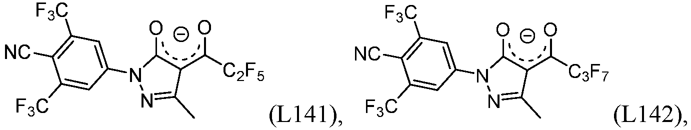

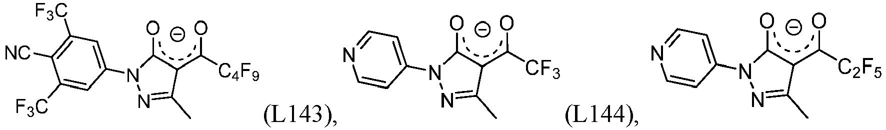

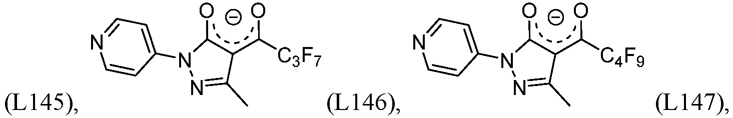

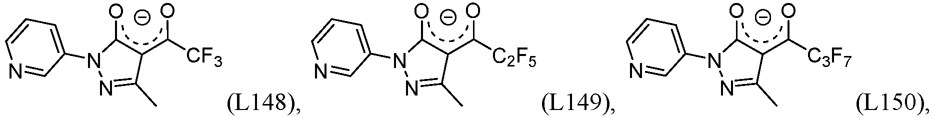

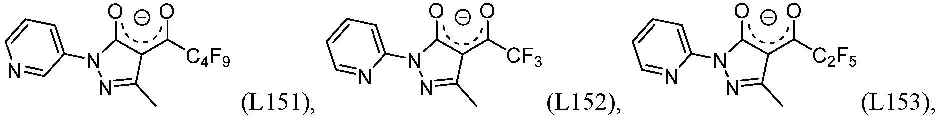

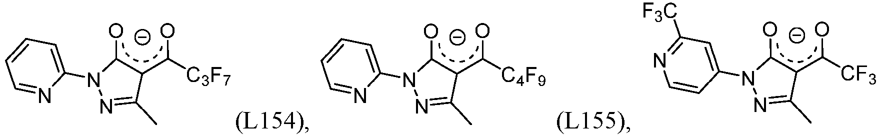

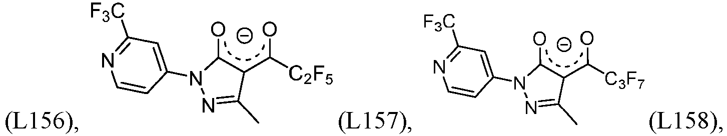

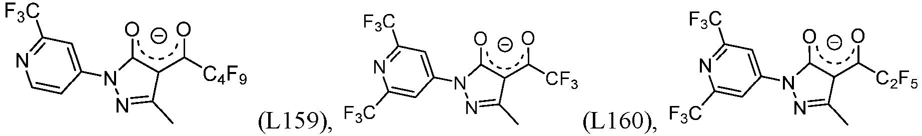

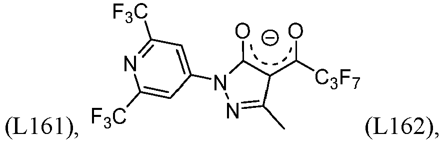

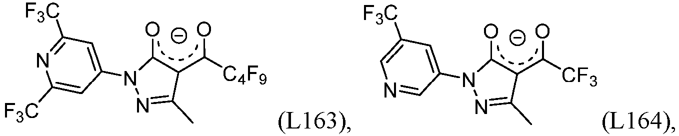

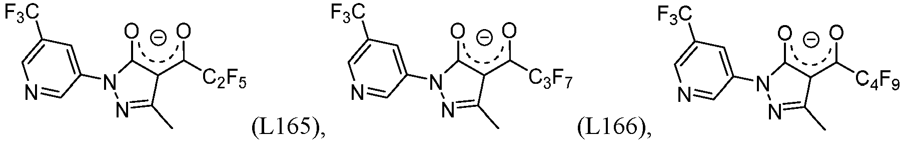

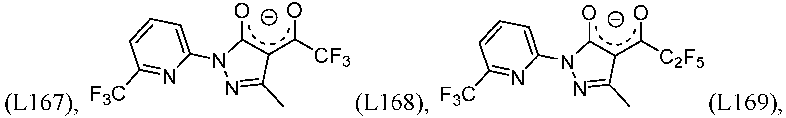

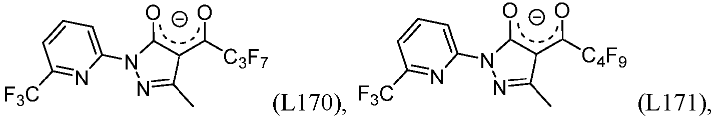

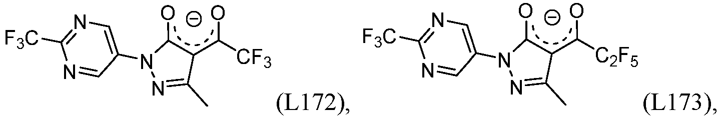

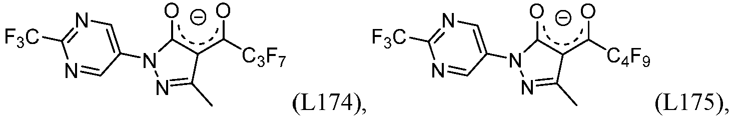

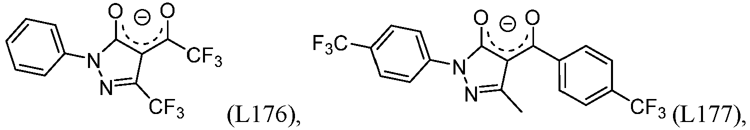

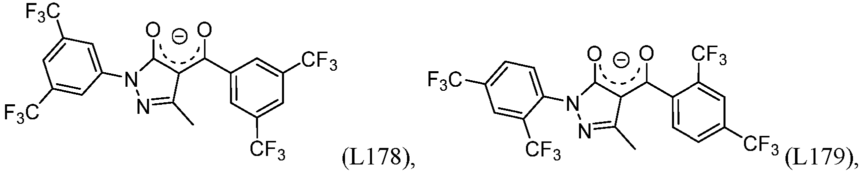

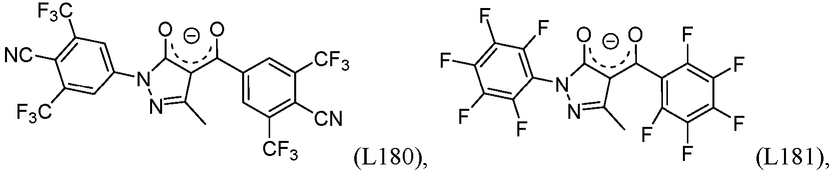

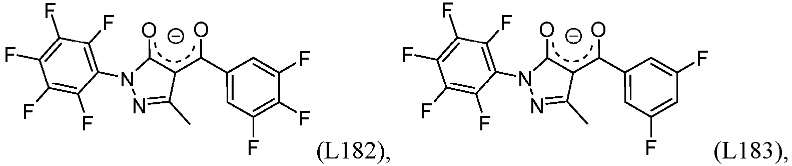

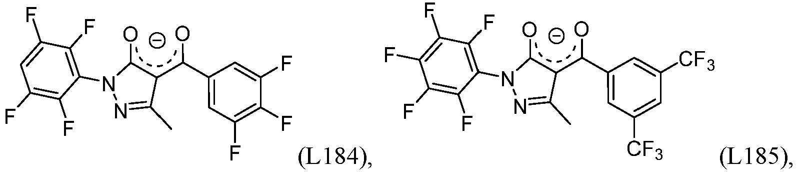

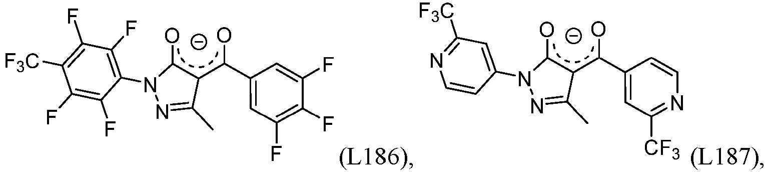

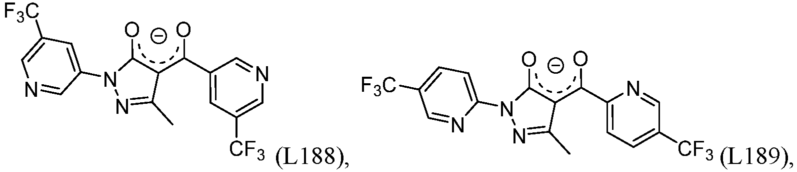

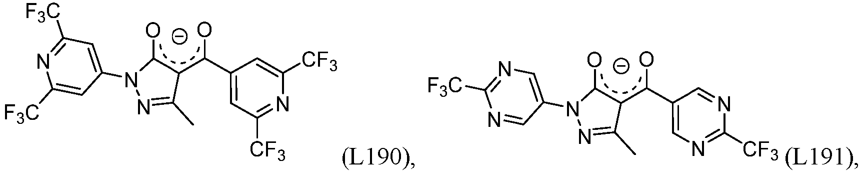

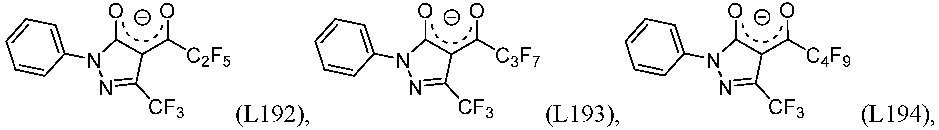

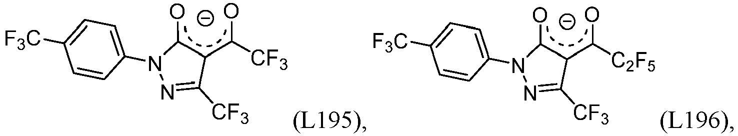

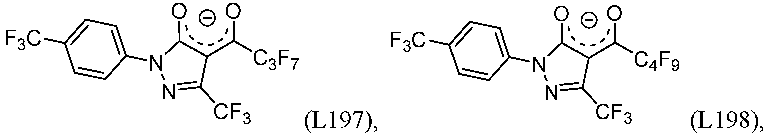

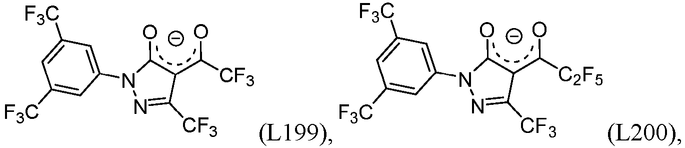

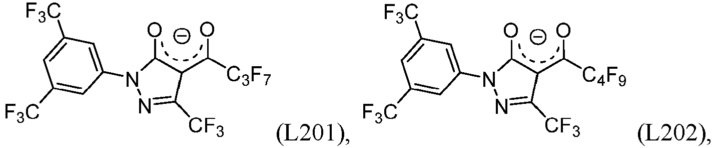

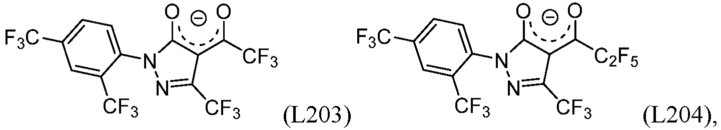

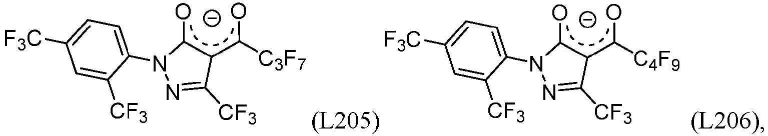

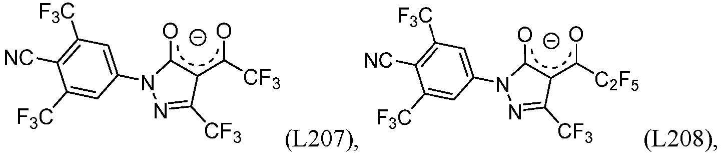

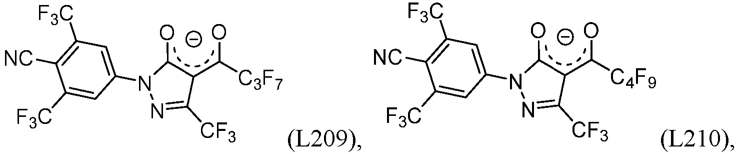

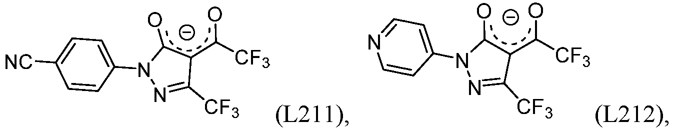

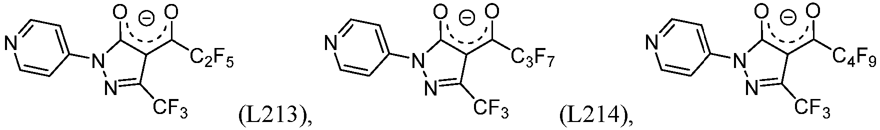

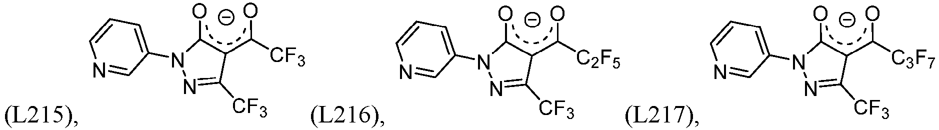

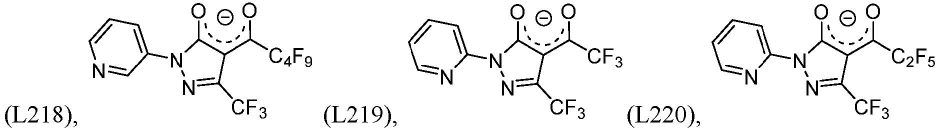

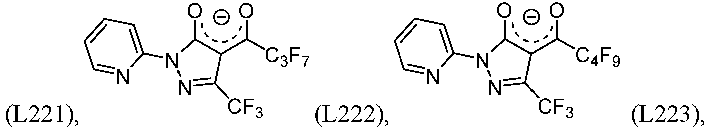

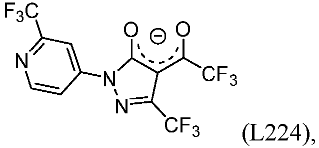

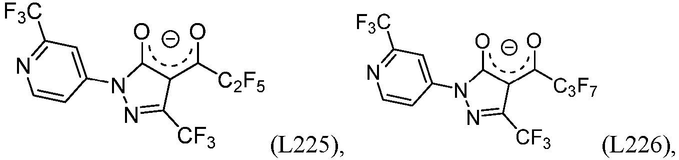

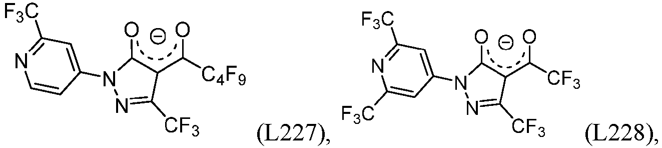

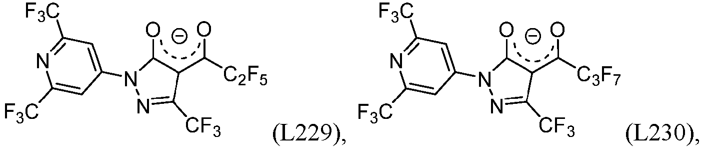

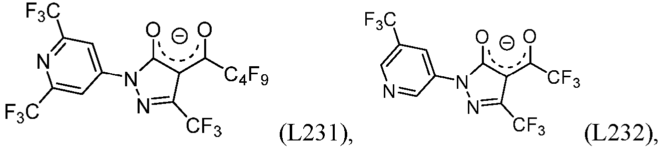

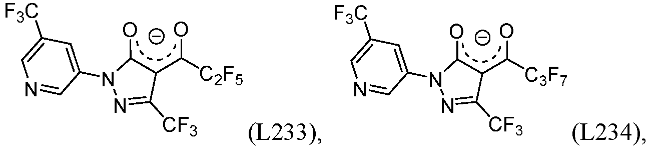

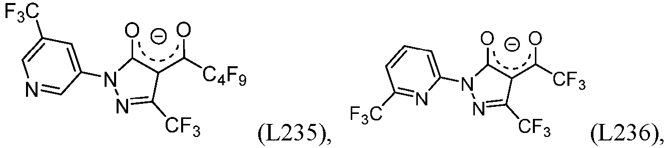

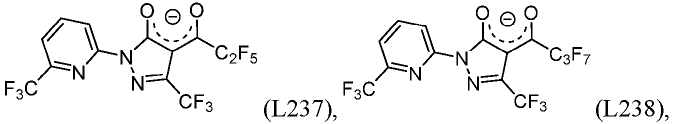

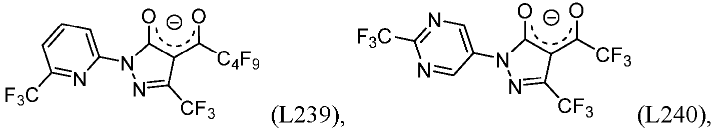

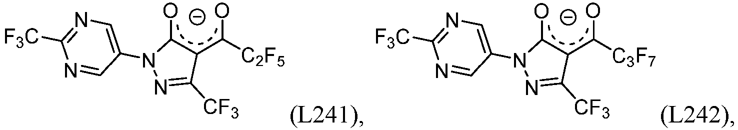

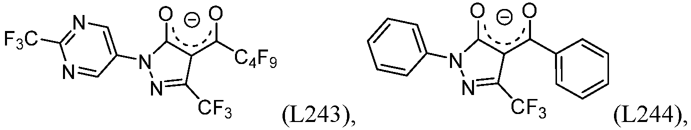

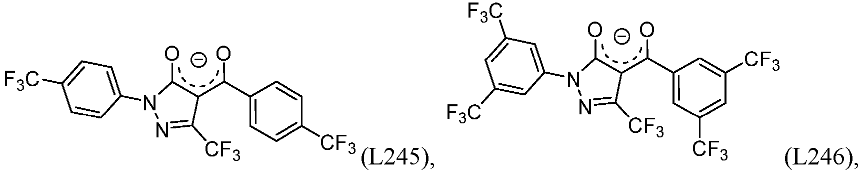

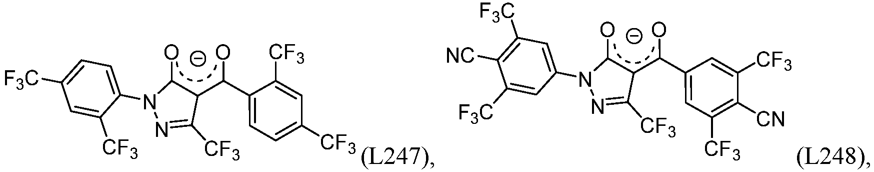

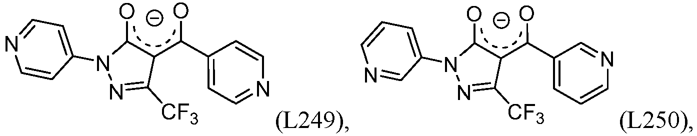

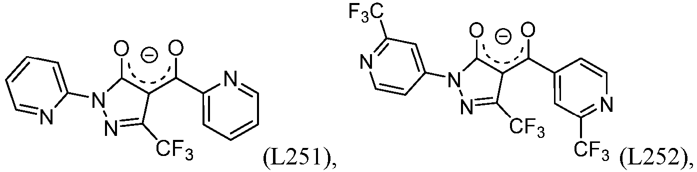

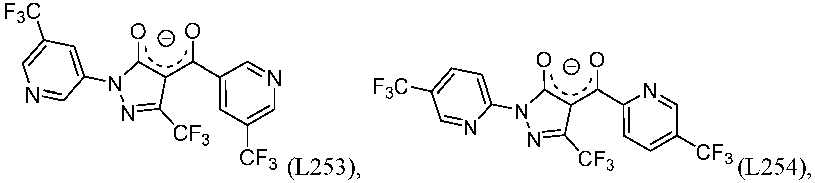

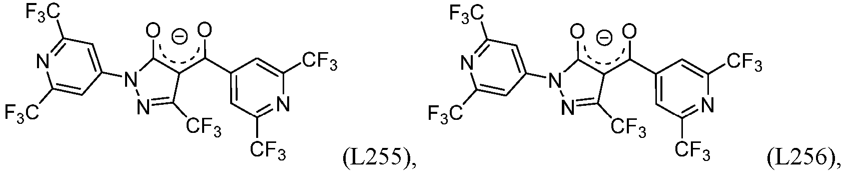

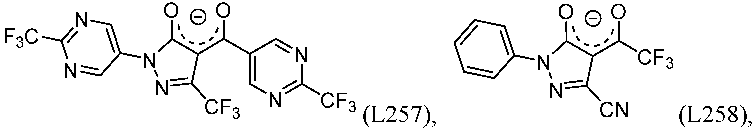

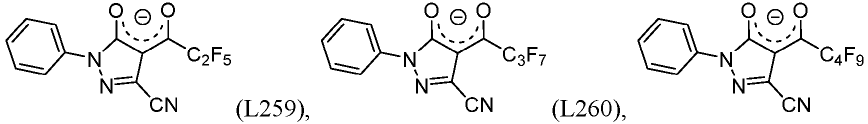

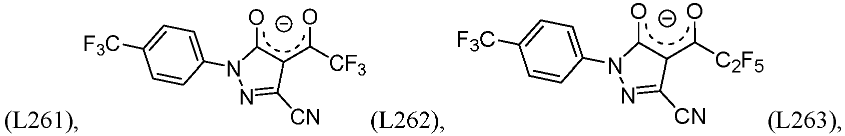

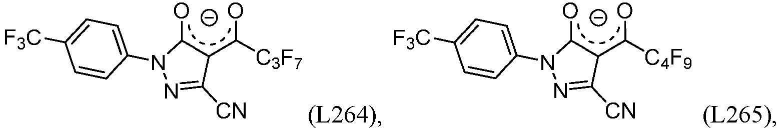

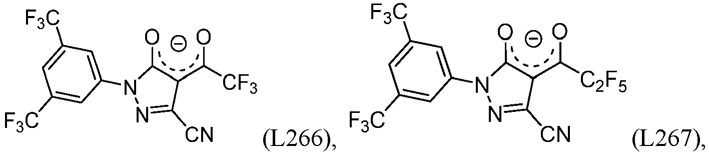

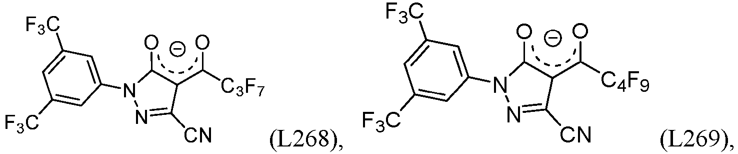

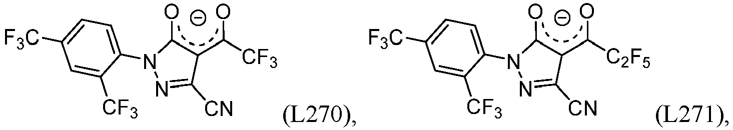

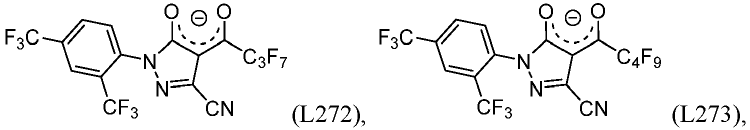

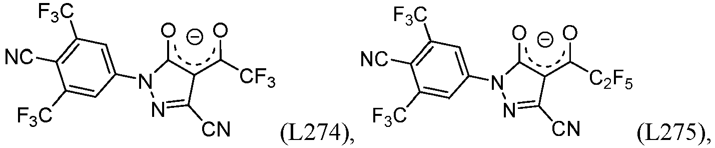

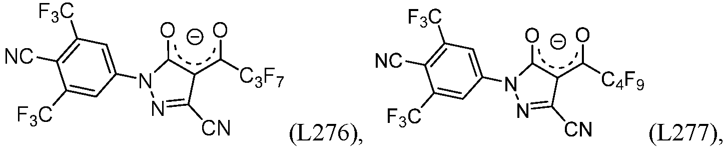

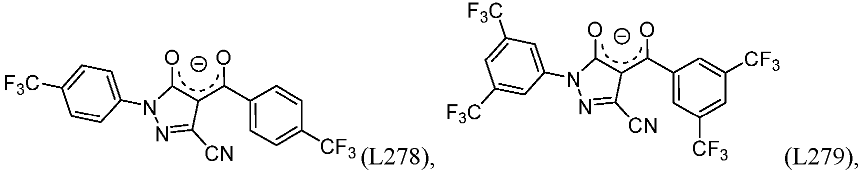

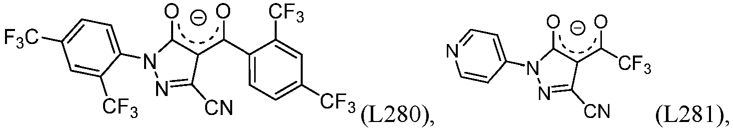

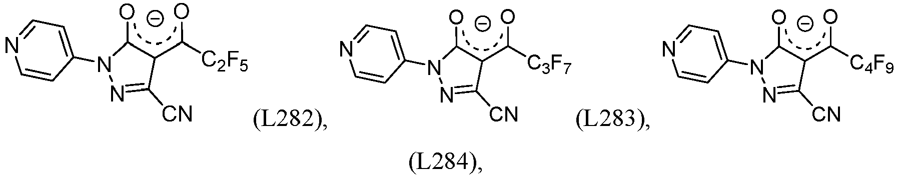

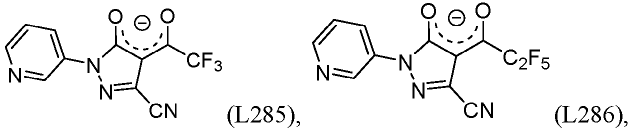

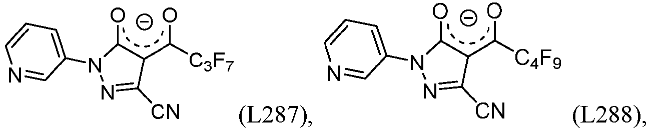

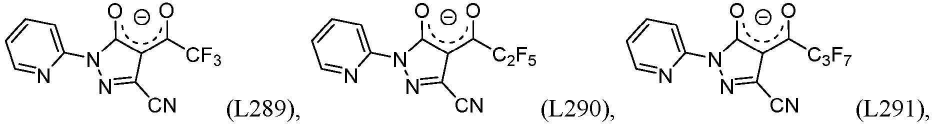

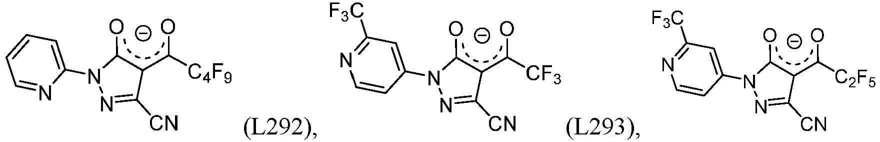

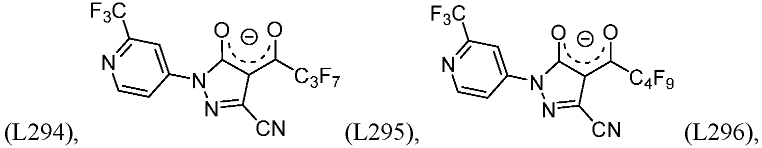

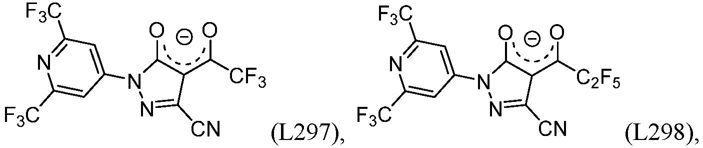

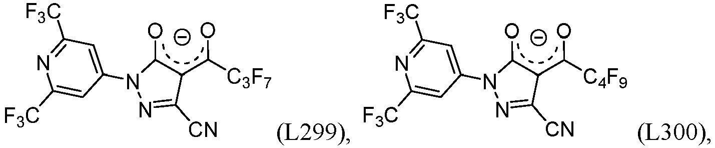

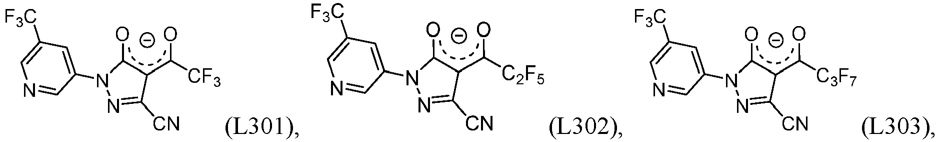

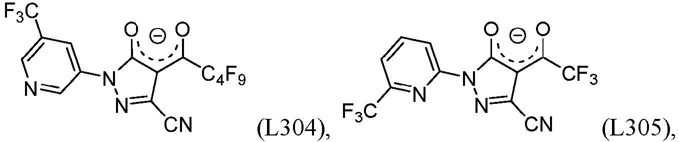

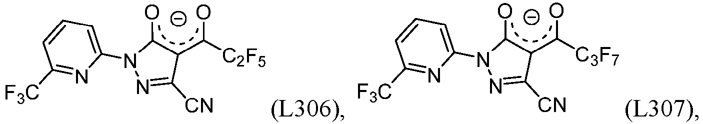

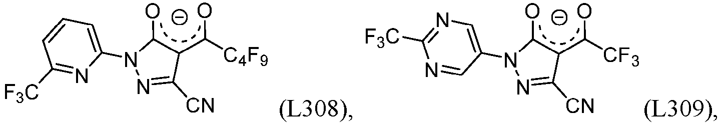

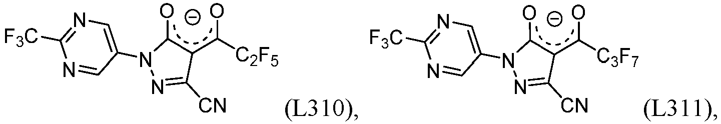

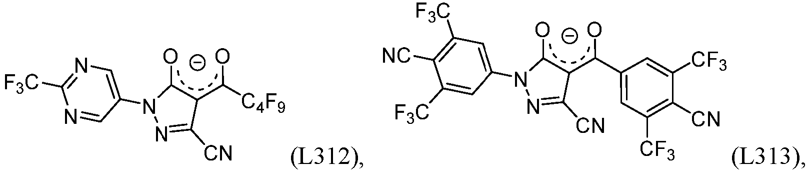

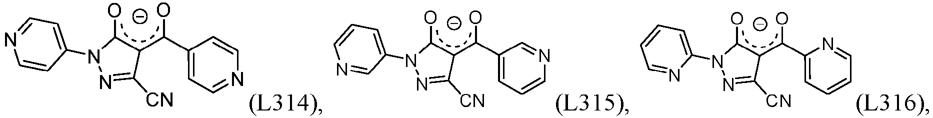

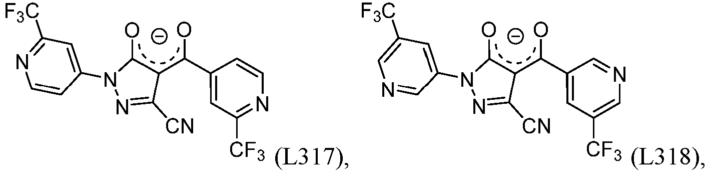

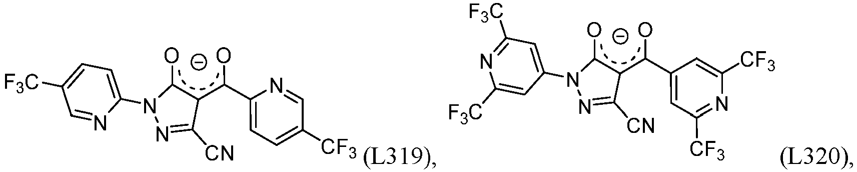

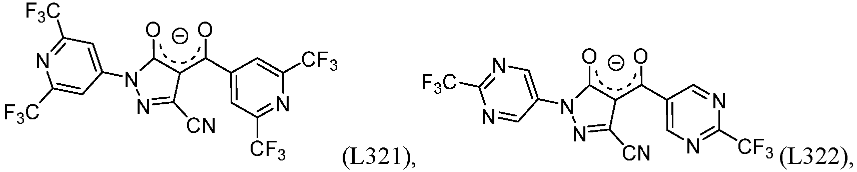

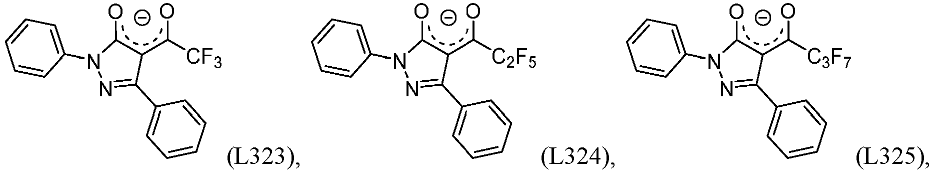

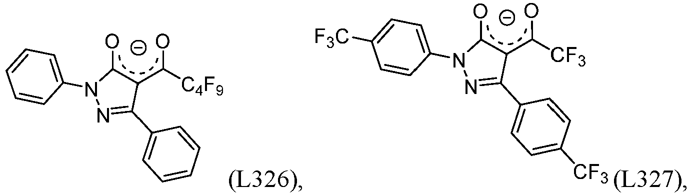

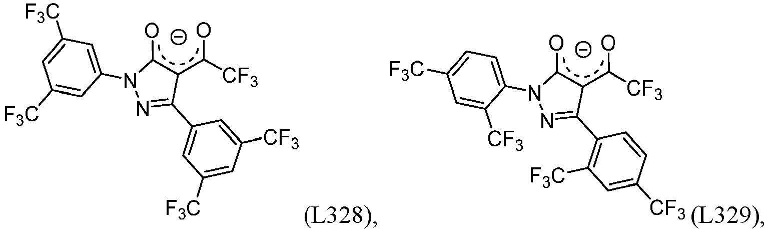

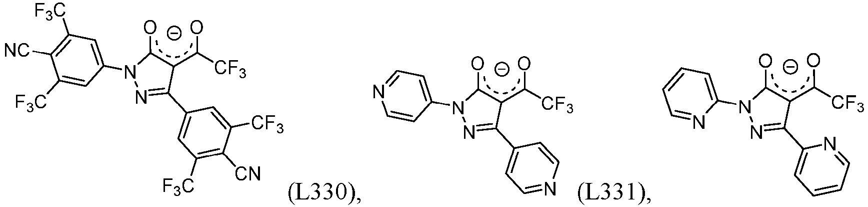

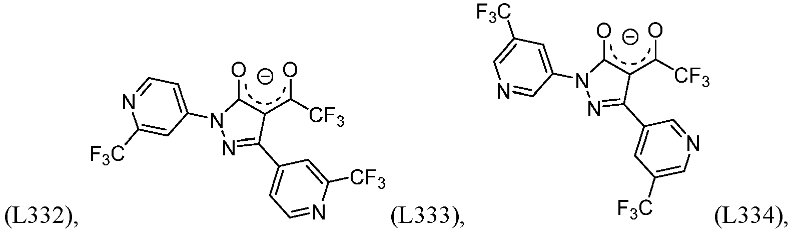

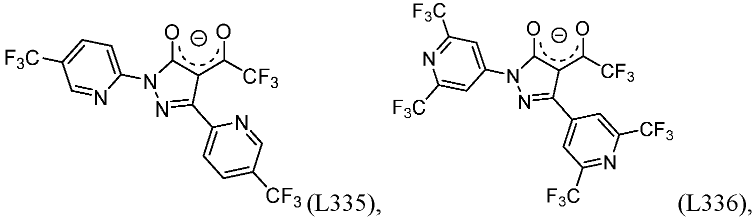

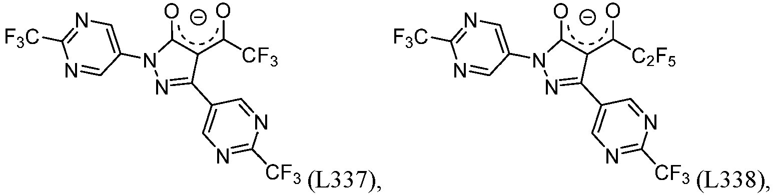

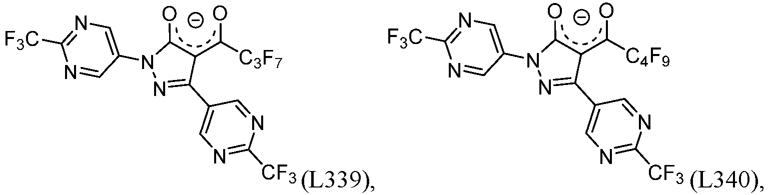

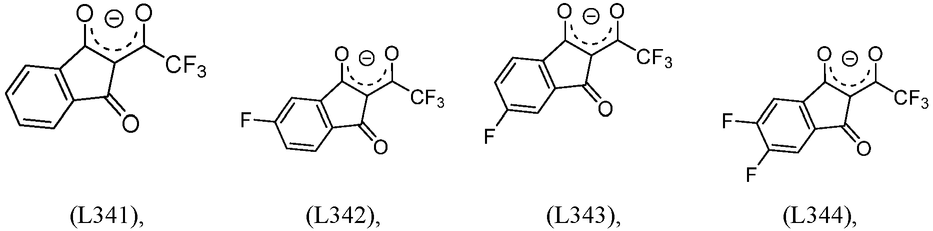

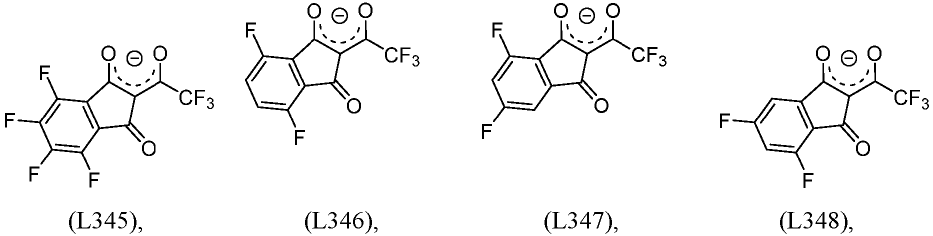

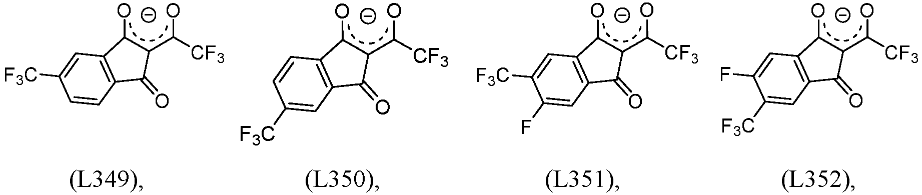

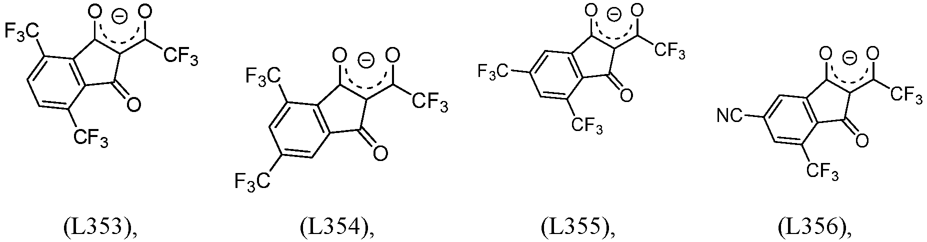

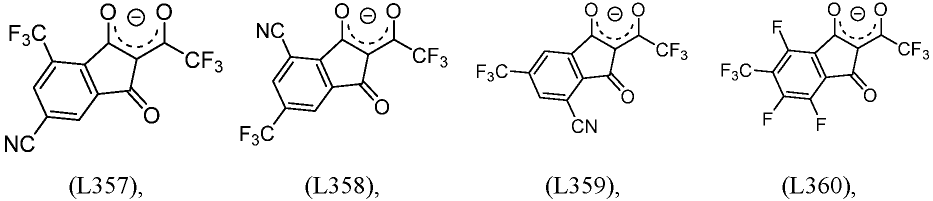

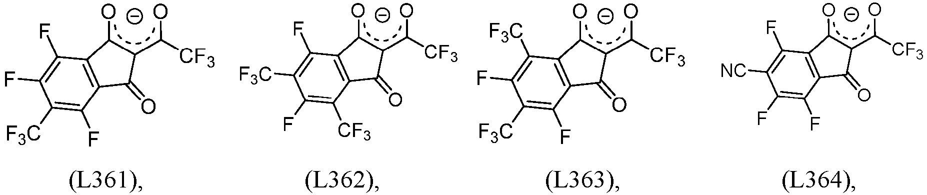

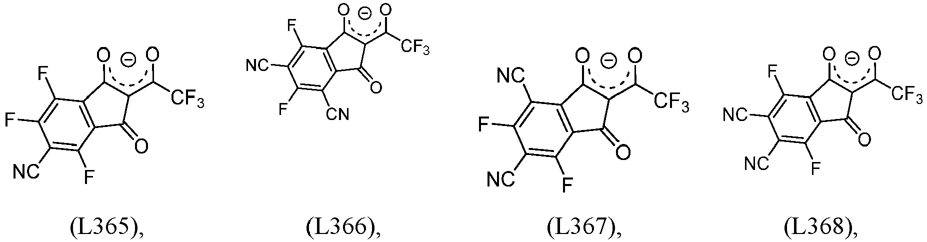

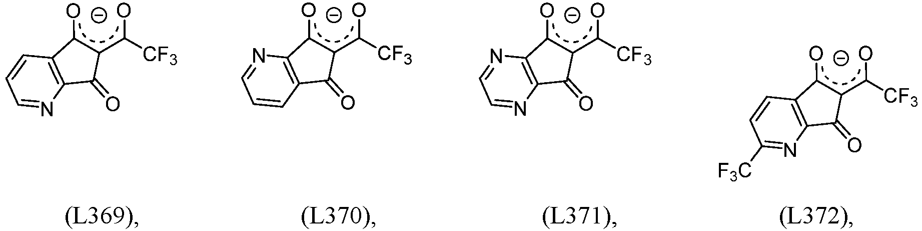

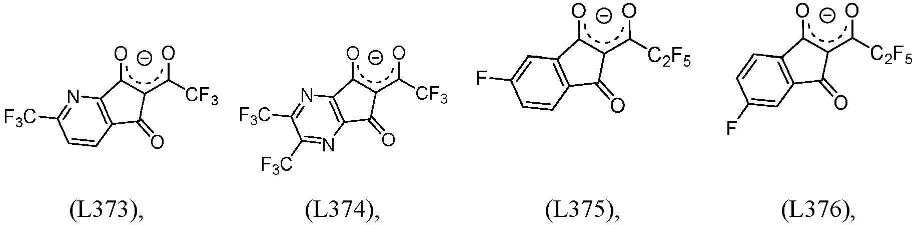

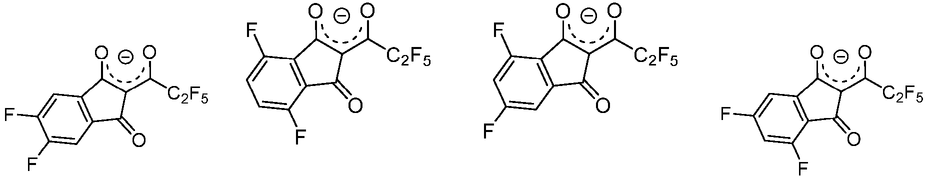

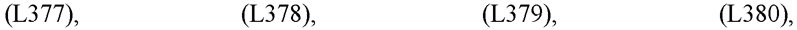

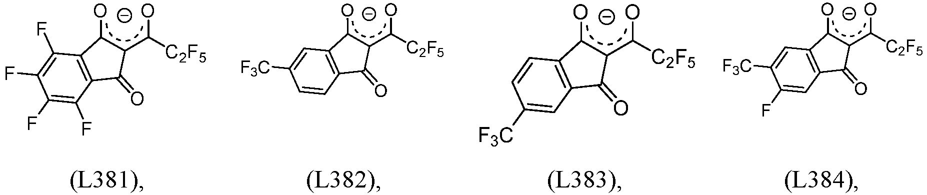

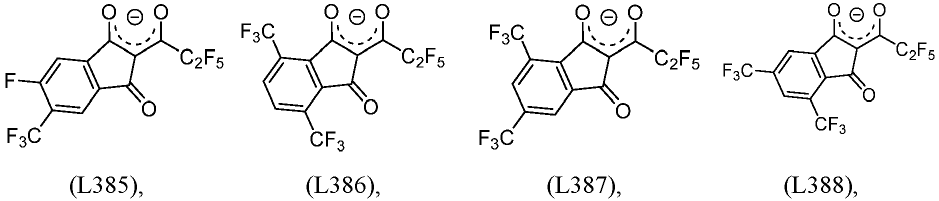

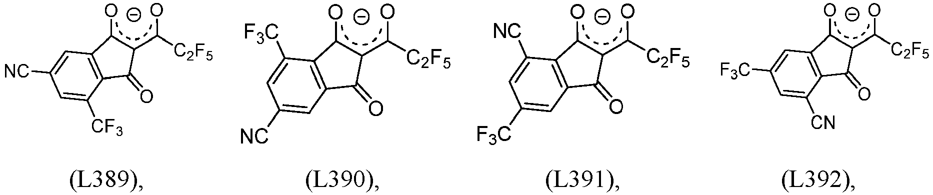

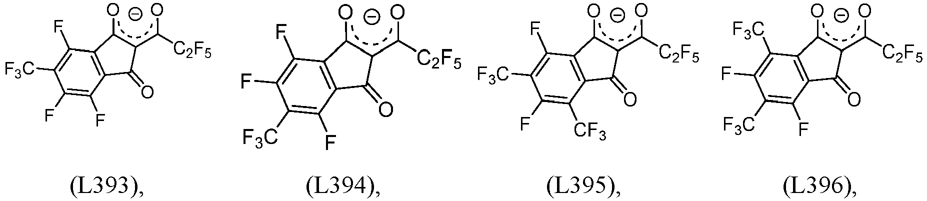

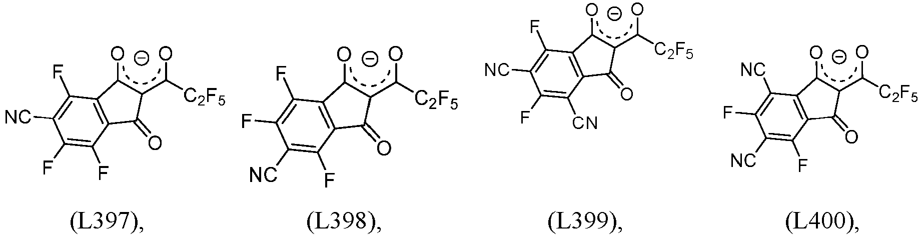

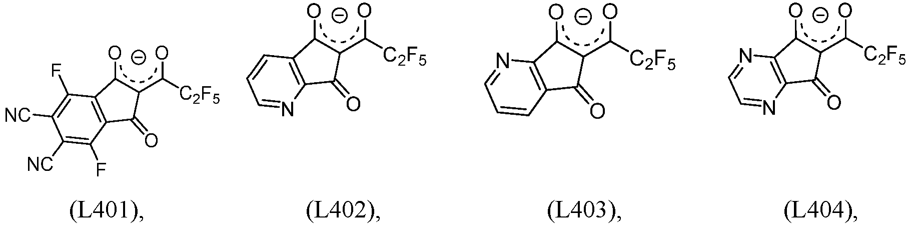

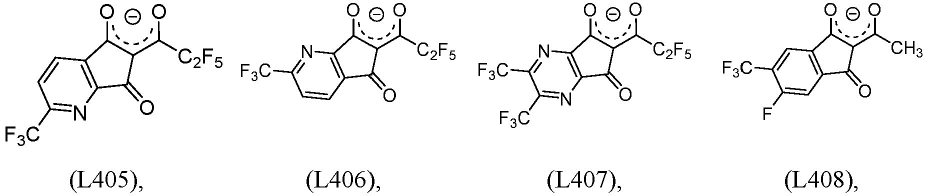

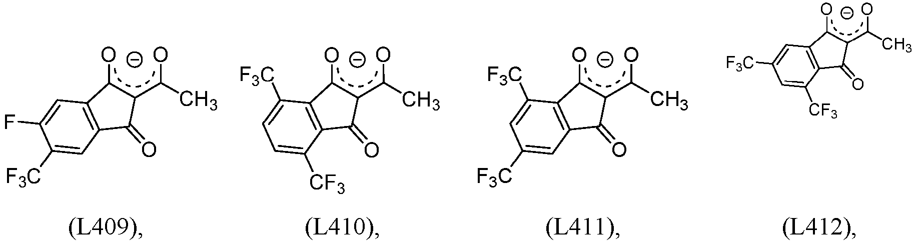

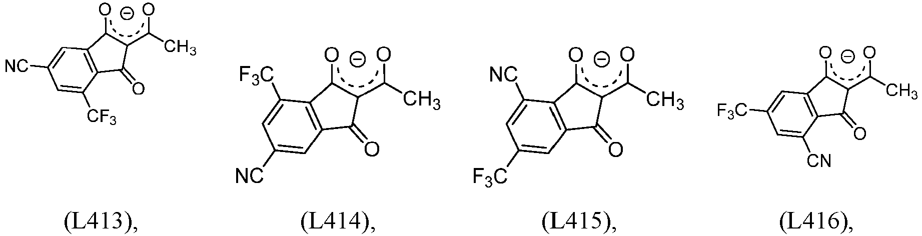

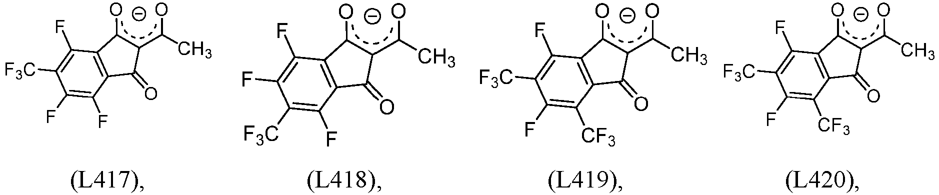

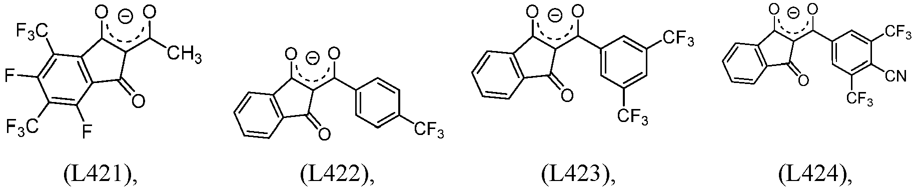

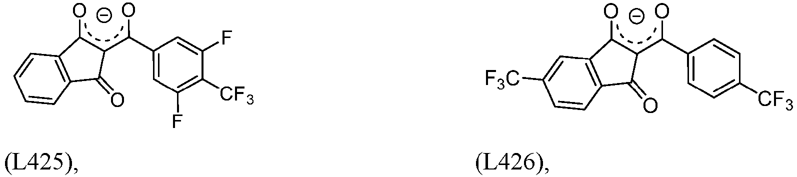

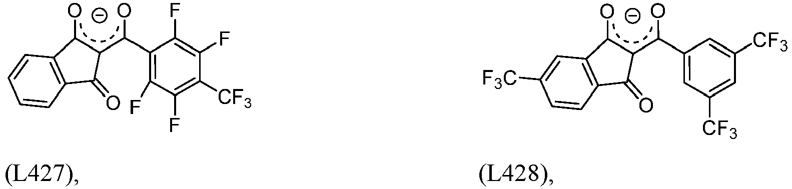

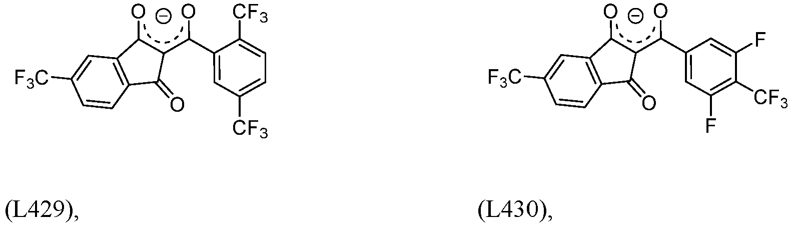

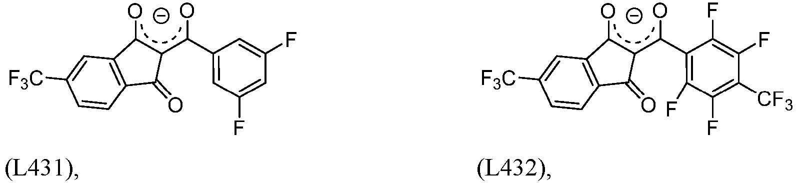

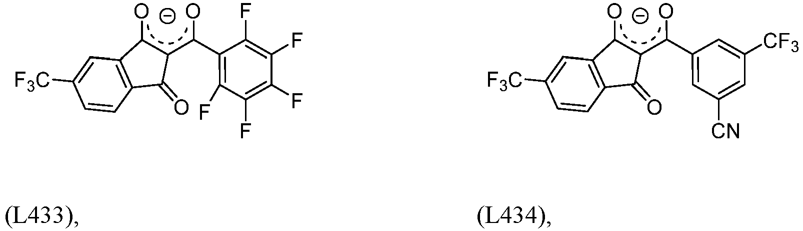

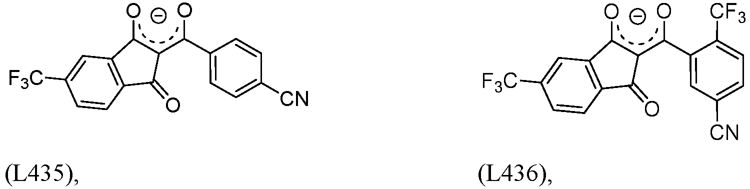

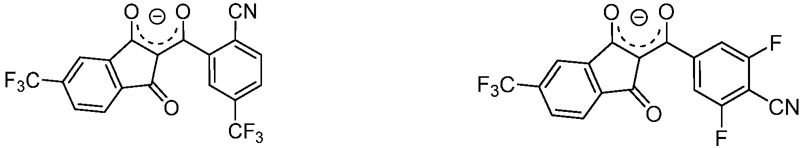

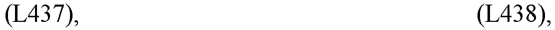

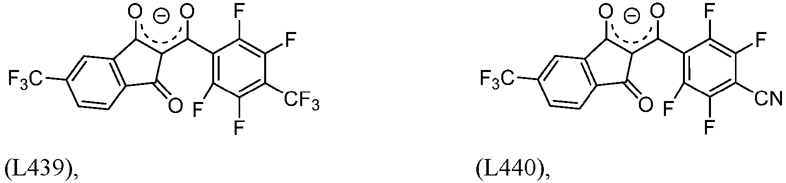

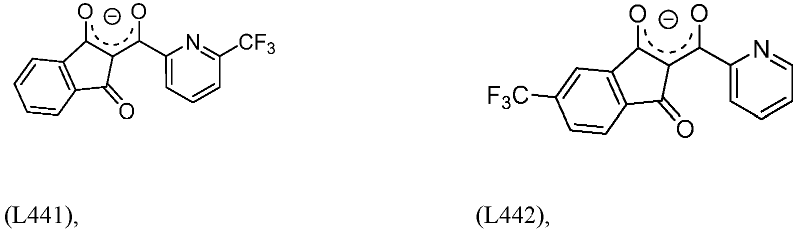

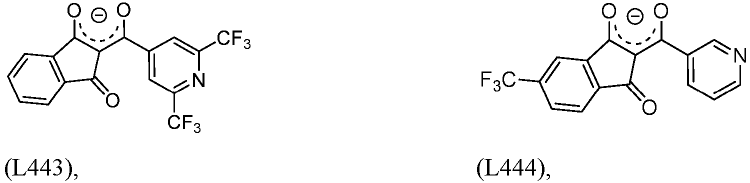

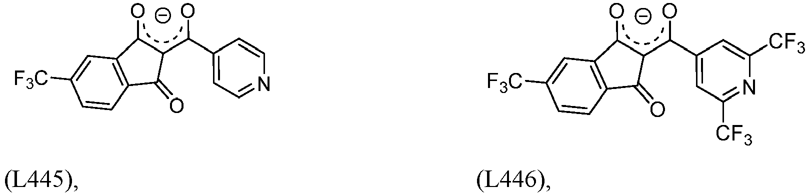

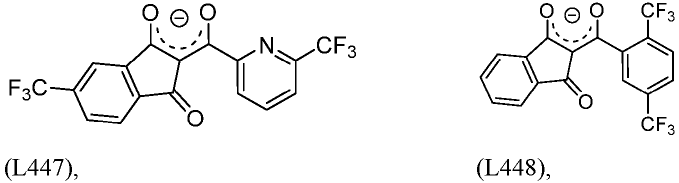

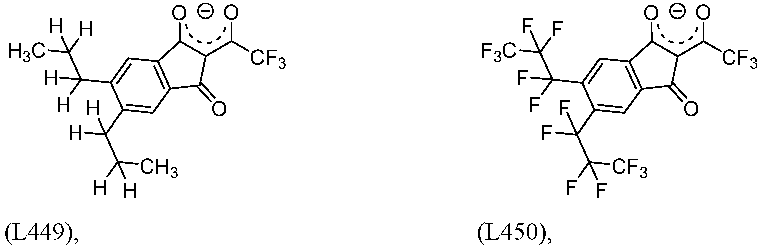

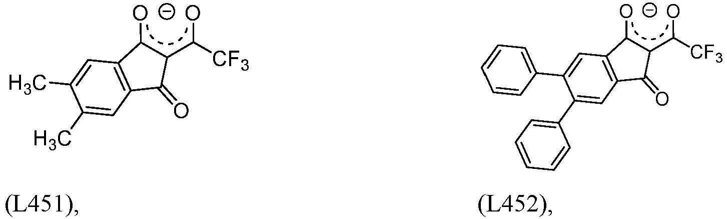

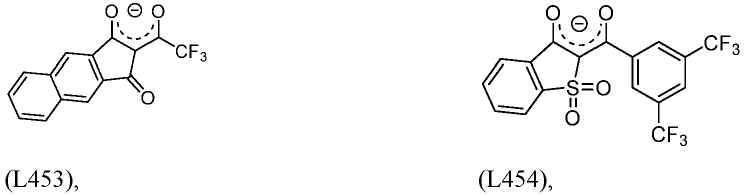

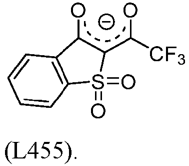

15. A display device comprising an organic electronic device according to any of the claims 1 to 14.
